# EUROPEAN PATENT SPECIFICATION

(11) **EP 3 944 034 B1**
(45) Date of publication and mention of the grant of the patent: **12.11.2025**
(21) Application number: 21175655.6
(22) Date of filing: 25.05.2021
(51) Int. Cl.: G05B 17/02, G05B 19/418

(54) **MODEL-BASED DESIGN OF LINEAR SYNCHRONOUS MOTOR TRANSPORT SYSTEMS**
MODELLBASIERTER ENTWURF VON TRANSPORTSYSTEMEN MIT LINEAREN SYNCHRONMOTOREN
CONCEPTION À BASE DE MODÈLES DE SYSTÈMES DE TRANSPORT À MOTEUR SYNCHRONE LINÉAIRE

(30) Priority: 21.07.2020 US 202063054545 P; 25.09.2020 US 202017033180
(43) Date of publication of application: 26.01.2022
(73) Proprietor: Rockwell Automation Technologies, Inc., Mayfield Heights, OH 44124 (US)
(72) Inventor: ZARUR, Ashraf, Mayfield Heights, OH 44124 (US); MANSOURI, Haithem, Mayfield Heights, OH 44124 (US); THOMSEN, Joachim, Mayfield Heights, OH 44124 (US)
(74) Representative: Grünecker Patent- und Rechtsanwälte PartG mbB

(56) References cited:
- WO-A1-2018/183275
- US-A1- 2011 040 531
- US-A1- 2015 261 200

## Description

### BACKGROUND

The subject matter disclosed herein relates generally to industrial automation systems, and, for example, to model-based design of linear synchronous motor (LSM) transport systems
WO 2018/183275 A1 relates to a system for automated generative design synthesis using data from design tools and knowledge from a digital twin graph. A system for autonomous generative design in a system having a digital twin graph includes a design tool with an observer for capturing interactions of a user with the design tool, the design tool in communication with the digital twin graph, a requirements distillation tool for receiving requirements documents of a system in human-readable format and importing useful information contained in the requirements documents into the digital twin graph, and a synthesis and analysis tool in communication with the digital twin graph, wherein the synthesis and analysis tool generates a set of design alternatives based on the captured interactions of the user with the design tool and the imported useful information from the requirements documents. The system further includes an observer within the design tool in communication with the digital twin that captures time series of user interactions with the design tool and communicates the user interactions with the digital twin graph. An insighter in communication with the design tool and with the digital twin graph receives design alternatives from the digital twin graph and presents the received design alternatives to a user via a design tool. A digital twin provides a virtual copy of a real-world system. Each component of the system is modeled. To capture additional aspects of the system, relationships between the components and between components and the environment are also modeled in the digital twin. Due to the identification and modeling of relationships in the system, the digital twin lends itself to representation as a graph containing nodes that define components of the system, with edges connecting the nodes to represent relationships. As the system operates, it generates data that is imported to the digital twin graph to better inform the modeled relationships and components. Past engineering decisions are captured and the lessons learned from these implementations become part of the analysis history of the digital twin. The digital twin is in communication with an associated physical system and receives real-time data streams from the physical environment and processes the real-time data to predict various operating states of the physical objects based on prognostic features found within the received data.
US 2011/040531 A1 relates to a method and system for identification of grouping characteristics. A transformation methodology is used which maps points on a component of the automation technology system, modeled in the first CAD model, onto points of the same component in the second CAD model. The method includes application of the transformation methodology to at least one first point of a first envelope geometry of a first CAD object that represents a first automation component in the first CAD model to calculate a second point in the second CAD model and to at least one third point of a second envelope geometry of a second CAD object that represents a second automation component in the first CAD model to calculate a fourth point in the second CAD model, checking for the existence of a grouping relationship, which is deemed to be satisfied if the second and fourth points are arranged within a third envelope geometry of a CAD group object in the second CAD model and, if this group relationship exists, creation of a hierarchical ordering within the engineering system, in which the first and the second CAD objects are hierarchically subordinate to the CAD group object.
US 2015/261200 A1 relates to updating and utilizing dynamic process simulation in an operating process environment. The simulation system is implemented with smart process objects, which have both graphical and simulation elements that are used to depict and model the operation of a plant or a portion of the plant. Each smart process object, which represents a physical device or entity within the process plant (such as a valve, a tank, a pipe, etc.), includes a graphical element that is used in a graphical display to depict that physical element and a modeling or simulation element, such as an algorithm, that models or simulates the behavior of that process element when operating in the plant. A smart process object includes a display element to be displayed to the operator, data storage for storing data pertaining to and received from an associated entity within a plant, inputs and outputs for communicating with other process objects, methods that are executed on the stored and received data to detect plant or device conditions, such as leaks, errors and other conditions and a simulation algorithm that is used to simulate operation of the process entity. Simulation is also provided via smart stream objects, which are associated with streams of material (or material flow) within the plant. Such streams represent fluids, solids or gases flowing or moving through the plant and each stream includes properties or parameters of the stream such as pressure, volume, density, flow rate, composition, etc. which changes as the stream moves through the different elements of the process module. Because the streams flow through the inputs and outputs of the process control elements, the properties of the streams are generally effected by the process elements (valves, tanks, etc.) through which the streams flow and, as a result, the individual elements within the process module include algorithms to simulate the effect of those process elements on the streams provided at the inputs thereof.

### BRIEF DESCRIPTION

It is the object of the present invention to simplify and improve generating a model for an LSM transport system.

This object is solved by the subject matter of the independent claims.

Preferred embodiments are defined by the dependent claims.

### BRIEF DESCRIPTION OF THE DRAWINGS

FIG. 1 is a block diagram of an example industrial control environment.
FIG. 2 is a conceptual diagram illustrating the flow of industrial data across various information levels in a typical industrial environment.
FIG. 3 is a block diagram of an example industrial device that supports smart objects.
FIG. 4 is a block diagram of a gateway device capable of discovering BIDTs on one or more industrial devices and formatting a presentation of associated data in accordance with a user-defined asset model.
FIG. 5 is a block diagram of an application server system capable of aggregating asset models from gateway devices into one or more plant models and formatting a presentation of associated data received from the gateway devices in accordance with the aggregated plant models.
FIG. 6 is an illustration of four example smart objects that can be supported by one or more embodiments of an industrial device.
FIG. 7 is a diagram illustrating development of smart objects in a tag database of an industrial device.
FIG. 8 is a diagram illustrating storage of smart objects in a tag database.
FIG. 9 is a diagram illustrating runtime operation of an example industrial device that supports smart objects.
FIG. 10 is a diagram illustrating configuration of a gateway device with one or more asset model definitions.
FIG. 11 is a graphical representation of an example asset model formatted as a production model.
FIG. 12 is a diagram illustrating the flow of BIDT data from industrial devices to an application server system that delivers contextualized presentations of the BIDT data.
FIG. 13 is an example plant model generated by an application server system by integrating multiple asset models received from respective multiple gateway devices.
FIG. 14 is a diagram illustrating an example network architecture that includes industrial devices, a gateway device, and a cloud-based application server system.
FIG. 15 is a diagram illustrating integration of an asset model of an industrial asset with a mechanical model of the industrial asset to yield a digital twin representing the asset.
FIG. 16 is a diagram illustrating generation of asset data based on integration of an asset (automation) model with a mechanical model of the industrial asset.
FIG. 17 is a diagram illustrating parallel development of an asset model and a mechanical model for an industrial asset.
FIG. 18 is a diagram of an example architecture that uses an interlinked asset model and mechanical model to generate playback simulations of past industrial asset operations.
FIG. 19 is a diagram illustrating generation of supplemental calculated asset data based on integration of an asset (automation) model with a mechanical model for the industrial asset.
FIG. 20 is a block diagram illustrating an example virtual reality system that leverages a digital twin to generate virtual reality presentations that play back past asset behaviors using a digital twin.
FIG. 21 is a generalized block diagram of a software testing system that uses a digital twin to verify a control program.
FIG. 22 is a diagram illustrating the use of a digital twin in connection with performing collective supervisory control of an industrial asset.
FIG. 23 is a diagram illustrating an example architecture that includes an AI engine component capable of applying AI analysis to a digital twin for contextualization, validation, and adaptation purposes.
FIG. 24 is a diagram illustrating contextualization of a digital twin's smart objects by an AI engine component.
FIG. 25 is a diagram illustrating an example architecture in which an AI engine component contextualizes smart tags of a digital twin based on analysis of both the data topology of the digital twin and real-time or historical process data.
FIG. 26 is an example data schema illustrating smart objects that have been augmented by an AI engine component to include AI fields defining various AI properties.
FIG. 27 is a diagram illustrating the use of AI-based simulation to validate a digital twin against a physical industrial asset or system being modeled.
FIG. 28 is a view of an example LSM transport system.
FIG. 29 is a block diagram of a track design and testing system for digitally engineering and testing an LSM transport system.
FIG. 30 is a diagram illustrating example data flows associated with creation and simulation of a track automation model for an LSM transport system being designed using a design and testing system.
FIG. 31 is an example design interface that can be generated and rendered on a client device by a user interface component of a design and testing system.
FIG. 32 is a view of an example track automation model within a design area of the design and testing system.
FIG. 33 is a diagram illustrating example data flows associated with simulation of a track automation model.
FIG. 34 is an example track metrics display that can be generated by a user interface component of the design and testing system.
FIG. 35 is a partial listing of track design parameters that can be varied across different simulation sessions for the purpose of comparative analysis.
FIG. 36a is a list of station velocity and acceleration values that can set for respective simulation test cases in a first sequential simulation test.
FIG. 36b is a list of station velocity and acceleration values that can set for respective simulation test cases in a second sequential simulation test.
FIG. 37 is an example test summary display that compares predicted mover throughput through a specified station for different simulated design scenarios.
FIG. 38 is a diagram that illustrates playback of selected simulations based on previously generated simulation result data.
FIG. 39 is a diagram illustrating analysis of the simulation result data generated by a simulation component for multiple design test case scenarios.
FIG. 40 is a diagram illustrating creation of a track controller program and a visualization program by the design and testing system based on a completed automation model.
FIG. 41 is a depiction of an example Station instruction that can be included in a ladder logic program generated by a program generation component of the design and testing system.
FIG. 42 is an example track overview screen that depicts an animated overhead graphic of a physical transport system.
FIG. 43 is an example Paths operator screen.
FIG. 44 is an example Nodes operator screen.
FIG. 45 is an example Node Controllers operator screen.
FIG. 46 is a diagram illustrating deployment of a track controller program and a visualization program by the design and testing system.
FIG. 47 is a diagram illustrating cascading of design changes between a model, a control program, and a visualization program.
FIG. 48 is a diagram illustrating integration of an automation model for an LSM transport system with a mechanical model to yield a digital twin of the transport system.
FIG. 49 is a diagram of an example architecture in which live data from a physical transport system is fed to an automation model for the purposes of live visualization and analytics.
FIG. 50 is a flowchart of an example methodology for developing and simulating a virtual model or digital twin of an LSM transport system.
FIG. 51a is a flowchart of a first part of an example methodology for identifying a set of configuration parameters for an LSM transport system by executing multiple simulations the transport system.
FIG. 51b is a flowchart of a second part of the example methodology for identifying a set of configuration parameters for an LSM transport system by executing multiple simulations the transport system.
FIG. 52 is a flowchart of an example methodology for cascading design changes between a virtual model or digital twin of an LSM transport system, a control program that monitors and controls the transport system, and a human-machine interface (HMI) application that visualizes operation of the transport system.
FIG. 53 is an example computing environment.
FIG. 54 is an example networking environment.

### DETAILED DESCRIPTION

The subject disclosure is now described with reference to the drawings, wherein like reference numerals are used to refer to like elements throughout. In the following description, for purposes of explanation, numerous specific details are set forth in order to provide a thorough understanding thereof. It may be evident, however, that the subject disclosure can be practiced without these specific details. In other instances, well-known structures and devices are shown in block diagram form in order to facilitate a description thereof.

As used in this application, the terms "component," "system," "platform," "layer," "controller," "terminal," "station," "node," "interface" are intended to refer to a computer-related entity or an entity related to, or that is part of, an operational apparatus with one or more specific functionalities, wherein such entities can be either hardware, a combination of hardware and software, software, or software in execution. For example, a component can be, but is not limited to being, a process running on a processor, a processor, a hard disk drive, multiple storage drives (of optical or magnetic storage medium) including affixed (e.g., screwed or bolted) or removable affixed solid-state storage drives; an object; an executable; a thread of execution; a computer-executable program, and/or a computer. By way of illustration, both an application running on a server and the server can be a component. One or more components can reside within a process and/or thread of execution, and a component can be localized on one computer and/or distributed between two or more computers. Also, components as described herein can execute from various computer readable storage media having various data structures stored thereon. The components may communicate via local and/or remote processes such as in accordance with a signal having one or more data packets (e.g., data from one component interacting with another component in a local system, distributed system, and/or across a network such as the Internet with other systems via the signal). As another example, a component can be an apparatus with specific functionality provided by mechanical parts operated by electric or electronic circuitry which is operated by a software or a firmware application executed by a processor, wherein the processor can be internal or external to the apparatus and executes at least a part of the software or firmware application. As yet another example, a component can be an apparatus that provides specific functionality through electronic components without mechanical parts, the electronic components can include a processor therein to execute software or firmware that provides at least in part the functionality of the electronic components. As further yet another example, interface(s) can include input/output (I/O) components as well as associated processor, application, or Application Programming Interface (API) components. While the foregoing examples are directed to aspects of a component, the exemplified aspects or features also apply to a system, platform, interface, layer, controller, terminal, and the like.

As used herein, the terms "to infer" and "inference" refer generally to the process of reasoning about or inferring states of the system, environment, and/or user from a set of observations as captured via events and/or data. Inference can be employed to identify a specific context or action, or can generate a probability distribution over states, for example. The inference can be probabilistic-that is, the computation of a probability distribution over states of interest based on a consideration of data and events. Inference can also refer to techniques employed for composing higher-level events from a set of events and/or data. Such inference results in the construction of new events or actions from a set of observed events and/or stored event data, whether or not the events are correlated in close temporal proximity, and whether the events and data come from one or several event and data sources.

In addition, the term "or" is intended to mean an inclusive "or" rather than an exclusive "or." That is, unless specified otherwise, or clear from the context, the phrase "X employs A or B" is intended to mean any of the natural inclusive permutations. That is, the phrase "X employs A or B" is satisfied by any of the following instances: X employs A; X employs B; or X employs both A and B. In addition, the articles "a" and "an" as used in this application and the appended claims should generally be construed to mean "one or more" unless specified otherwise or clear from the context to be directed to a singular form.

Furthermore, the term "set" as employed herein excludes the empty set; e.g., the set with no elements therein. Thus, a "set" in the subject disclosure includes one or more elements or entities. As an illustration, a set of controllers includes one or more controllers; a set of data resources includes one or more data resources; etc. Likewise, the term "group" as utilized herein refers to a collection of one or more entities; e.g., a group of nodes refers to one or more nodes.

Various aspects or features will be presented in terms of systems that may include a number of devices, components, modules, and the like. It is to be understood and appreciated that the various systems may include additional devices, components, modules, etc. and/or may not include all of the devices, components, modules etc. discussed in connection with the figures. A combination of these approaches also can be used.

Industrial controllers and their associated I/O devices are central to the operation of modem automation systems. These controllers interact with field devices on the plant floor to control automated processes relating to such objectives as product manufacture, material handling, batch processing, supervisory control, and other such applications. Industrial controllers store and execute user-defined control programs to effect decision-making in connection with the controlled process. Such programs can include, but are not limited to, ladder logic, sequential function charts, function block diagrams, structured text, or other such platforms.

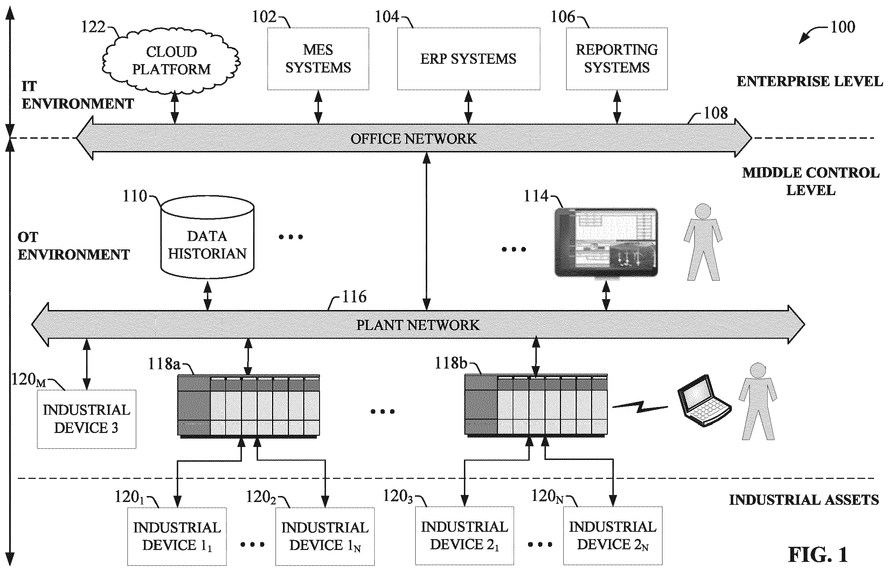

FIG. 1 is a block diagram of an example industrial environment 100. In this example, a number of industrial controllers 118 are deployed throughout an industrial plant environment to monitor and control respective industrial systems or processes relating to product manufacture, machining, motion control, batch processing, material handling, or other such industrial functions. Industrial controllers 118 typically execute respective control programs to facilitate monitoring and control of industrial devices 120 making up the controlled industrial assets or systems (e.g., industrial machines). One or more industrial controllers 118 may also comprise a soft controller executed on a personal computer, on a server blade, or other hardware platform, or on a cloud platform. Some hybrid devices may also combine controller functionality with other functions (e.g., visualization). The control programs executed by industrial controllers 118 can comprise any conceivable type of code used to process input signals read from the industrial devices 120 and to control output signals generated by the industrial controllers, including but not limited to ladder logic, sequential function charts, function block diagrams, structured text, C++, Python, Javascript, etc.

Industrial devices 120 may include input devices that provide data relating to the controlled industrial systems to the industrial controllers 118, output devices that respond to control signals generated by the industrial controllers 118 to control aspects of the industrial systems, or devices that act as both input and output devices. Example input devices can include telemetry devices (e.g., temperature sensors, flow meters, level sensors, pressure sensors, etc.), manual operator control devices (e.g., push buttons, selector switches, etc.), safety monitoring devices (e.g., safety mats, safety pull cords, light curtains, etc.), and other such devices. Output devices may include motor drives, pneumatic actuators, signaling devices, robot control inputs, valves, and the like. Some industrial devices, such as industrial device 120M, may operate autonomously on the plant network 116 without being controlled by an industrial controller 118.

Industrial controllers 118 may communicatively interface with industrial devices 120 over hardwired connections or over wired or wireless networks. For example, industrial controllers 118 can be equipped with native hardwired inputs and outputs that communicate with the industrial devices 120 to effect control of the devices. The native controller I/O can include digital I/O that transmits and receives discrete voltage signals to and from the field devices, or analog I/O that transmits and receives analog voltage or current signals to and from the devices. The controller I/O can communicate with a controller's processor over a backplane such that the digital and analog signals can be read into and controlled by the control programs. Industrial controllers 118 can also communicate with industrial devices 120 over the plant network 116 using, for example, a communication module or an integrated networking port. Exemplary networks can include the Internet, intranets, Ethernet, EtherNet/IP, DeviceNet, ControlNet, Data Highway and Data Highway Plus (DH/DH+), Remote I/O, Fieldbus, Modbus, Profibus, wireless networks, serial protocols, and the like. The industrial controllers 118 can also store persisted data values that can be referenced by the control program and used for control decisions, including but not limited to measured or calculated values representing operational states of a controlled machine or process (e.g., tank levels, positions, alarms, etc.) or captured time series data that is collected during operation of the automation system (e.g., status information for multiple points in time, diagnostic occurrences, etc.). Similarly, some intelligent devices - including but not limited to motor drives, instruments, or condition monitoring modules - may store data values that are used for control and/or to visualize states of operation. Such devices may also capture time-series data or events on a log for later retrieval and viewing.

Industrial automation systems often include one or more human-machine interfaces (HMIs) 114 that allow plant personnel to view telemetry and status data associated with the automation systems, and to control some aspects of system operation. HMIs 114 may communicate with one or more of the industrial controllers 118 over a plant network 116, and exchange data with the industrial controllers to facilitate visualization of information relating to the controlled industrial processes on one or more pre-developed operator interface screens. HMIs 114 can also be configured to allow operators to submit data to specified data tags or memory addresses of the industrial controllers 118, thereby providing a means for operators to issue commands to the controlled systems (e.g., cycle start commands, device actuation commands, etc.), to modify setpoint values, etc. HMIs 114 can generate one or more display screens through which the operator interacts with the industrial controllers 118, and thereby with the controlled processes and/or systems. Example display screens can visualize present states of industrial systems or their associated devices using graphical representations of the processes that display metered or calculated values, employ color or position animations based on state, render alarm notifications, or employ other such techniques for presenting relevant data to the operator. Data presented in this manner is read from industrial controllers 118 by HMIs 114 and presented on one or more of the display screens according to display formats chosen by the HMI developer. HMIs may comprise fixed location or mobile devices with either user-installed or pre-installed operating systems, and either user-installed or pre-installed graphical application software.

Some industrial environments may also include other systems or devices relating to specific aspects of the controlled industrial systems. These may include, for example, one or more data historians 110 that aggregate and store production information collected from the industrial controllers 118 and other industrial devices.

Industrial devices 120, industrial controllers 118, HMIs 114, associated controlled industrial assets, and other plant-floor systems such as data historians 110, vision systems, and other such systems operate on the operational technology (OT) level of the industrial environment. Higher level analytic and reporting systems may operate at the higher enterprise level of the industrial environment in the information technology (IT) domain; e.g., on an office network 108 or on a cloud platform 122. Such higher level systems can include, for example, enterprise resource planning (ERP) systems 104 that integrate and collectively manage high-level business operations, such as finance, sales, order management, marketing, human resources, or other such business functions. Manufacturing Execution Systems (MES) 102 can monitor and manage control operations on the control level given higher-level business considerations. Reporting systems 106 can collect operational data from industrial devices on the plant floor and generate daily or shift reports that summarize operational statistics of the controlled industrial assets.

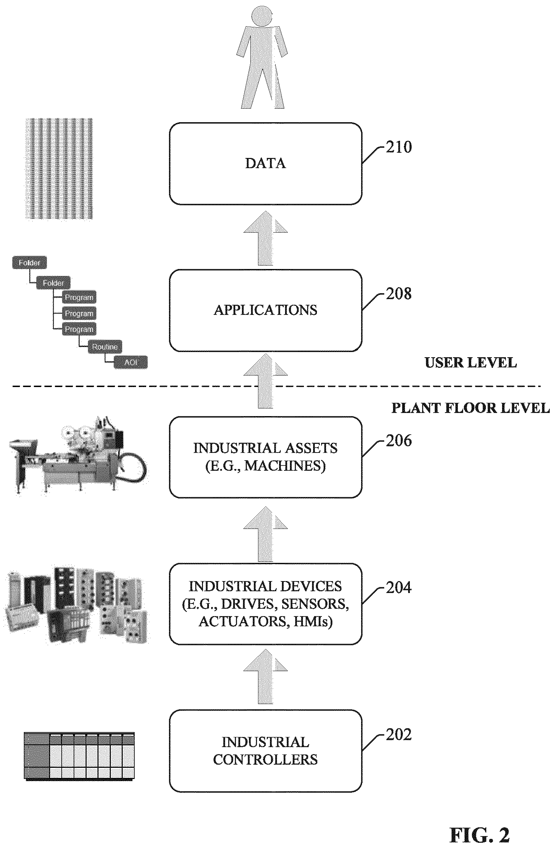

Industrial assets and their associated industrial assets can generate large amounts of information during operation. FIG. 2 is a conceptual diagram illustrating the flow of industrial data across various information levels in a typical industrial environment. On the plant floor level, industrial assets 206 - e.g., industrial machines, production lines, industrial robots, etc. - carry out respective tasks in connection with manufacture, packaging, or handling of a product; control of an industrial process; or other such industrial functions. These industrial assets 206 are directly monitored and controlled by industrial devices 204. For example, various statuses and metrics of the industrial assets 206 (e.g., actuator positions, motor speeds, temperatures, flows, pressures, human presence, etc.) can be monitored using proximity switches, telemetry devices, photo-sensors, or other such monitoring devices. Industrial devices that facilitate control of the industrial assets 206 can include, for example, motor drives, pneumatic actuators, remote I/O devices, or other such equipment. Industrial devices 204 can also include HMIs (e.g., HMIs 114).

Industrial controllers 202 perform supervisory monitoring and control of the industrial assets 206 via industrial devices 204. In this regard, industrial devices 204 serve as inputs and outputs for industrial controllers 202, which control their output industrial devices in accordance with user-defined control routines (e.g., ladder logic programs, sequential function chart programs, etc.) and the current values and statuses of the input industrial devices. Data generated by industrial devise 204 reflect the current statuses of the industrial assets 206. This data is read by industrial controllers 202, which can generate additional data (e.g., calculated supplemental data, aggregated values, etc.) based on these industrial device statues and values.

At the user level, customized applications - e.g., reporting applications, visualization applications, enterprise resource planning applications, manufacturing execution systems, etc. - can collect selected subsets of information available in industrial controllers 206 and present this information as formatted data 210 to a user in accordance with data presentation formats defined in the applications 208.

Collecting and delivering some or all of this information to a user in meaningful presentation formats can offer valuable insights into past, current, and future operation of the industrial assets 202. However, the highly distributed nature of data available across many industrial devices associated with various industrial machines or systems that make up an industrial enterprise presents a challenge with regard to collection and formatting of the data for a common presentation that can be delivered to a user's client device. Moreover, much of the information available on a given set of industrial devices comprises uncontextualized, unstructured data (e.g., integer, real, or discrete values stored on the data table of an industrial controller) whose meaning must be defined by the applications 208 used to present the data. This places a burden on the developers of such applications 208, who must designate the meaning of each item of unstructured data received and rendered by these applications so that the data will have meaning to the viewer (e.g., a product count, a production rate, a system temperature or pressure, a historical trend, etc.).

To address these and other issues, one or more embodiments of the present disclosure provide an industrial data presentation system that support the use of structured data types in connection with generating and delivering meaningful presentations of industrial data. In one or more embodiments, industrial devices and/or controllers are configured to support structured data types - referred to herein as basic information data types (BIDTs) - comprising a finite set of structured information data types. In an example implementation, the basic information data types can comprise four structured information data types representing (1) a rate, (2) states, (3), an odometer, and (2) events. Within an industrial device or controller configuration, a user can define associations between respective physical assets (e.g., a machine, a production line, etc.) and one or more of the basic information data types. This can include, for example, defining one or more data tags representing a metric or status of the physical asset and associating each tag with one of the basic information data types. Each basic information data type has associated metadata that can be configured by a user to customize the data tag for a given industrial application (e.g., maximum and minimum values for rate data types, roll-over values for odometer data types, event or state names for event and state data types, any parent-child relationships between data tags, etc.). Data tags conforming to basic information data types are also referred to herein as smart tags or smart objects.

Once configured in an industrial device or controller, the BIDTs (or smart objects) are discoverable by external data collection and/or visualization systems, including local systems sharing a network with the industrial device or remote cloud-based systems. For example, a gateway device can be configured with one or more asset models that reference BIDT data tags on the industrial devices. The asset models assign groups of BIDT data tags to respective hierarchical elements of the asset models (e.g., a production facility, a production area or line, and industrial asset, a unit of equipment, an industrial device, etc.). The gateway device can retrieve industrial data from the BIDT data tags, as well as the associated user-defined metadata for each tag. Then either the gateway device or a separate application server system can generate a graphical presentation of the industrial data based on a selected one of the asset models and the BIDT metadata.

BIDTs can also facilitate simplified integration of an automation model of an industrial asset with a non-automation model of the asset (e.g., a mechanical model, a financial model, a thermal model, etc.) by providing a common nomenclature by which both models can reference selected items of real-time or historical asset data. In this way, automation-domain properties of the automation model can be linked to corresponding properties of the non-automation model (e.g., machine domain properties of a mechanical model) by virtual of a common data source referencing.

Smart objects that include BIDT metadata can also serve as a foundation for building automation models or digital twins of industrial systems that can be simulated prior to deployment of those systems. In an example implementation, a testing and development platform for designing and simulating track-guided linear synchronous motor (LSM) transport systems can generate a digital model (e.g., an automation model, a digital twin, or another type of model) that represents an LSM transport system in accordance with design input submitted by a user. Such a design and testing system is described in more detail herein.

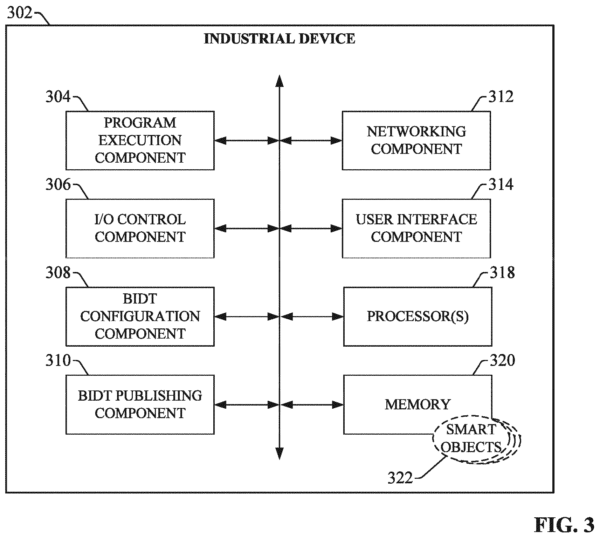

FIG. 3 is a block diagram of an example industrial device 302 that supports basic information data types according to one or more embodiments of this disclosure. Aspects of the systems, apparatuses, or processes explained in this disclosure can constitute machine-executable components embodied within machine(s), e.g., embodied in one or more computer-readable mediums (or media) associated with one or more machines. Such components, when executed by one or more machines, e.g., computer(s), computing device(s), automation device(s), virtual machine(s), etc., can cause the machine(s) to perform the operations described.

Industrial device 302 can comprise substantially any type of data-generating industrial device, including but not limited to an industrial controller, a motor drive, an HMI terminal, a vision system, an industrial optical scanner, or other such device or system. Industrial device 302 can include a program execution component 304, an I/O control component 306, a BIDT configuration component 308, a BIDT publishing component 310, a networking component 312, a user interface component 314, one or more processors 318, and memory 320. In various embodiments, one or more of the program execution component 304, I/O control component 306, BIDT configuration component 308, BIDT publishing component 310, networking component 312, user interface component 314, the one or more processors 318, and memory 320 can be electrically and/or communicatively coupled to one another to perform one or more of the functions of the industrial device 302. In some embodiments, components 304, 306, 308, 310, 312, and 314 can comprise software instructions stored on memory 320 and executed by processor(s) 318. Industrial device 302 may also interact with other hardware and/or software components not depicted in FIG. 3. For example, processor(s) 318 may interact with one or more external user interface devices, such as a keyboard, a mouse, a display monitor, a touchscreen, or other such interface devices.

Program execution component 304 can be configured to compile and execute a user-defined control program. In various embodiments, the control program can be written in any suitable programming format (e.g., ladder logic, sequential function charts, structured text etc.) and downloaded to the industrial device 302. Typically, the control program uses data values read by the industrial device's analog and digital inputs as input variables, and sets values of the industrial device's analog and digital outputs in accordance with the control program instructions based in part on the input values. I/O control component 306 can be configured to control the electrical output signals of the industrial device's digital and analog electrical outputs in accordance with the control program outputs, and to convert electrical signals on the industrial device's analog and digital inputs to data values that can be processed by the program execution component 304.

BIDT configuration component 308 can be configured to set metadata values associated with BIDT data tags defined for the industrial device 302 based on metadata configuration input data. As will be described in more detail below, in addition to standard general data types (e.g., real, analog, digital, etc.), industrial device 302 is configured to support industrial-specific data types referred to herein as basic information data types (BIDTs). Data tags or smart objects associated with these basic information data types have associated metadata that can be configured by the user via BIDT configuration component 308 in order to customize the data tags for a given industrial application. For convenience, data tags or objects that are associated with a basic information data type are referred to herein as smart objects. Smart objects 322 defined by the user - as well as pre-defined smart objects 322 - are stored in memory 320 (e.g., in the industrial device's tag database together other defined data tags of other data types).

BIDT publishing component 310 is configured to expose defined smart objects 322 to external systems, allowing the smart objects 322 to be discovered by such systems over a local and/or remote network. Networking component 312 can be configured to exchange data with one or more external devices over a wired or wireless network using any suitable network protocol. User interface component 314 can be configured to receive user input and to render output to the user in any suitable format (e.g., visual, audio, tactile, etc.). In some embodiments, user interface component 314 can be configured to communicatively interface with a development application that executes on a client device (e.g., a laptop computer, tablet computer, smart phone, etc.) that is communicatively connected to the industrial device 302 (e.g., via a hardwired or wireless connection). The user interface component 314 can then receive user input data and render output data via the development application. In other embodiments, user interface component 314 can be configured to generate and serve suitable graphical interface screens to a client device, and exchange data via these graphical interface screens. Input data that can be received via user interface component 314 can include, but is not limited to, user-defined control programs or routines, data tag definitions, BIDT metadata configuration data, or other such data.

The one or more processors 318 can perform one or more of the functions described herein with reference to the systems and/or methods disclosed. Memory 320 can be a computer-readable storage medium storing computer-executable instructions and/or information for performing the functions described herein with reference to the systems and/or methods disclosed.

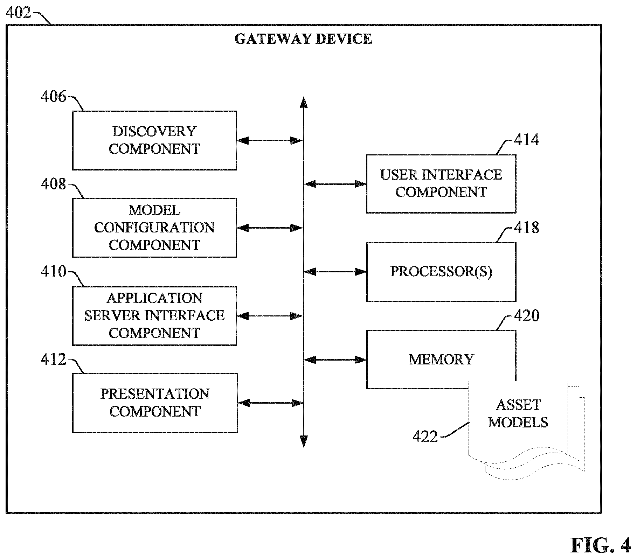

FIG. 4 is a block diagram of a gateway device 402 capable of discovering smart objects on one or more industrial devices and formatting a presentation of associated data in accordance with a user-defined asset model. Gateway device 402 can include a discovery component 406, a model configuration component 408, an application server interface component 410, a presentation component 412, a user interface component 314, one or more processors 418, and memory 420. In various embodiments, one or more of the discovery component 406, model configuration component 408, application server interface component 410, presentation component 412, user interface component 314, the one or more processors 418, and memory 420 can be electrically and/or communicatively coupled to one another to perform one or more of the functions of the gateway device 402. In some embodiments, components 404, 406, 408, 410, 412, and 414 can comprise software instructions stored on memory 420 and executed by processor(s) 418. Gateway device 402 may also interact with other hardware and/or software components not depicted in FIG. 4. For example, processor(s) 418 may interact with one or more external user interface devices, such as a keyboard, a mouse, a display monitor, a touchscreen, or other such interface devices.

Discovery component 406 can be configured to discover smart objects (e.g., smart objects 322) defined on industrial devices (e.g., industrial device 302) that are communicatively connected to the gateway device 402. Discovery component 406 can also be configured to retrieve data and metadata associated with the smart objects 322 for use in generating industrial data presentations. Model configuration component 408 can be configured to create and store one or more asset models 422 in accordance with user-defined asset model definitions. These asset models 422 can represent an industrial asset or collection of industrial assets in terms of hierarchical elements of an industrial facility or collection of facilities, where these hierarchical element can include, but are not limited to, a plant, a production area or line, an industrial machine or other industrial asset, a unit of equipment that makes up an industrial asset, an industrial device (e.g., a controller, a motor drive, a vision system device, a safety device, etc.) associated with an industrial asset, or other such elements. Asset models 422 can also assign groups of smart objects 322 to respective elements of the hierarchical model. Asset models 422 can be customized to suit the information requirements of various types of information consumers (e.g., line operators, engineers, plant managers, etc.).

Application server interface component 410 can be configured to expose asset models 422 and industrial data collected from industrial devices (e.g., industrial device 302) to an application server (e.g., application server system 502 discussed below), which can aggregate multiple asset models 422 into a larger aggregate plant or enterprise model and generate graphical presentations of the industrial data based on the plant model. Presentation component 412 can be configured to generate a data presentation - e.g., in the form of a graphical display layout, a collection of widgets, etc. - that renders selected subsets of industrial data received from the discovery component 406 in accordance with one or more of the asset models 422. In some embodiments, presentation component 412 can be configured to render data associated with a smart object using a suitable object-specific widget (or other graphical display element) selected from a set of predefined widgets.

User interface component 414 can be configured to receive user input and to render output to the user in any suitable format (e.g., visual, audio, tactile, etc.). In some embodiments, user interface component 414 can be configured to communicatively interface with a client application that executes on a client device (e.g., a laptop computer, tablet computer, smart phone, etc.) that is communicatively connected to the gateway device 402 (e.g., via a hardwired or wireless connection). The user interface component 414 can then receive user input data and render output data via the client application. In other embodiments, user interface component 414 can be configured to generate and serve suitable graphical interface screens to a client device, and exchange data via these graphical interface screens. Input data that can be received via user interface component 414 can include, but is not limited to, asset model definitions that are saved as asset models 422, or other such data.

The one or more processors 418 can perform one or more of the functions described herein with reference to the systems and/or methods disclosed. Memory 420 can be a computer-readable storage medium storing computer-executable instructions and/or information for performing the functions described herein with reference to the systems and/or methods disclosed.

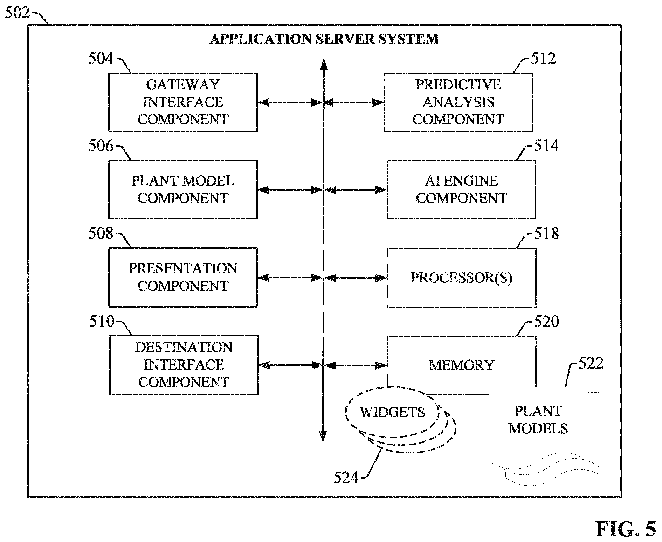

FIG. 5 is a block diagram of an application server system 502 capable of aggregating asset models 422 from gateway devices (e.g., gateway device 402) into one or more plant models 522 and formatting a presentation of associated data received from the gateway devices 402 in accordance with the aggregated plant models 522. Application server system 502 can include a gateway interface component 504, a plant model component 506, a presentation component 508, a destination interface component 510, a predictive analysis component 512, an AI engine component 514, one or more processors 518, and memory 520. In various embodiments, one or more of the gateway interface component 504, plant model component 506, presentation component 508, destination interface component 510, predictive analysis component 512, AI engine component 514, the one or more processors 518, and memory 520 can be electrically and/or communicatively coupled to one another to perform one or more of the functions of the application server system 502. In some embodiments, components 504, 506, 508, and 510 can comprise software instructions stored on memory 520 and executed by processor(s) 518. Application server system 502 may also interact with other hardware and/or software components not depicted in FIG. 5. For example, processor(s) 518 may interact with one or more external user interface devices, such as a keyboard, a mouse, a display monitor, a touchscreen, or other such interface devices.

Gateway interface component 504 can be configured to exchange data with one or more gateway devices (e.g., gateway device 402) over a wired or wireless network. In some embodiments, application server system 502 can be an on-premise device that resides on the plant floor, and the gateway interface component 504 can exchange data with the gateway devices 402 over a local plant and/or office network. In other embodiments, application server system 502 can reside on a cloud platform. In such embodiments, the gateway interface component 504 can exchange data with the gateway devices 402 over a combination of a public network (e.g., an Internet layer) and a private network (e.g., a plant or office network at the industrial facility).

The plant model component 506 can be configured to discover asset models 422 maintained on one or more gateway devices 402, and to aggregate these discovered asset models 422 into an overall plant model 522 for an industrial facility or enterprise. The plant model 522 can define hierarchical relationships between industrial assets of a given plant facility, or between assets distributed across geographically diverse plant facilities. The plant model 522 also defines relationships between smart objects 322 associated with the respective industrial assets by assigning groups of smart objects 322 defined in industrial devices associated with the industrial assets to respective hierarchical elements of the plant model 522 (e.g., production lines, industrial asset identifiers, units of equipment, industrial devices, etc.). By defining relationships between assets that make up an industrial facility or enterprise, the plant models 522 similarly define relationships between data items associated with those assets. The hierarchical relationships defined by the plant models 522 can be leveraged by the application server system 502 to present information about the assets to a user in a structured fashion.

Presentation component 508 can be configured to generate a data presentation - e.g., in the form of a graphical display layout, a collection of widgets 524, etc. - that renders selected subsets of data received from the gateway devices 402 in accordance with one or more of the plant models 522. In some embodiments, presentation component 508 can be configured to render data associated with a basic information data type tag using a suitable object-specific widget (or other graphical display element) selected from a set of predefined widgets 524. Destination interface component 510 can be configured to exchange data with one or more destination client devices over a wired or wireless network (e.g., a private plant or office network, a cloud platform, or a public network such as the Internet). This can include delivering the graphical data presentations to a client device in accordance with one or more of the plant models 522. Predictive analysis component 512 can be configured to perform predictive analysis on stored time-series industrial asset data.

AI engine component 514 can be configured to apply AI analysis to a digital twin that uses smart objects 322 as an underlying data foundation to facilitate discovery of new relationships between digital twin variables, validation of the digital twin relative to its modeled industrial asset, and adaptation of the digital twin for use with other assets or in other operating conditions.

The one or more processors 518 can perform one or more of the functions described herein with reference to the systems and/or methods disclosed. Memory 520 can be a computer-readable storage medium storing computer-executable instructions and/or information for performing the functions described herein with reference to the systems and/or methods disclosed.

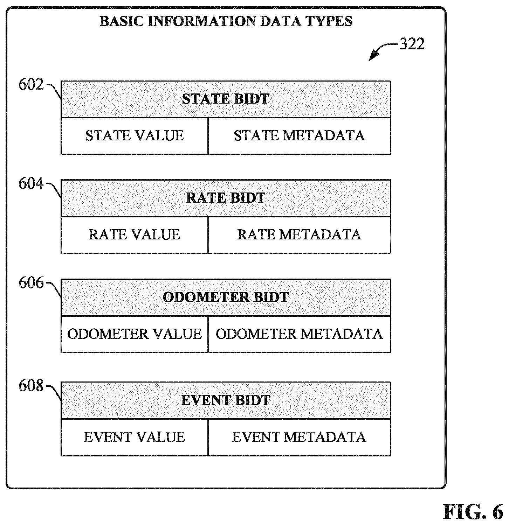

FIG. 6 is an illustration of four example smart objects 322 corresponding to respective four example basic information data types that can be supported by one or more embodiments of industrial device 302. These data types can supplement other standard data types that are typically supported by industrial controllers or other industrial devices (e.g., integer, real, Boolean, string, floating point etc.). In general, data tags are data structures defined within an industrial device that reference a memory location within the device (e.g., an input value, an output value, or an internal data register) and correspond to respective data items. A data tag can be configured to be (or may be an instance of) of a specified data type, such as Boolean, floating point, integer, double integer, string, etc. During development, controller tags can be created and maintained in a tag database of the industrial device. The BIDTs described herein are additional data types that are catered to industrial automation applications, and that supplement conventional data types. Data tags conforming to one or more basic information data types are referred to herein as smart objects or smart tags.

In the illustrated example, the smart objects 322 comprise a finite set of four structured information data types - a State BIDT 602, a Rate BIDT 604, an Odometer BIDT 606, and an Event BIDT 608. Although the examples described herein assume that the supported smart objects 322 comprise these four data types, it is to be appreciated that some embodiments may include other BIDT data types without departing from the scope of this disclosure.

Each smart object 322 includes a field for storing the current value of the object (e.g., a state value, a rate value, an Odometer value, and an Event value) as well as one or more metadata fields configured to store user-defined configuration data for that object 322. The metadata values for each smart object 322 can customize management and presentation of the associated object data value in accordance with the particular industrial asset or industrial application with which the smart object 322 is associated.

The value contained in a State BIDTs 602 can represent a current state of an industrial asset or device (e.g., a machine, a production line, a motor drive, etc.). The state data contained in a State BIDT 602 can represent one of a set of predefined states representative of a current state or status of the associated industrial asset or device. For example, the State BIDT may convey an S88 state, a Packaging Machine Language state, a current state of a state machine defined for the asset, a state of a valve (e.g., OPEN or CLOSED), a state of a motor (e.g., RUNNING, IDLE, FAULTED, etc.), or other types of states.

User-configurable metadata associated with the State BIDT 602 (which can be configured by BIDT configuration component 308 in accordance with user input received via user interface component 314) may define a state machine representing available states of the associated asset, where each defined state is configured to be invoked in response to a detected condition. For example, each defined state may be linked via the metadata to one or more other related data tags or smart objects 322 defined in the industrial device 302 (e.g., a smart object 322 representing a state of a sensor or switch indicative of the defined state), such that the current state indicated by the State BIDT 602 is a function of the current values of the related smart objects or data tags.

The value contained in a Rate BIDT 604 can represent an integer or real value of a measured rate of a metric associated with the industrial asset or device. The rate value may be an instantaneous rate or a value representing a rate of change of the metric over time. For example, the rate value contained in the Rate BIDT 604 can represent a temperature, a pressure, a velocity (e.g., a velocity of a conveyor or other motor-driven machine component), an overall equipment effectiveness (OEE), or other such metric.

User-configurable metadata associated with the Rate BIDT 604 can define maximum and minimum values for the corresponding rate value, such that the value contained in the Rate BIDT 604 will not deviate outside the window defined by the maximum and minimum value metadata. The metadata can also identify one or more data sources (e.g., one or more other smart objects 322, data tags, or input addresses) that determine the event. For example, the metadata for the Rate BIDT 604 can define whether the corresponding rate value is an aggregation of multiple other values contained in other defined smart objects 322 or data tags. In this regard, the user can define the rate value to be an average or a sum of two or more identified data tags, or an integral of a data tag over time. Another metadata field can be used to designate an engineering unit to be associated with the rate.

The value contained in the Odometer BIDT 606 can represent a cumulative quantity associated with an industrial asset. For example, the Odometer BIDT 606 can be configured to represent cumulative quantity with a rollover value, such as a part count associated with the industrial asset. In such cases, the metadata associated with the Odometer BIDT 606 can include a definition of the rollover value. The Odometer BIDT 606 may also be configured to represent a quantity over a defined time interval, such as an energy consumption associated with the asset. In the case of quantities over a defined time interval, the metadata associated with the Odometer BIDT 606 can include a definition of the time interval, which may be defined in terms of daily start and end times, in terms of a start time and a defined duration of the time interval, or as another time definition format. The metadata associated with the Odometer BIDT 606 can also define one or more data sources that drive the odometer value. For example, the metadata may define another data tag associated with a Cycle Complete event, such that the odometer value will increment when the Cycle Complete data tag goes high. The odometer value may also be defined to be an aggregation of multiple values. In such cases, the metadata may identify two or more data tags whose values are to be aggregated or summed to yield the odometer value. The metadata can also define a unit of measure associated with the odometer value (e.g., bottles filled, operating cycles, megawatt-hours, etc.).

The value contained in the Event BIDT 608 can represent an instantaneous or persistent event associated with an industrial asset. For example, an Event BIDT 608 may represent an instantaneous event such as a push-button event (e.g., "Service Button Pushed"), a sensor event (e.g., "Part Present," "Person Detected," etc.), a safety device event (e.g., "Light Curtain Broken"), or another such instantaneous event. Persistent events that can be represented by Event BIDT 608 can include, but are not limited to, events associated with an alarm status (e.g., "Alarm Unacknowledged," "Alarm Acknowledged," etc.). Other examples of persistent events that can be represented by an Event BIDT 608 can include persistent events with an identifier and a state. For example, events associated with a batch process can include a batch number (an identifier) and an associated event (e.g., "Starting," "Executing," "Complete," etc.). User-configurable metadata associated with the Event BIDT 610 can include identifiers of other smart objects 322 or data tags whose states, in aggregation, determine the event to be represented by the Event BIDT 610. Alternatively, if the event represented by Event BIDT 608 is a function of only a single input (e.g., a push-button input), the metadata can identify the appropriate input address of the industrial device.

In addition to the metadata described above for each basic information data type, the smart objects 322 may also include configurable metadata fields that define communication or discovery parameters for the respective smart objects 322. For example, each smart object 322 may include an Update Rate metadata parameter that allows the user to set the rate or frequency at which the smart object 322 sends its data to a gateway device in order to update a corresponding data presentation. Such metadata fields may allow the user to set the update period for the smart object 322 (e.g., a 60 second period, which causes the BIDT to send updated values every 60 seconds), or to specify that the smart object 322 is to send its updated value substantially continuously (e.g., every 5 milliseconds to 10 seconds).

It is to be appreciated that the smart objects 322 described above in connection with FIG. 6 are intended to be exemplary, and that smart objects 322 conforming to other types of BIDTs are also within the scope of one more embodiments of this disclosure.

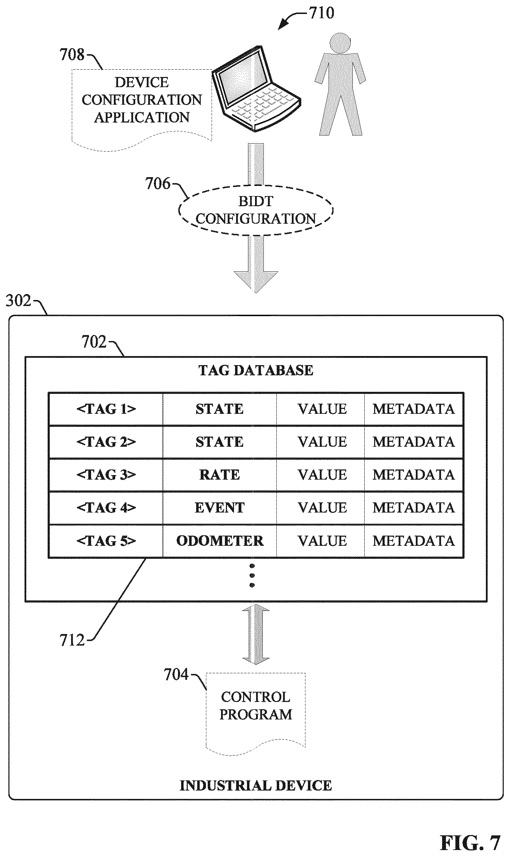

In an example scenario, a user can configure smart objects 322 in an industrial controller or other industrial device during control program development, along with other data tags to be used by the control program. FIG. 7 is a diagram illustrating configuration of smart objects 322 in a tag database 702 of an industrial device 302 that supports BIDTs. Industrial device 302 may be, for example, an industrial controller (e.g., a programmable logic controller or other type of programmable automation controller) configured to execute an industrial control program 704 to facilitate monitoring and control of an industrial machine or process. Industrial device 302 includes a tag database 702 that stores data tag definitions. The data tag definitions are configured by a user in tandem with development of control program 704 (e.g., a ladder logic program, a sequential function chart program, etc.), and define data tags 712 of various data types that are used to store and identify analog and digital data values generated and consumed by the control program 704. Example standard data types that can be represented by data tags 712 can include, for example, integer data types, real data types, Boolean data types, etc. In addition to these standard data types, one or more of the data tags 712 can include smart objects 322 (e.g., smart objects corresponding to BIDTs 602, 604, 606, and 608) associated with the basic information data types described herein.

In this example scenario, a user can configure both the control program 704 and the data tag definitions using a device configuration application 708 that executes on a client device 710 (e.g., a laptop computer, a desktop computer, a tablet computer, etc.) that is communicatively interfaced to the industrial device 302. In various embodiments, client device 710 can interface with the industrial device 302 over a hard-wired connection (e.g. a universal serial bus connection, an Ethernet connection, a serial connection, etc.) or over a wireless connection (e.g., near-field, WiFi, etc.) supported by user interface component 314. Device configuration application 708 can execute a program development environment that can be used to develop control program 704 and its associated data tags 712, including any smart objects 322 to be associated with one or more industrial assets to be controlled using control program 704.

During development, BIDT configuration component 308 of the industrial device 302 can create smart objects 322 corresponding to any of the BIDT types described above (state, rate, odometer, and event, or other supported BIDT types) in accordance with BIDT configuration input 706 downloaded to industrial device 302 by client device 710. Using device configuration application 708, the user can also configure the metadata associated with each smart object 322 in order to customize the smart objects 322 for a given industrial application. For example, for a State smart object 322 (corresponding to State BIDT 602) associated with a bottle filling machine to be controlled by industrial device 302, the user may specify the various states to be represented by the smart object 322 (e.g., Running, Home, Abnormal, Idle, etc.). In some embodiments, the BIDT configuration component 308 can support a number of pre-defined states that can be selected by the user and associated with a given State smart object 322. In addition or alternatively, the user can define the names of one or more of the states to be associated with the State smart object 322.

For a Rate smart object 322 (corresponding to Rate BIDT 604) representing a velocity of a conveyor that feeds bottles to the filling machine, the user can specify maximum and minimum values for the velocity value. Accordingly, the Rate smart object 322 will not generate a velocity value that is outside the range defined by the defined maximum and minimum values, and may generate an error or alarm output if the measured velocity value exceeds the defined maximum or falls below the defined minimum. Another Rate smart object 322 representing an average temperature may be configured to average multiple analog temperature input values specified by the user in the metadata. For an Odometer smart object 322 representing a product count (e.g., the number of filled bottles output by the filling machine), the user can configure the associated metadata to define a data tag - or another smart object 322 - that is to trigger an increment of the odometer value (e.g., an input tag or another smart object 322 representing a "fill cycle complete" event), as well as daily shift start and shift end times between which the value of the Odometer smart object 322 will increment before being reset to zero. Metadata of an Event smart object 322 associated with a component of the filling machine can define an input address or data tag representing a state of a device (e.g., a push-button, a photo-sensor, etc.) that determines the event, or an alarm data tag corresponding to an alarm whose state (e.g., Abnormal, Normal, Acknowledged, Unacknowledged, etc.) determines the event.

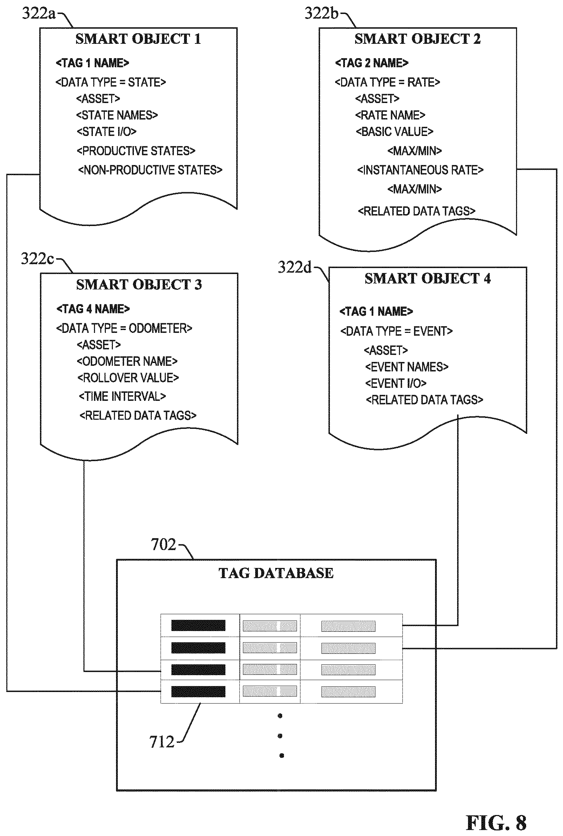

Once the data tags (including standard data tags and smart objects 322) are configured, the tag database 702 stores the configured data tags 712 on memory 320 of industrial device 302, where the data tags 712 are accessible by control program 704. FIG. 8 is a diagram illustrating storage of smart objects 322 in tag database 702, which shows example data fields for respective types of smart objects 322. In the example depicted in FIG. 8, smart object 322a is a State smart object with metadata fields for a name of an industrial asset associated with the smart object 322a (e.g., a name of a bottle filling machine, a die cast furnace, a stamping press, etc.), names of the states represented by the smart object 322a, identification of one or more device inputs or other data tags that determine the states, identification of productive and non-productive states, etc.

Smart object 2 322b is a Rate smart object with metadata fields for an industrial asset name, a name of the rate represented by the rate value (e.g., Line 3 Conveyor Velocity), maximum and minimum values for a basic rate value and/or for an instantaneous rate, related data tags whose values are aggregated to obtain the rate value, a unit for the rate value, or other such metadata fields. Smart object 3 322c is an Odometer smart object with metadata fields for an asset name, a name of the odometer value (e.g., Bottles Filled, #4 Die Cast Energy Consumption, etc.), a rollover value representing a value of the odometer value at which the value will return to zero, a time interval during which the odometer value is to be incremented (e.g., a start and end time corresponding to a work shift), one or more related data tags that trigger an increment of the odometer value, a unit associated with the odometer value, or other such metadata fields. Smart object 4 344d is an Event smart object with metadata fields for an asset name, names one or more events represented by the Event smart object 344d, identification of one or more inputs or data tags that determine the event, or other such metadata data fields.

It is to be appreciated that the metadata fields described above in connection with FIG. 8 are only intended to be exemplary, and that the metadata for a smart object 322 can have any suitable set of data fields that allow the user to align the smart object 322 with the industrial application carried out by the industrial device 302.

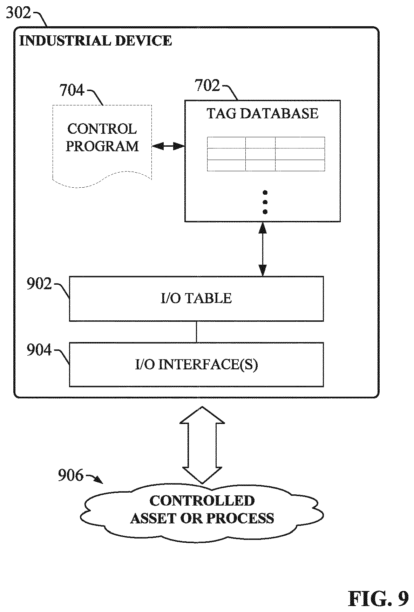

After industrial device 302 has been programed and configured (including creation of any smart objects 322 to be used by the control program 704), the industrial device 302 can be deployed on the plant floor to facilitate control of one or more industrial assets or processes. FIG. 9 is a diagram illustrating runtime operation of an example industrial device 302 that supports BIDTs and smart objects 322. In this example, industrial device 302 is assumed to be an industrial controller (e.g., a PLC or other type of programmable automation controller). Controlled asset or process 906 can represent any industrial machine, production line, process, or operation under the control of industrial device 302. Controlled asset or process 906 can have a number of associated input and output devices (e.g., industrial devices 204 of FIG. 2) that receive command signals from or send telemetry data to industrial device 302 over any suitable combination of hardwired or networked connectivity to regulate a controlled operation. Industrial device 302 can also include one or more I/O interfaces 904 that provide hardwired or networked connectivity to the controlled equipment and industrial devices associated with the controlled asset or process 906. These I/O interfaces 904 can include, for example, digital and/or analog input modules, digital and/or analog output modules, networking modules, or the like.

An I/O table 902 within the industrial device's memory 320 can maintain current analog and digital values of the various inputs and outputs read from or written to the I/O interfaces 904. That is, data signals read from field devices by I/O interfaces 904 (e.g., analog or digital input modules) can be written to the I/O table 902 (e.g., by I/O control component 306). Some or all of these input values can be linked to respective data tags (standard data tags or smart objects 322) maintained in tag database 702, which can be read by control program 704 or by external applications. These input values can then be read from the appropriate data tags or smart objects 322 by control program 704, which updates its control variables accordingly. Similarly, output values generated by the control program 704 can be written to output data tags defined in tag database 702, causing the corresponding output registers of I/O data table 902 to be updated. The I/O control component 306 then generates appropriate analog or digital output signals at the output points of I/O interfaces 904 in accordance with the updated output values. It is to be appreciated that this overview of industrial controller functionality is only intended to be exemplary, and that the smart objects 322 described herein can be implemented on other types of industrial controllers having different data update processes, or on different classes of industrial devices.

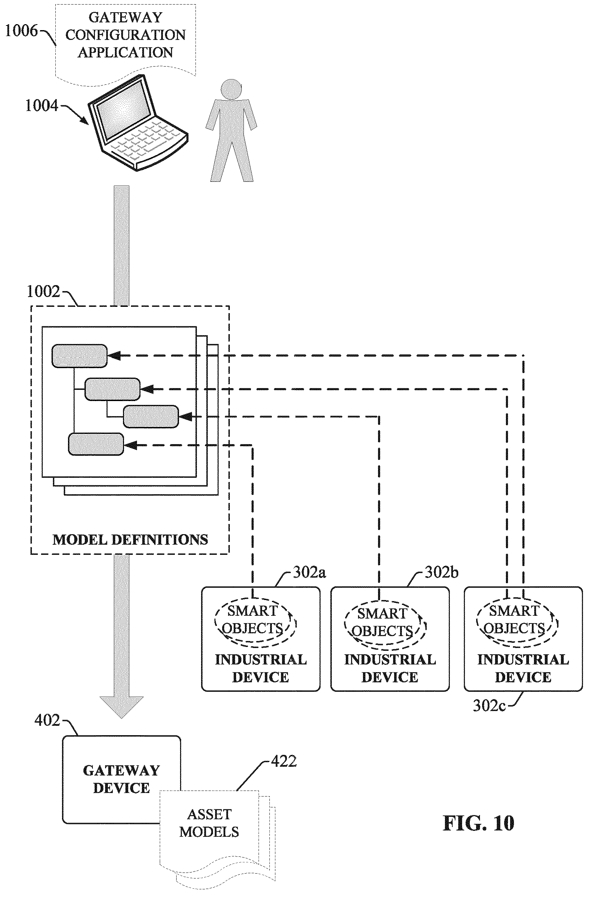

Smart objects 322 in tag database 702 are discoverable by external systems, so that the smart tag data - with associated metadata customized in accordance with the industrial application carried out by industrial device 302 - can be retrieved and organized by those external systems in accordance with user-defined asset and/or plant models. In one or more embodiments, a gateway device 402 can be used to collect, format, and present data from one or more BIDT-capable industrial devices 302. FIG. 10 is a diagram illustrating configuration of a gateway device 402 with one or more asset model definitions. Gateway device 402 can be configured using a gateway configuration application 1006 that executes on a client device 1004 (e.g., a laptop computer, a desktop computer, a tablet computer, etc.). In some embodiments, gateway configuration application 1006 can be an integrated tool of device configuration application 708 used to program and configure industrial device 302.

Gateway configuration application 1006 allows a user to define an asset structure or model of an industrial automation application or a collection of industrial automation applications being monitored and controlled by one or more BIDT-capable industrial devices 302. These asset models define hierarchical relationships between industrial assets, associated industrial devices, production lines or areas, and data generated by the various devices associated with the industrial applications. Using gateway configuration application 1006, a user can define these asset models as model definitions 1002, which can be downloaded to and stored on gateway device 402 as asset models 422.

To facilitate creation of the model definitions 1002, gateway configuration application 1006 can be configured to generate and render suitable configuration screens on client device 1004 that guide the user through the process of defining these asset models 422 for their own industrial applications. The model definitions 1002 can be defined to reference the smart objects 322 defined on one or more industrial devices 302. In particular, the model definitions 1002 can define, as nodes of the hierarchy, hierarchical elements of an industrial asset or collection of assets, and assign selected groups of smart objects 322 to respective elements with which the smart objects 322 are associated (e.g., a node associated with an industrial asset, a unit of equipment associated with the asset, or an industrial device associated with the asset). The asset models 422 are thereby configured by the user to associate the respective smart objects 322 with selected industrial machines, devices, production lines, and/or plant facilities, as well as to define hierarchical relationships between these elements.

In embodiments in which gateway configuration application 1006 is an integrated tool of device configuration application 708, model building tools of the gateway configuration application 1006 can allow the user to build the model definitions 1002 by browsing to selected smart objects 322 defined in one or more industrial device configuration files (e.g., the configuration files that are downloaded to the industrial devices 302, and which define the control program 704 and tag database 702). The user can create nodes representing an industrial facility, production lines or areas within the industrial facility, industrial assets (e.g., industrial machine, industrial robots, etc.) within each production line, units of equipment associated with a given industrial asset (e.g., a loader, a pusher, a machining station, etc.), and/or industrial devices (e.g., controllers, drives, etc.) associated with each industrial asset. Selected smart objects 322 defined on respective industrial devices 302a, 302b, and 302c can then be associated with respective nodes defined in the model definitions 1002 to yield an asset model 422, which can be downloaded to gateway device 402. The asset model 422 allows the user to define a hierarchical asset or plant architecture, and to group smart objects 322 within the framework in association with selected nodes representing plant production areas or production lines, industrial assets, and/or equipment and devices associated with the assets.

Asset models 422 defined on gateway device 402, working in conjunction with the BIDTs defined on industrial devices 302, contextualize data generated by industrial applications and facilitate generation of contextualized data presentations. For a given industrial application, multiple asset models 422 can be created and maintained on gateway device 402, where each asset model 422 can represent a different view of the industrial application. The different views represented by the asset models 422 can be customized to the needs of a particular user role.

The BIDT publishing component 310 of each industrial device 302 exposes the smart objects 322 of the industrial device 302 to the asset models 422 defined on the gateway device 402. Thus, when the gateway device 402 is deployed on a plant network or on a cloud platform having secured remote access to the industrial devices 302, the asset models 422 can cause the gateway device 402 to retrieve data from the respective smart objects 322 as well as the metadata parameters associated with each smart object 3223 in order to generate contextualized presentations of the industrial application data in accordance with the asset models 422.

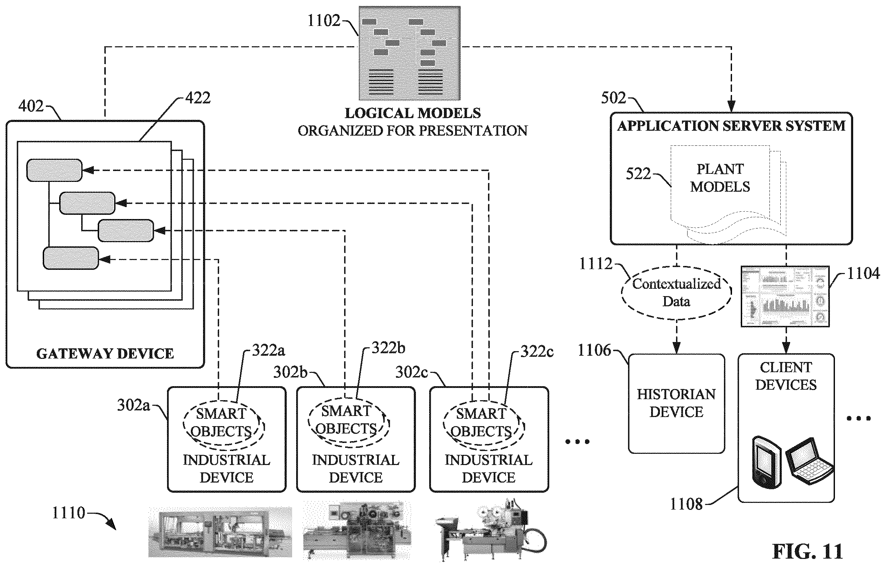

FIG. 11 is a diagram illustrating the flow of smart object data from industrial devices 302 to an application server system 502 that delivers contextualized presentations of the smart object data. In this example, multiple industrial devices 302 (e.g., 302a, 302b, and 302c) have been programmed to control respective industrial assets 1110 (e.g., industrial machines, production lines, etc.). Each industrial device 302 has been configured with a number of smart objects 322, as described above in connection with FIGs. 6-9. A gateway device 402 has been configured with a number of asset models 422, as described above in connection with FIG. 10. Asset models 422 define respective customized views of the smart object (BIDT) data.

During operation, industrial devices 302a-302c monitor and control their respective industrial assets 1110 (e.g., via respective input and output devices associated with the respective industrial assets 1110). Gateway device 402 is networked to the respective industrial devices 302a-302c. For example, gateway device 402 may be an on-premise device that resides on the same plant network as industrial devices 302a-302c. In another implementation, gateway device 402 may reside on a cloud platform and is capable of securely accessing the plant network from the cloud platform (e.g., through a firewall device).

The BIDT publishing component 310 of each industrial device 302 exposes the data and metadata associated with each configured smart object 322 to the gateway device 402, rendering the smart object data and metadata accessible and retrievable by the discovery component 406 of the gateway device 402. For each model 422 defined on gateway device 402, the model configuration component 408 of the gateway device 402 retrieves the data and metadata for each smart object 322 referenced by the model 422 (as specified by the user-defined model definitions 1002) and creates a logical model 1102 of the data based on the model 422 and the smart object data and metadata. Logical model 1302 organizes the data from the smart objects 322 in accordance with the hierarchical asset models 422 defined by the user.

Gateway device 402 includes an application server interface component 410 (see FIG. 4) that communicatively connects the gateway device 402 to an application server system 502. Although application server system 502 is depicted in FIG. 11 as being a separate system relative to gateway device 402, in some embodiments the application server system 502 can be an integrated application of the gateway device 402. Application server system 502 is configured to receive the logical model 1302 from gateway device 402 and serve data display presentations 1104 to authorized client devices 1108. For example, the presentation component 508 of application server system 502 can generate an application view of the smart object data based on the logical model and associated smart object data and metadata received from the gateway device 402, and the destination interface component 510 of the application server system 502 sends this application view to one or more client devices 1108 as data display presentation 1104. In some scenarios, application server system 502 can also store selected subsets of the contextualized data 1112 in a historian device 1106 that is integrated with or communicatively connected to application server system 502.

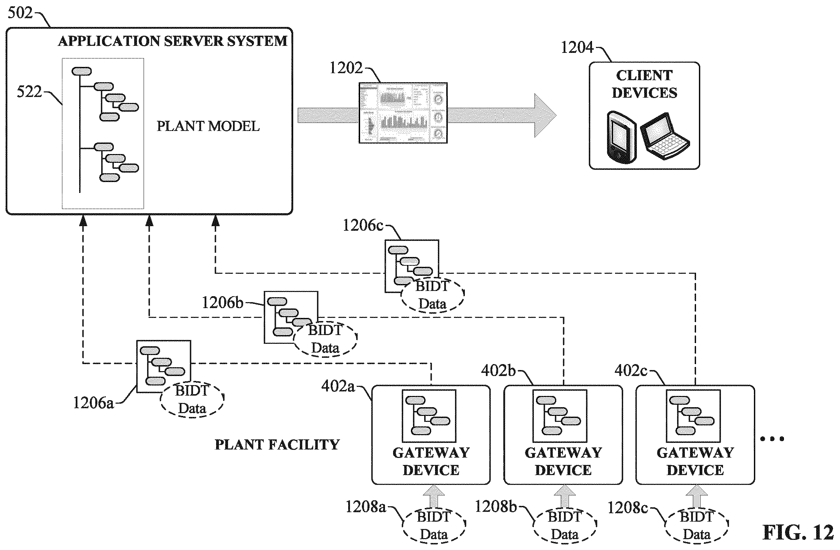

Data display presentations 1104 can present the contextualized data from the smart objects 322 in a format that generally aligns with the plant and asset hierarchy defined by the asset models 422. In the example depicted in FIG. 11, the application server system 502 is depicted as receiving logical models 1302 and smart object data and metadata from a single gateway device 402 that receives and contextualizes smart object data from multiple industrial devices 302a-302c. As illustrated in FIG. 12, in some embodiments application server system 502 can be configured to collect logical models 1102 and smart object data and metadata from multiple gateway devices (e.g., gateway devices 402a-402c), and integrate the logical models 1102 into a common plant model 522. In an example implementation, gateway devices 402a-402c may reside at different areas of a given plant facility, and application server system 502 can be either an on-premise device or a cloud-based system that receives the defined asset models 1406a-1406c from the respective gateway devices 402a-402c, together with the BIDT data and metadata from the smart objects 322 defined on each gateway device 402a-402c. In another example implementation, gateway devices 402a-402c may reside at different geographically diverse industrial facilities whose plant and/or office networks are linked to a cloud platform on which application server system 502 executes.

Gateway devices 402a-402c collect BIDT data 1208a-1208c from respective industrial devices (not shown in FIG. 12), as described in previous examples. Each of the gateway devices 402a-402c is configured with one or more asset models 1206a-1206b, as also discussed above. The application server system 502 retrieves the asset models 1206a-1206c from the respective gateway devices 402a-402c, and the plant model component 506 of the application server system 502 integrates the asset models 1206a-1206c into an aggregate plant model 522, which is used as the basis for formatting and presenting the BIDT data via data presentations 1202.

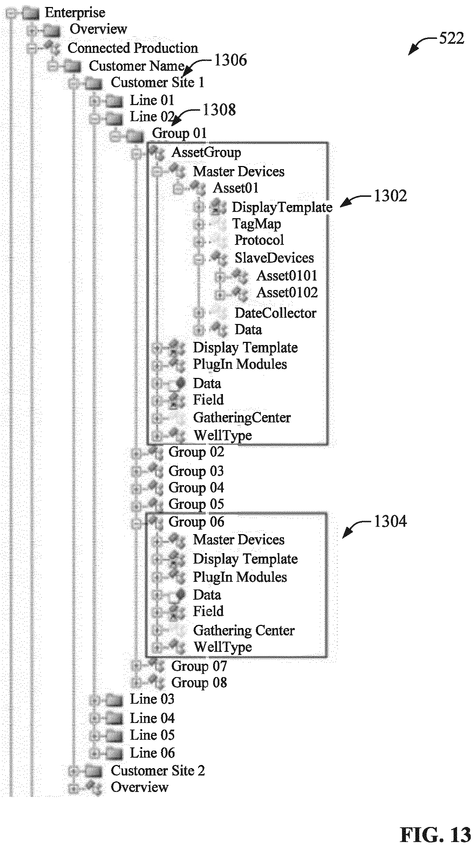

FIG. 13 is an example plant model 522 generated by application server system 502 by integrating multiple asset models received from respective multiple gateway devices 402. In this example, the gateway interface component 504 of application server system 502 has discovered two new asset models 1302 and 1304 residing on respective two gateway devices 402, and has integrated models 1302 and 1304 into the larger plant model 522. Asset model 1302 corresponds to an asset group named Group 01, which resides at a plant facility indicated by plant node 1306 (Customer Site 1). Accordingly, the plant model component 506 of application server system 502 has inserted asset model 1302 under an appropriate asset group node 1308 (Group 01) below the plant node 1306. The plant model component 506 can determine the appropriate location at which to connect the asset model 1302 within the plant model 522 based on user-defined context information associated with the asset model 1302 (e.g., an explicit definition of the plant facility and production area within which the asset represented by asset model 1302 resides). As shown in FIG. 13, asset model 1302 defines a master device (Asset01) and a number of slave devices (Asset0101, Asset0102) that make up the asset.

Asset model 1304 represents a second asset located in the same plant facility, customer site, and production line (Line 02). Accordingly, asset model 1304 has been inserted under the same plant node 1306 and production line node (Line 02).

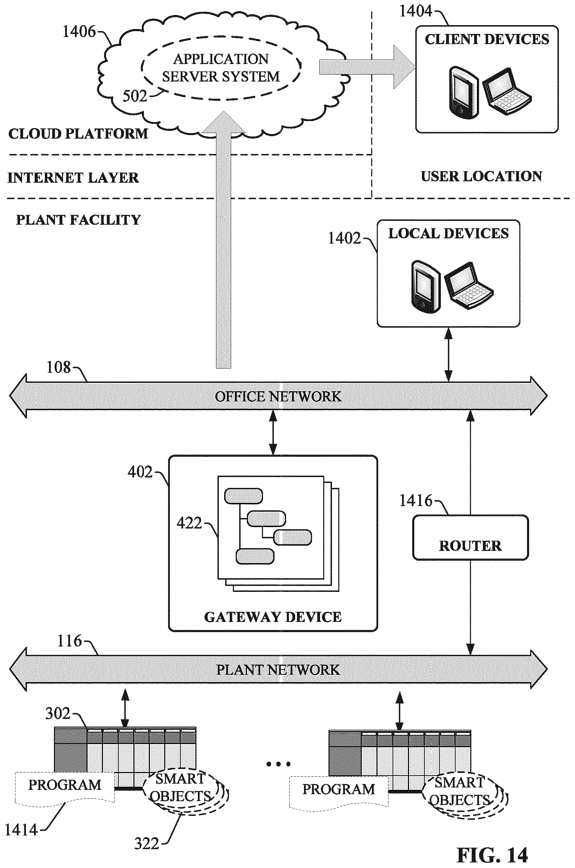

FIG. 14 is a diagram illustrating an example network architecture that includes industrial devices 302, a gateway device 402, and a cloud-based application server system 502. In this example, industrial devices 302 are industrial controllers that each execute a control program 1414, where a number of smart objects 322 have been configured on each controller. The industrial devices 302 are connected to a plant network 116 (e.g., a common industrial protocol network, an Ethernet/IP network, etc.) that facilitates data exchange between industrial devices on the plant floor. Plant network 116 may be a wired or a wireless network. In the illustrated example, gateway device 402 resides on a separate office network 108 that is connected to the plant network 116 (e.g., through a router 1416 or other network infrastructure device). However, the gateway device 402 can also be installed directly on the plant network 116 in other implementations, or may connect to each industrial device 302 over a separate wired or wireless connection.

As described in previous examples, gateway device 402 can be configured with one or more asset models 422 that define groupings of smart objects 322 within a user-defined hierarchical representation of a plant, a production area, and/or an industrial asset. The BIDT publishing component 310 of the industrial devices 302 expose the smart objects 322 to the gateway device 402 over a communication channel that traverses the plant network 116 and the office network 108 (that is, the BIDT publishing component 310 renders the smart objects 322 communicatively accessible to the discovery component 406 of the gateway device 402).

In this example, application server system 502 is a cloud-based system that resides on a cloud platform 1406 and executes as a cloud-based service that is accessible to authorized remote client devices 1404 as well as the gateway device 402. Cloud platform 1406 can be any infrastructure that allows shared computing services (such as application server system 502) to be accessed and utilized by cloud-capable devices. Cloud platform 1406 can be a public cloud accessible via the Internet by devices 1404 having Internet connectivity and appropriate authorizations to utilize the application server system 502. In some scenarios, cloud platform 1406 can be provided by a cloud provider as a platform-as-a-service (PaaS), and the application server system 502 can reside and execute on the cloud platform 1406 as a cloud-based service. In some such configurations, access to the cloud platform 1406 and associated application server system 502 can be provided to customers as a subscription service by an owner of the application server system 502. Alternatively, cloud platform 1406 can be a private cloud operated internally by the industrial enterprise (the owner of the plant facility). An example private cloud platform can comprise a set of servers hosting the application server system 502 and residing on a corporate network protected by a firewall.

If cloud platform 1406 is a web-based cloud, the application server interface component 410 of the gateway device 402 may interact with the application server system 502 via a secure Internet connection. In some embodiments, gateway device can also be embodied as an integrated component of a network infrastructure device, such as a network switch, router, or hub. In such embodiments, the network infrastructure device performs the network connectivity functions of a network switch, hub, or router, as well as the functions of the gateway device 402 as described above.

The basic information data types and associated services described herein can simplify creation of customized industrial data visualization presentation using an elegant, adaptable, and scalable architecture. A given industrial asset, collection of assets, or industrial application can be described in terms of customized smart objects at the controller level. Asset models can be created that define the industrial assets in terms of user-defined groupings of these smart objects, where multiple different asset models can be defined that are customized for respective different user roles or views. These asset models, together with data and metadata associated with these smart objects, are used to generate graphical presentations of the asset data that are structured in accordance with the models. An application server system can render the smart object (BIDT) data on these presentations using suitable graphical widgets or other graphical elements, which may include widgets that are specific to a given type of smart object (e.g., state, rate, odometer, event, etc.). As industrial assets are added, removed, or modified, the associated asset models can be reconfigured to add, remove, modify, or re-locate nodes, and the data presentations will be updated accordingly. The smart objects 322 are discoverable by a gateway device that maintains the asset models, so that newly added smart objects instantiated on an industrial controller or other industrial device can be easily integrated into the asset models and associated graphical data presentations.

The asset models 422 and plant models 522 described above represent static and dynamic properties of an industrial asset, defined in terms of groupings of smart objects 322 within a user-defined hierarchical representation of the asset. An asset model 422 for a given industrial asset may define the hierarchical arrangement of sub-assets that make up the asset being defined, and identify the smart objects 322 corresponding to the static and/or dynamic properties of each sub-asset. For example, a depositor may comprise an inlet, a hopper, and a piston. Accordingly, an asset model 422 representing the depositor may define the inlet, hopper, and piston as sub-assets or child nodes of the larger industrial asset. The asset model 422 may also identify the smart objects 322 defined on one or more industrial devices that correspond to the dynamic or static properties of each of the sub-assets. For example, the depositor's inlet may have an associated speed rate obtained from a smart object named Depositor.Inlet.Speed_Rate (a Rate smart object). The inlet may also have an execution state, and a production state that are obtained from respective smart objects named Depositor.Inlet.Execution_State and Depositor.Inlet.Production_State. A batch event value for the inlet may be obtained from a smart object named Depositor.Inlet.Batch_Event.

The asset model 422 for the depositor asset can define a hierarchical automation organization of these sub-assets and their associated smart objects 322. The hierarchical automation organization can comprise as many hierarchical levels as is necessary to describe the industrial asset. For example, sub-assets may also have their own sub-assets which are defined in the asset models 422 as child nodes of the sub-assets. Moreover, plant models 522 comprising a collection of asset models 422 may encompass an entire production line or collection of production lines, such that asset nodes and their associated child nodes are defined as child nodes of the production line node to which the assets belong.

By defining an organization of industrial assets and their sub-assets, as well as linking the assets' static and dynamic properties to their corresponding smart objects 322, asset models 422 and plant models 522 can serve as automation models for an industrial machine, asset, production area, or plant. In one or more embodiments, the use of smart objects 322 to define asset models 422 can also allow the asset models 422 to be easily integrated with non-automation models of the industrial assets by virtue of a common smart object nomenclature. Linking properties of an asset (automation) model 422 to corresponding properties of a non-automation model - such as a mechanical model, a business model, a thermal model, or another type of non-automation model - can yield a composite model of the industrial assets that can be used for a variety of purposes, including but not limited to holistic real-time or historical visualization of asset information, predictive analytics, simulation, training, software validation, or other such uses.

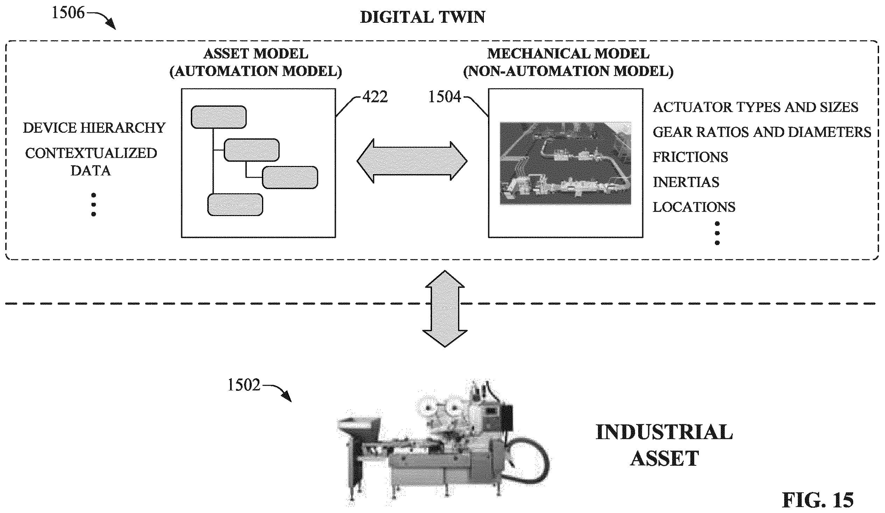

FIG. 15 is a diagram illustrating integration of an asset model 422 of an industrial asset 1502 with a mechanical model 1504 (a type of non-automation model) of the industrial asset 1502 to yield a digital twin 1506 for the asset 1502. Although the examples described herein depict creation of a digital twin by linking an asset (automation) model 422 with a mechanical model, it is to be appreciated that the techniques described herein can also be used to link an automation model with other types of non-automation models, including but not limited to a thermal model that defines thermal characteristics of components that make up the industrial asset, a business or financial model that defines financial information associated with operation of the asset (e.g., material or energy costs as a function of operating characteristics or runtimes, profits associated product output, etc.), or another type of model that defines non-automation characteristics of the asset.

As described above, the asset model 422 can define a hierarchical arrangement or organization of machines and/or industrial devices that make up the industrial asset 1502, as well as the device-level smart objects 322 that corresponding to monitored values, events, states, rates, or other dynamic properties associated with the various machines and devices. The asset model 422 can contextualize monitored telemetry values (e.g., temperatures, pressures, speeds, torques, etc.), machine and device states, control events, product counts, energy consumption, and other dynamic control and operation properties. The asset model 422 can therefore be viewed as an automation model that describes static and dynamic properties of the industrial asset 1502 as contextualized and organized BIDT data.

Mechanical models 1504 define mechanical properties of the industrial asset 1502. An example mechanical model 1504 of an industrial asset 1502 may define gear ratios and/or gear diameters of a gear box used in the industrial asset 1502, types and sizes of actuators used in the industrial asset 1502, inertias and coefficients of friction of mechanical components or surfaces of the industrial asset 1502, relative locations or orientations of the mechanical components, or other such mechanical properties. Mechanical models 1504 can also define mechanical formulas representing mechanical transformations applied by components of the industrial asset (e.g., formulas representing torque, speed, or force translations across the industrial asset 1502).

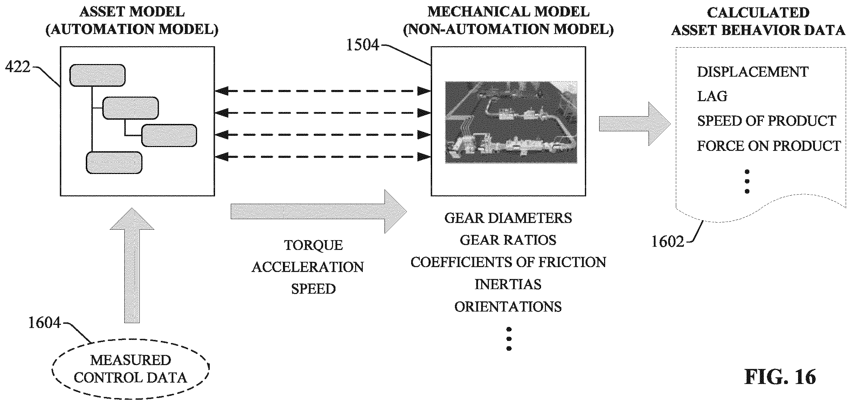

If the automation model - embodied by asset model 422 - can be linked to the mechanical model 1504 such that contextualized data can be shared between the two models, the resulting composite model can serve as a digital twin 1506 of the industrial asset 1502 that, when provided with real-time or historical smart object data generated by the industrial asset 1502 being modeled, holistically describes real-time or historical behavior of the industrial asset 1502. FIG. 16 is a diagram illustrating generation of supplemental asset behavior data 1602 based on integration of an asset (automation) model 422 with a mechanical model 1504 of the industrial asset 1502. The asset model 422 can contextualize measured control data 1604 read from industrial devices (e.g., sensors, telemetry devices, controllers, drives, etc.) during control and operation of the industrial asset 1502. As described in previous examples, this data can be obtained from the smart objects 233 configured on the industrial devices. The measured asset data can include positions of machine components or manufactured products, velocities (e.g., velocities of conveyors or other motor-driven assets, robot operating speeds, etc.), flows, pressures, electrical currents, part presence or human presence indicators, or other such measured values. By linking some of these control-domain values to the mechanical model 1504, additional calculated data 1602 for the industrial asset 1502 can be generated by applying the mechanical properties and formulas defined by the mechanical model 1504 to the measured control-domain data.

In an example scenario, the industrial asset 1502 may include a conveyor that transfers parts between two work stations. Measured control data 1604 may include torque, acceleration, and speed values for the motor that drives the conveyor (read from the motor drive). These control values - contextualize by the asset model 422 - can be combined with such mechanical model properties as the conveyor's coefficient of friction, roller diameters, or inertia to calculate such additional data 1602 as the force that acts on a product being transferred by the conveyor, a speed or displacement of the product over a defined time period, product lag, or other such information. Since many mechanical properties defined in the mechanical model 1504 are transformational (e.g., ratios or mechanical coefficients present in the assets gears, cranks, surfaces, etc.), these mechanical properties and associated mechanical formulas defined by the mechanical model 1504 can be applied to the contextualized measured automation values provided by the asset model 422 (e.g., torques, motor speeds, pressures, etc.) to calculate forces, speeds, positions or other dynamic properties of the industrial asset's machine components or manufactured products. Thus, the combined asset model 422 and mechanical model 2304 can be leveraged to yield a more holistic and comprehensive representation of the industrial asset 1502, describing static control and mechanical properties of the asset as well as dynamic asset and product behaviors calculated based on measured and contextualized automation data.

For a given industrial asset 1504 for which an automation model and a mechanical model has been developed, there may be thousands of points of potential connectivity between the automation and mechanical models; that is, connections between contextualized automation values provided by the asset model 422 and points in the mechanical model 1504 to which these values apply in the mechanical domain. For example, in order to calculate how a torque applied by a motor translates to a speed or a force applied to a product resting on a conveyor driven by the motor, a connection must be defined between the relevant measured torque value in the asset model 422 and the location in the mechanical domain (a point defined in the mechanical model 1504) to which the torque is applied. Conventionally, even if an automation model and a mechanical model exists for a given industrial asset, these links between properties of the automation model and the mechanical model must be defined manually, a process which can be time-consuming, laborious, and prone to error. The complexities of integrating an automation model with a mechanical model are even greater in cases in which the automation and mechanical models are developed by two different engineering entities who use different protocols and naming conventions for the respective models.

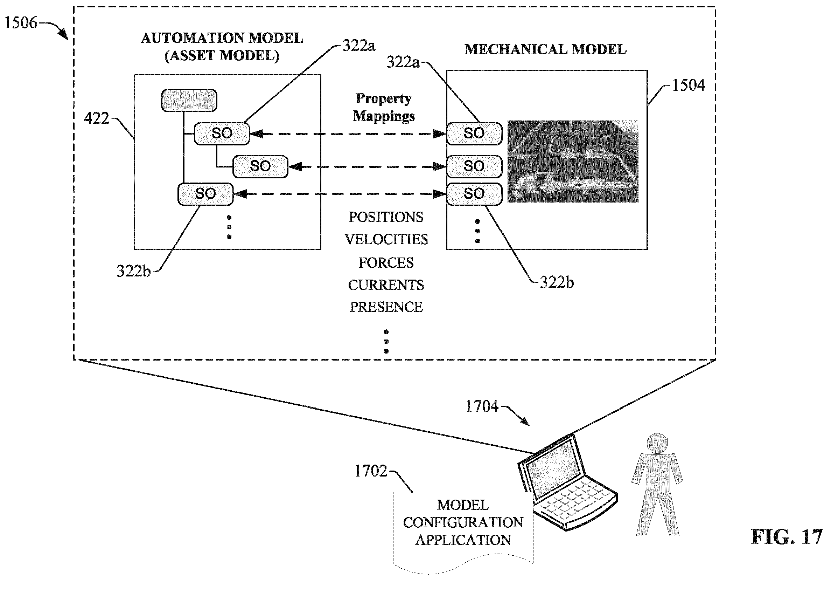

Object-based model development can mitigate these problems associated with interconnecting an automation model and a mechanical model. For example, some embodiments of model configuration component 408 can allow the asset model 422 and a mechanical model 1504 to be developed using a common development platform and a common object-based nomenclature. FIG. 17 is a diagram illustrating parallel development of an asset model 422 and a mechanical model 1504 for an industrial asset. In the illustrated example, a model configuration application 1702 executes on a client device 1704 (e.g., a laptop computer, a desktop computer, a tablet computer, etc.). In some implementations, gateway configuration application 1006 may serve as model configuration application 1702 (e.g., for embodiments in which gateway configuration application 1006 supports definition of mechanical models for an asset in addition to asset models 422). Model configuration application 1702 may also be an integrated tool of device configuration application 708 used to program and configure industrial device 302. In other implementations, model configuration application 1702 may be another type of industrial design application that supports parallel development of asset (automation) models 422 and mechanical models 2304 for an industrial asset or collection of industrial assets.

Similar to gateway configuration application 1006, model configuration application 1702 can render suitable model configuration interfaces on client device 1704. These model configuration interfaces can include interactive features that guide the user through the process of defining asset models 422 as well as mechanical models for a given industrial asset. Also similar to gateway configuration application 1006, the configuration interfaces generated by model configuration application 1702 can include interactive features that reference the smart objects 322 defined for one or more industrial devices 302 associated with the industrial asset being modeled. In embodiments in which model configuration application 1702 is an integrated tool of device configuration application 708, which is used to define the smart objects 322 for the industrial devices, the development interfaces can allow the user to browse or reference the smart object definitions that will be used to configure the tag database 702 of one or more industrial devices, and assign selected smart objects 322 from the smart object definitions for inclusion in one or both of the asset model 422 or the mechanical model 1504, similar to the asset model configuration workflow of the gateway configuration application 1006 described above.

In the case of the asset model 422, model configuration application 1702 allows a user to create nodes representing an industrial facility, production lines or areas within the industrial facility, industrial assets (e.g., industrial machine, industrial robots, etc.) within each production line, units of equipment associated with a given industrial asset (e.g., a loader, a pusher, a machining station, etc.), and/or industrial devices (e.g., controllers, drives, etc.) associated with the industrial asset being modeled. The user can then assign selected smart objects 322 (representing measured control values, events, states, odometer counts, etc.) to respective nodes of the asset model 422, as described above in connection with FIG. 10.

The mechanical model 1504 for the industrial asset (or group of assets) can also be developed using the same model configuration application 1702. Model configuration application 1702 allows the user map or link properties of the mechanical model 1504 (e.g., torques, accelerations, flow rates, currents, etc.) to corresponding properties of the asset model 422 via reference to the relevant smart objects 322. In this regard, the smart objects 322 represent a common nomenclature shared by the asset model 422 (serving as an automation model of the asset) and the mechanical model 1504 that allows properties of the industrial asset (measured and contextualized automation values) to be easily mapped or linked between the two models. For example, in order to map a torque value of the asset model 422 to a corresponding mechanical-domain property of the mechanical model 1504 (e.g., a representation of a mechanical component to which the torque is applied), both the asset model 422 and the mechanical model 1504 can be configured to reference the appropriate smart objects (e.g., smart object 322a in FIG. 17) corresponding to the torque value. In this way, properties can be easily mapped between the asset model 422 and the mechanical model 1504 by virtue of common references to the smart objects 322 representing the properties (see also smart object 322b in FIG. 17, which is referenced by both the asset model 422 and the mechanical model 1504, thereby creating a link between the model properties that reference this smart object 322b). This allows the asset (automation) model 422 and the mechanical model 1504 to understand each other based on common references to smart objects 322.

Parallel development of asset model 422 and mechanical model 1504 using model configuration application 1702 allows both models to share a common organization and defined property structure. The object-based type system shared by the asset model 422 and the mechanical model 1504 creates a mapping of properties between the two models, allowing the mechanical formulas or transformations defined by the mechanical model 1504 to be applied to measured contextualized automation data to yield additional real-time or historical behavior or response data for the industrial asset (including but not limited to forces, positions, orientations, shapes, or temperatures of mechanical components). The combined asset model 422 and mechanical model 1504 - with properties linked via common smart object references - can serve as a mechatronic model or digital twin 1506 of the industrial asset capable of generating more comprehensive information about the industrial asset than either of the two models can produce individually. In general, the digital twin 1506 comprises multiple disparate models of the industrial asset (the asset model 422 and the mechanical model 1504) that interact to simulate the behavior of the industrial asset.

This combined model, representing a virtualization of the industrial asset, can be used in a variety of applications. For example, the digital twin 1506 can be used to drive a virtual simulation of the asset in connection with testing of control software to be deployed in the industrial environment, to serve as a training tool that simulates the asset's response to human interactions, to predict future asset behavior or play back past asset behaviors based on an analysis of historical automation data, to perform live or historical operational analytics, or other such applications. Depending on the type of application performed by the digital twin 1506, the digital twin 1506 can be fed with live (real-time) data from the smart objects 322 during operation of the industrial asset or with historical time-series BIDT data generated and stored during prior operation of the asset.

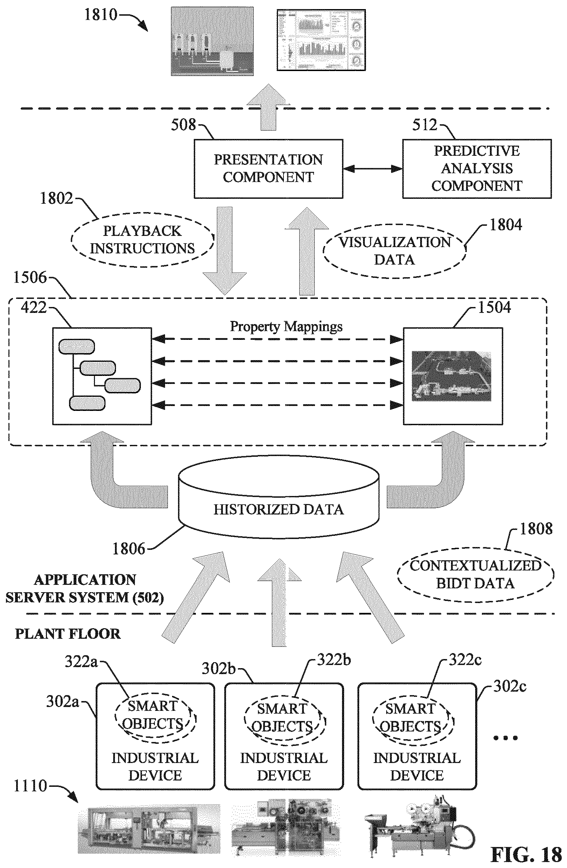

FIG. 18 is a diagram of an example architecture that uses the interlinked asset model 422 and mechanical model 1504 to generate playback simulations of past industrial asset operations. In this example, it is assumed that the behavior playback functionality is implemented on application server system 502, on which the asset model 422 and mechanical model 1504 for one or more industrial assets are stored. However, the playback functionality described below can be implemented on other types of host devices or platforms in some embodiments, including but not limited to gateway devices (e.g., gateway device 402), on-premise server devices, cloud-based systems, or other such platforms.

As described in previous examples, industrial devices 302 deployed at a plant facility are programmed to monitor and/or control one or more industrial assets 1110 (e.g., machines, production lines, work stations, robot-based systems, etc.). The device configurations of the respective industrial devices 302 include smart object definitions that define the smart objects 322 used to store and contextualize data measured or generated by the industrial devices 302.

During operation of the industrial assets, industrial devices 302 monitor and control their respective industrial assets 1110, and the smart objects 322 store data values, statuses, events or other properties that are measured and/or generated by the industrial devices 302. In this example, the contextualized BIDT data 1808 is read from the smart objects 322 and stored in historical data storage 1806 as time-series historized data. Any suitable architecture can be used to transfer the contextualized data 1808 to the historical data storage 1806. For example, as in the example architecture depicted in FIG. 11, an on-premise or cloud-based gateway device 402 (not shown in FIG. 18) can be networked to the respective industrial devices 302, and the BIDT publishing component 310 of each industrial device 302 can expose the data and metadata associated with each configured smart object 322 to the gateway device 402, rendering the BIDT data and metadata accessible and retrievable by the discovery component 406. The gateway device 402 can retrieve the contextualized data 1808 on a periodic or event-driven basis and log the contextualized data 1808 in historical data storage 1806. Historical data storage 1806 can comprise cloud-based data storage or may reside on the plant facility. Other architectures are also within the scope of one or more embodiments. Smart object data records logged to historical data storage 1806 are recorded with time-stamps so that data values from disparate devices and systems are synchronized for collective analysis and playback.

The historized data can be further contextualized by the linked asset model 422 and mechanical model 1504 (collectively acting as a digital twin 1506 of industrial assets 1110). As described above, each model 422 and 1504 is configured to reference selected items of historized BIDT data representing historical operation of the industrial assets 1110 (e.g., speeds, torques, positions, locations, pressures, flows, voltages, etc.). Similar to the system described above in connection with FIG. 11, the presentation component 508 of application server system 502 is configured to serve data display presentations 1810 to authorized client devices that interface with the system 502. These presentations 1810 are generated based on the historized BIDT data as contextualized by the digital twin 1506 and can conform to substantially any presentation format. For example, presentations 1810 may comprise an animated graphical representation of the industrial asset rendered on a client device, where animation of the industrial asset's rendered components are controlled by their corresponding time-series smart object values, states, events, etc. as read from historical data storage 1806. The presentations 1810 may also superimpose alphanumerical data displays on the industrial asset representation representing contextualized BIDT data values (e.g., temperatures, operating modes, etc.). In another example format, presentations 1810 may comprise a three-dimensional virtual reality (VR) presentation delivered to a suitable VR client device (e.g., a VR headset or other type of wearable computer) that renders a virtualized rendering of the industrial assets 1110 based on the digital twin 1506, where the VR rendering of the industrial asset is animated based on the time-series historized BIDT data.

Since contextualized BIDT data 1808 is time-stamped and synchronized when the data is stored in historical data storage 1806, time-series subsets of this historized data can be selected and rendered by the presentation component 508 as a sequential time-series animation of the virtualized industrial asset. In this way, presentation component 508 can leverage digital twin 1506 and the historized data to generate a virtualized "playback" of past operations of the industrial asset via presentations 1810. In an example implementation, presentation component 508 can render playback controls on the client device (e.g., a wearable computer or another type of client device) that allow the user to generate and send playback instructions 1802 to the system 502. Playback instructions 1802 can include, for example, a specification of a past time range to be reviewed, selection of an industrial asset to be reviewed, instructions to scroll the asset operation playback backward or forward in time, or other such instructions. In response to playback instructions 1802, presentation component 508 can retrieve, from historical data storage 1806, the subset of time-series historized BIDT data 1808 corresponding to the selected industrial asset and selected time range, and generate an animated virtual playback of the selected asset's operation based on the retrieved time-series data.

Presentation component 508 can generate the virtualized presentation 1810 of the industrial asset based in part on the organizations defined by the asset model 422 and mechanical model 1504 for the asset. In an example embodiment in which the presentation 1810 is a VR presentation, presentation component 508 may render, on the client device, a three-dimensional graphical representation of the industrial asset or production area based in part on the organization of production lines, machines, and/or devices defined by the asset model 422 and/or the mechanical model 1504. Presentation component 508 can then animate this representation based on a time-series streaming of the visualization data 1804 across the time range selected by the user, where the visualization data 1804 comprises the subset of historized BIDT data corresponding to the selected time range and contextualized by the asset model 422. This animation can include, for example, animation of the motion of an actuator, a robot, a conveyor, a motor-driven machine axis, or another movable component of the industrial asset based on a relevant subset of the historical BIDT data indicative of the component positions at respective time instances. The animation can also include other graphical objects that are animated by relevant subset of the BIDT data, such as temperature or pressure gauges, alphanumeric overlays representing performance metrics or alarms, or other such objects.

In general, the animation state of the virtualized presentation 1810 at a given time instant is a function of the set of historical visualization data 1804 corresponding to the same historical time instant or time-stamp. Streaming the visualization data 1804 in a time-wise or time-series manner across the selected historical time range of interest causes the virtualized presentation 1810 to recreate, as an animation, the operation of the selected industrial asset across the selected time range.

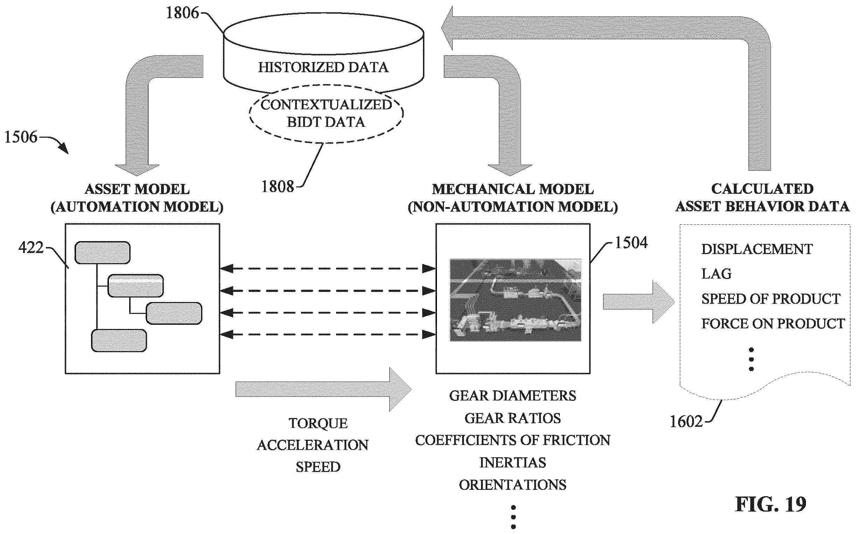

In addition, presentation component 508 can leverage the BIDT-based property mappings between the asset model 422 and mechanical model 1504 to generate additional time-series mechanical information for inclusion on presentation 2610. FIG. 19 is a diagram illustrating generation of supplemental calculated asset behavior data based on integration of an asset (automation) model 422 with a mechanical model 1504 for the industrial asset 1502. Similar to the example depicted in FIG. 16, integration of the asset model 422 with the mechanical model 1504 via common references to smart object data sources, as described above, allows application server system 502 (or another visualization or analytic system) to calculate additional asset behavior data 1602 based on measured automation values. In the example depicted in FIG. 19, the automation values (e.g., torques, accelerations, speeds, etc.) are obtained as contextualized BIDT data 1808 read from historical data storage 1806. The calculated asset behavior data 1602 can supplement the automation values already stored in historical data storage 1806 for use in reporting, analytic, or visualization applications. Asset behavior data 1602 can be generated as time-series values having the same time base as the contextualized BIDT data 1808 that was used to calculate the behavior data 1602.

In some embodiments, after calculated behavior data 1602 has been generated, system 502 (or another system that leverages models 422 and 1504) can time-stamp and log the calculated data 1602 in historical data storage 1806. Each time-stamp identifies the historical time instant that gave rise to the corresponding item of calculated data 1602, and corresponds to the time instant of the contextualized smart object data values that were used to calculate the data 1602. Time-stamping the calculated data 1602 in this manner allows system 502 (or another system) to record the calculated data 1602 in historical data storage 1806 against the same points in time as the smart object data values that gave rise to the calculated data 1602, thereby supplementing the measured automation values with calculated dynamic asset behavior, properties, and mechanical states.

In addition to streaming a time-series visualization of past behavior and operation of an industrial asset, some embodiments can also extend the visualization to predicted future behavior of the asset based on predictive analysis performed on the historical data and the digital twin 1506. Returning to FIG. 18, some such embodiments can include a predictive analysis component 512 configured to generate predicted future values of the measured BIDT data 1808 and calculated behavior data 1602 based on analysis of the historical BIDT data 1808. Predictive analysis component 512 can predict this future asset behavior based on learned trends of asset behavior as a function of various asset conditions or states identified based on mining of the historical BIDT data 1808 and application of digital twin 1506. For such embodiments, playback instructions 1802 can include instructions to advance the visualization to future time ranges. In response to such instructions, presentation component 508 can leverage predicted behavior information generated by predictive analysis component 512 to render an animated visualization of this predicted future asset performance.

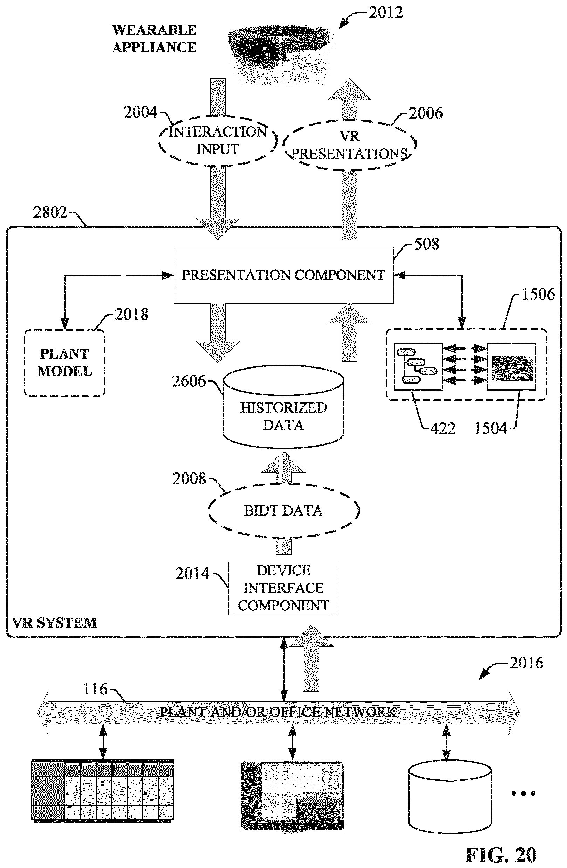

As noted above, some example systems can generate virtual reality (VR) presentations based on historical BIDT data and supplemental data contextualized and/or calculated based on the digital twin 1506. FIG. 20 is a block diagram illustrating an example VR system 2002 that leverages digital twin 1506 to generate VR presentations that play back past asset behaviors. In some embodiments, VR system 2002 can be integrated with application server system 502 and can reside on a cloud platform or other private or public network having communicative access to plant network 116. Alternatively, VR system 2002 can reside on a gateway device (e.g., gateway device 402) or on a local server communicatively connected to plant network 116 and residing within the plant facility.

VR system 2002 can comprise a device interface component 2014 that collects BIDT data 2008 from industrial devices and systems 2016 distributed across an industrial environment. In some embodiments, device interface component 2014 can be configured to retrieve selected data items from the industrial devices and systems 2016 via network 116 in accordance with asset model 422, which specifies the BIDT tags from which data is to be collected. Device interface component 2014 time-stamps and stores this collected BIDT data 2008 on historical data storage 1806 together with time-stamps, and presentation comment 508 uses this historical time-series data, as well as supplemental mechanical information for the assets calculated using digital twin 1506, to populate and animate VR presentations 2006 of one or more industrial assets using this contextualized historical data. Presentation component 508 delivers these VR presentations to a suitable wearable appliance 2012 for rendering.

Wearable appliance 2012 can interface with VR system 2002 via a wired or wireless network interface, a near-field communication interface, or other such device interface suitable for the particular platform on which the VR system 2002 is implemented. In some embodiments, presentation component 508 may be configured to verify an authorization of the wearable appliance 2012 to access the VR system 2002 prior to allowing VR presentation data 2006 to be delivered to the wearable appliance 2012. Presentation component 508 may authenticate the wearable appliance 2012 or its owner using password verification, biometric identification (e.g., retinal scan information collected from the user by the wearable appliance 2012 and submitted to the presentation component 508), cross-referencing an identifier of the wearable appliance 2012 with a set of known authorized devices, or other such verification techniques.

VR presentation data 2006, when received and executed by wearable appliance 206, renders an interactive three-dimensional VR presentation of the one or more represented industrial assets on the wearable appliance's display. Presentation component 508 can design the visual layout of the VR presentation based on the asset organization defined by digital twin 1506. For example, based in part on the identified production lines, machines, devices, and other entities defined by the digital twin 1506 as well as the relationships between these entities also defined by the digital twin 1506, presentation component 508 can render three-dimensional graphical VR representations of these entities, and animate the presentation using selected subsets of historical BIDT data as well as supplemental data (e.g., calculated data 1602) generated by applying the mechanical model 1504 to the BIDT data. In some embodiments, VR system 2005 can also maintain one or more plant models 2018 that define a visual representation of the physical layout of the area represented by a VR presentation. For example, a plant model 2018 for a given industrial area (e.g., a production area, a workcell, an assembly line, etc.) can define graphical representations of the industrial assets - including machines, conveyors, control cabinets, and/or industrial devices - located within that area, as well as the physical relationships between these industrial assets. For each industrial asset, the plant model 2018 can define physical dimensions and colors for the asset, as well as any animation supported by the graphical representation (e.g., color change animations, position animations that reflect movement of the asset, etc.). The plant models 2018 also define additional physical relationships between the industrial assets that may not be defined by the asset model 422, including relative positions and orientations of the assets on the plant floor, conduit or plumbing that runs between the assets, and other physical definitions.

A rendering engine supported by presentation component 508 is configured to generate an interactive VR presentation of the industrial area based on the industrial asset rendering definitions specified in the digital twin 1506 (as well as the one or more plant models 2018 for embodiments that use such models). Presentation component 508 populates this VR presentation with selected subsets of historical BIDT data 2008 (as well as additional dynamic statistics - e.g., calculated data 1602 - calculated by presentation component 508 by applying the mechanical model 2304 to the BIDT data 2008) and delivers the resulting aggregate VR presentation to wearable appliance 2012 as VR presentation data 2006. Presentation component 508 can generate the VR presentation such that alphanumeric items of the BIDT data (e.g., speeds, pressures, flows, voltages, etc.) are overlaid on or near graphical representations of the industrial assets to which the items of data relate.

Presentation component 508 can also control the view presented by the VR presentation based on interaction input 2004 received from the wearable appliance 2012. Interaction input 2004 can specify a current viewing direction of the wearer of wearable appliance 2012, which is used by the presentation component 508 to control the viewing perspective of the VR presentation. In the case of historical playback of asset behavior, interaction input 2004 can also include playback instructions (similar to playback instructions 1802) that control a time range for the playback as well as forward and backward scrolling through the playback.

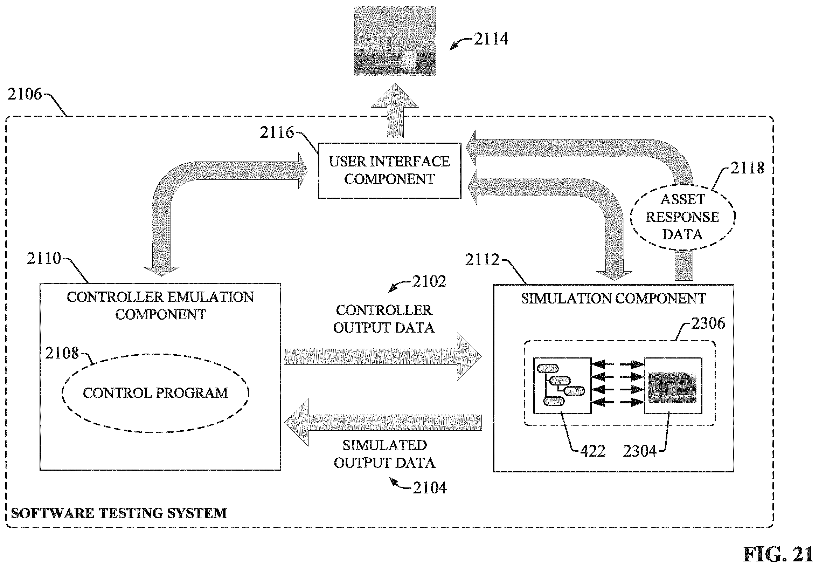

Since digital twin 1506 models both automation and mechanical characteristics of an industrial asset, the digital twin 1506 can be used to simulate expected behaviors of the industrial asset (e.g., responses to control inputs in terms of movement, speed, temperatures, flows, fill levels, fluid mechanics, product displacements, etc.) in connection with testing control programs or device configurations. FIG. 21 is a generalized block diagram of a software testing system 2106 that uses digital twin 1506 to verify a control program 2108. In this example, a controller emulation component 2110 of the software testing system 2106 acts as an industrial controller emulator to execute control program 2108 against digital twin 1506.

A simulation component 2112 can leverage the automation and mechanical characteristics modeled by the digital twin 1506 to simulate various aspects of a physical industrial system to be monitored and regulated by the control program 2108. Simulation component 2112 can virtually interface control program 2108 with the digital twin 1506 to facilitate exchange of simulated I/O data between the program 2108 and digital twin 1506, thereby simulating real-world control. Control program 2108 can comprise any conceivable type of code used to process input signals read into a controller and to control output signals from the controller, including but not limited to ladder logic, sequential function charts, function block diagrams, or structured text. Control program 2108 is designed to regulate an automation system being modeled by digital twin 1506. Simulation component 2112 generates digital and analog I/O values representing, for example, sensor outputs, metering outputs, or other plant data analogous to the data expected to be generated by the physical system based on the static and dynamic characteristics of the physical system modeled by the digital twin 1506. This simulated output data 2104 is provided to the emulation component 2110 executing control program 2108, which receives this data 2104 as one or more virtual physical inputs. Control program 2108 processes these inputs according to user-defined algorithms and generates digital and/or analog controller output data 2102 based on the processing. This output data 2102 represents the physical outputs that would be generated by a controller executing control program 2108 and transmitted to the hardwired field devices comprising the automation system (e.g., PID loop control outputs, solenoid energizing outputs, motor control outputs, actuator control outputs, robot control outputs, etc.). The controller output data 2102 is provided to the appropriate input points of the digital twin 1506, which updates the simulated output data 2104 accordingly.

In addition to generating simulated output data 2104, simulation component 2112 can also generate asset response data 2118 based on analysis of the simulated data exchange and expected behaviors of the modeled industrial assets in response to the simulated controller output data 2102. For example, based on the automation and mechanical characteristics of the industrial assets modeled in the digital twin 1506, simulation component 2112 can predict expected behaviors of the modeled industrial assets, as well as behaviors of products being manufactured by the assets, in response to the controller output data 2102, and convey this predicted behavior as asset response data 2118. Example behaviors represented by asset response data 2118 can include, but are not limited to, movement of product through the industrial assets (including speeds, accelerations, locations, lags, etc.), flow rates of fluids through the assets, expected energy consumption by the assets, an expected rate of degradation of mechanical components of the assets (based in part on coefficient of friction information defined in the mechanical model 1504), expected forces applied to respective components of the assets during operation, or other such behaviors.

User interface 2116 can generate a visualization 2114 that renders results of the simulation on a client device. Visualization 2114 can render asset response data 2118 and other statistics relating to the simulation session in any suitable format. For example, visualization 2114 may comprise an animated representation of the industrial system being simulated, similar to presentations 1810 described above. Some sets of asset behavior and simulation data can also be rendered as alphanumeric overlays on visualization 2114.

This simulation technique can be used to test and debug control programs without putting field equipment and machinery at risk, to simulate modifications to plant or machine operations and estimate how such modifications affect certain key performance indicators or financial metrics, or to perform other types of analytics.

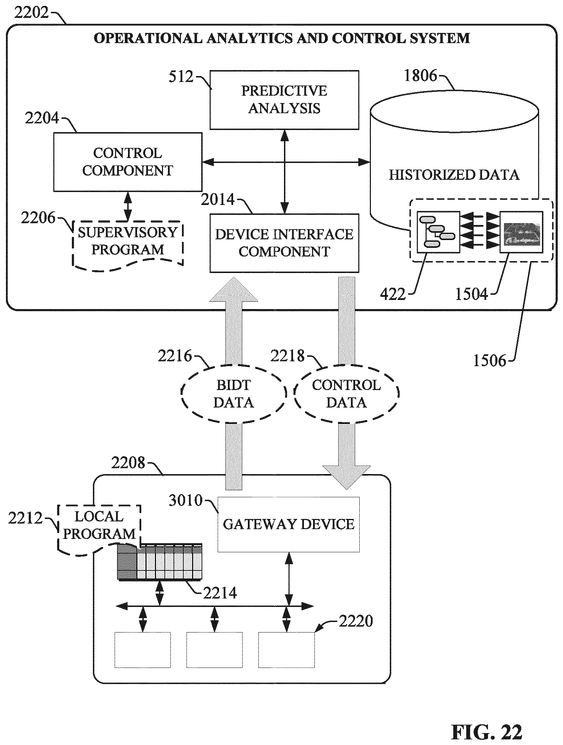

According to another type of application, digital twin 1506 can be analyzed in parallel with its corresponding real-world industrial asset and the results of this analysis can be used to perform supplemental supervisory control of the asset or for reporting purposes. FIG. 22 is a diagram illustrating the use of digital twin 1506 in connection with performing collective supervisory control of an industrial asset. In this example, automation system 2208 comprises an industrial controller 2214 that exchanges monitoring and control signaling with a number of industrial I/O devices 2220 to facilitate local control of an industrial machine or process in accordance with a local control program 2212 (e.g., a ladder logic program, a sequential function chart, etc.) executed by the controller 2214.

In this example, an operational analytics and control system 2202 executes on a cloud platform and interfaces with the automation system 2208 via a gateway device 2210 that shares a network with the industrial controller 2214. As an alternative to cloud-based analytics and control, some embodiments of system 2202 can reside on server device residing within the plant facility. During operation, a device interface component 2014 of the operational analytics and control system collects values of respective smart objects 322 configured on the industrial controller and/or other industrial devices of the automation system 2208. To facilitate substantially real-time analysis and supplemental control, the device interface component 2014 collects these BIDT data values substantially continuously or at a high update frequency.

Similar to previous examples, the collected BIDT data 2216 is stored in historical data storage 1806 and can be contextualized, enhanced (e.g., by generating calculated data 1602), and analyzed using digital twin 1506. In this example, a predictive analysis component 512 is configured to perform predictive analysis on the historical BIDT data 2216 and historical supplemental data (e.g., calculated data 1602) in order to identify potential future operational issues that may warrant modifications to current control. In an example implementation, a control component 2204 of the operational analytics and control system 2202 may execute a supervisory program 2206 that generates supplemental control data 2218 directed to the controller 2214 based on results of the predictive analysis. In general, supervisory program 2206 may be designed to alter control of the automation system 2208 to mitigate predicted future performance problems identified based on the predictive analysis of the BIDT data 2216 in view of digital twin 1506. Example predicted performance issues that can be identified by predictive analysis component 512 can include, but are not limited to, deviation of a key performance parameter of the automation system 2208 from defined acceptable ranges, a failure to satisfy a defined production goal within a required timeframe, excessive energy consumption by the automation system 2208, or other such issues.

Control component 2204 can be linked to predictive analysis component 512 such that supervisory program 2206 is notified when a performance issue is predicted, and supervisory program 2206 can be configured to, in response to a predicted performance issue, generate control data 2218 designed to alter control of the automation system 2208 in a manner that mitigates the predicted performance issue. Control data 2218 can include, for example, instructions to modify one or more control setpoints defined in the local industrial controller 2214, instructions to the local industrial controller 2214 to begin executing an alternate control routine, instructions to alter an operating mode of the automation system 2208, or other such instructions. In the illustrated example architecture, device interface component 2014 sends control data 2218 to the industrial controller 2214 via gateway device 2210.

In addition to or as an alternative to performing supervisory control of automation system 2208 based on predicted operational issues, some embodiments of operational analytics and control system 2202 can also be configured to generate report or notification data in response to prediction of a performance issue relating to automation system 2208. For example, based on predictive analysis of the historical BIDT data 2216 as contextualized by digital twin 1506, predictive analysis component 512 can identify an impending failure of a component of automation system 2208 (e.g., a bearing, a pump, a motor, etc.), an impending exhaustion of a material supplied to the automation system 2208, or other such concerns. In response to identifying such issues, device interface component 2014 can generate and send a notification of the issue to one or more client devices associated with relevant plant personnel.

The device interface component 2014 can determine which plant-side smart objects 322 or data tags to collect for storage and processing based on the asset model 422 of digital twin 1506. For example, the device interface component 2014 can determine which of the plant-side smart objects 322 are referenced by the asset model 422, and collect data associated with those referenced smart objects 322 from the appropriate local devices that make up automation system 2208. For the control data 2218, the device interface component 2014 can determine which data tag corresponds to each of the digital and analog output values defined by supervisory program 2206, and send the values of those output to their appropriate data tags or registers in the plant-side industrial devices (e.g., controller 2214). Depending on the configuration, the device interface component 2014 can send these values either directly to the respective plant floor devices, or via gateway device 2210.

This configuration yields a two-layer control architecture, whereby immediate control functions of the automation system 2208 is controlled locally by control program 2212 executing on local industrial controllers 2214, while higher-level control of the automation system 2208 is performed by the operational analytics and control system 2202 based on supervisory program 2206 and the predictive analysis performed on the historical BIDT data 2216 contextualized by digital twin 1506. Users can design supervisory program 2206 to manage substantially any high-level goal of the industrial enterprise. For example, the cloud-based supervisory program 2206 may be configured to regulate a production rate of automation system 2208 based on a measured rate of part production at an upstream system that supplies parts or material to automation system 2208, or a measured demand at a downstream system or facility. Such changes in production rate may be carried out, for example, by writing a new setpoint value to a data tag in controller 2214 that sets a speed of the automation system 2208.

In another example of cloud-based supervisory control, controller 2214 or another device on the plant floor may carry out an autonomous control of automation system 2208, such as proportional-integral-derivative (PID) loop control of a motion system. As this local control is executed, device interface component 2014 can read time-stamped status and operational values relating to control of the local automation system 2208 (e.g., loop tuning parameter values, current speed and position of the motion system, current or predicted control output signals generated by the local controller, etc.), where these status and operational values are collected based on the referencing of these data items by asset model 422. Based on these values and supplemental data (e.g., calculated asset behavior data 1602) generated based on application of the digital twin 1506 to the historical BIDT data 2216, predictive analysis component 512 can predict a future status (e.g., position, velocity, etc.) or trajectory of the motion system, and generate new control setpoint values or other control parameters for the local controller based on these predicted statuses in anticipation of where the motion system will be at a future time. The cloud-based system can then send these new setpoint or control values to the local controller 2214.

The foregoing disclosure described the structure of example smart objects 322 and the use of these smart objects 322 as the foundation for creating digital twins 1506 for industrial systems. Example applications of these digital twins 1506 - including visualization, analytics, data enhancement, simulation, and control applications - were also described. The contextualized data infrastructure of the smart objects 322 can also allow digital twins 1506 to be readily integrated with artificial intelligence (AI) tools and systems. For example, AI-based development or analysis of digital twin 1506 can be aided and simplified by the metadata and contextual relationships defined by the smart objects 322 that make up the digital twin 1506, as well as the relationships between devices and components defined by the asset model 422 (a component of the digital twin 1506). AI-based development and analysis is also aided by supplemental data generated by the digital twin 1506 that is not available directly from the plant data, such as the calculated asset behavior data 1602 discussed above in connection with FIGs. 16 and 19. This supplemental data can fill in gaps in the data available directly from the plant floor devices, machines, and processes, yielding a more comprehensive AI-analysis solution.

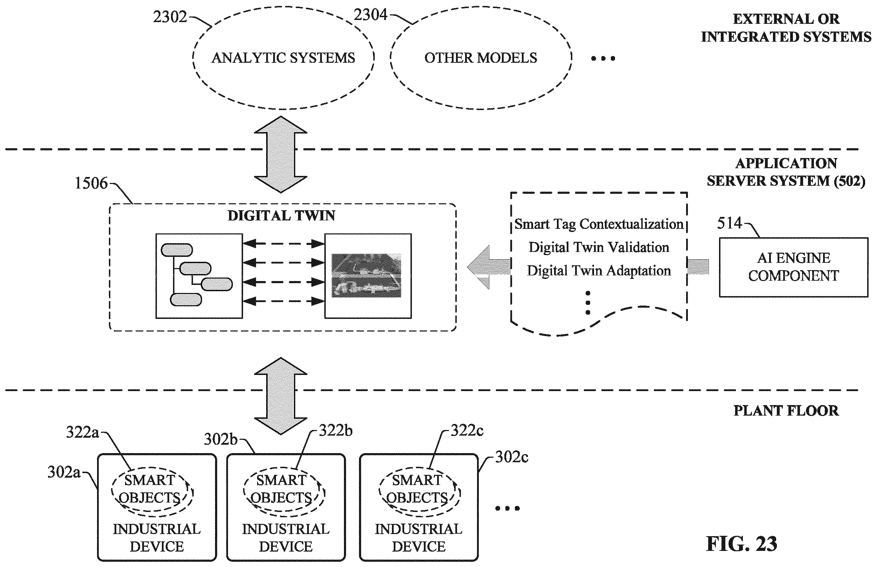

In some embodiments, AI analysis can also be used to validate the fidelity of the digital twin 1506 itself relative to the industrial asset being modeled, or to enhance the quality of the digital twin 1506 to yield a more accurate model of the industrial asset. FIG. 23 is a diagram illustrating an example architecture that includes an AI engine component 514 capable of applying AI analysis to the digital twin 1506 for contextualization, validation, and adaptation purposes. In the example depicted in FIG. 23 (and FIG. 5), AI engine component 514 is an integrated component of application server system 502. However, in some embodiments AI engine component 514 can be a component of a separate system or tool capable of accessing digital twin 1506 in order to contextualize, validate, and/or adapt the digital twin 2306.

In general, AI-based validation of a digital twin 1506 - that is, confirmation that the digital twin 1506 accurately models a given industrial asset or process - can be simplified and substantially automated if important relationships between variables (e.g., asset characteristics and responses, process measurements, etc.) can be encoded as properties of the smart objects 322 themselves. This not only applies useful constraints on AI analysis of the digital twin 1506 - reducing analytical overhead and guiding AI searches to useful discoveries more quickly - but also allows these relationships to travel with the digital twin 1506 for use with other installations of the industrial asset being modeled.

To this end, AI engine component 514 can be configured to discover key variables defined in the digital twin 1506, and the relationships of these key variables to other variables defined in the digital twin 1506. Once discovered, AI engine component 514 can encode these relationships in the relevant smart objects 322 themselves as additional properties or fields appended to the smart objects 322.

With these validation properties encoded in the digital twin's smart objects 322, AI engine component 514 can apply AI analytics to the digital twin 1506 together with live or historical process data from the modeled industrial asset in order to verify the fidelity of the digital twin relative to the industrial asset. This AI-driven validation is assisted by the relationships built into the smart objects 322 themselves, as well as higher-level relationships defined in the digital twin 1506 (e.g., the hierarchical relationships defined by the asset model 422, the relationships between the asset model 422 and the mechanical model 1504, etc.).

In some scenarios, the digital twin 1506 may be designed to model a particular industrial asset or automation system that is being substantially replicated at another plant location. In such scenarios, AI engine component 514 can validate a duplicate instance of the digital twin 1506 against the new installation of the asset. If AI engine component 514 identifies elements of the digital twin 1506 that do not accurately model corresponding physical or behavioral characteristics of the newly installed industrial asset, the AI engine component 514 can also perform a digital twin adaptation process that modifies the new instance of the digital twin 1506 as needed to bring the digital twin 1506 in line with the physical industrial system.

Modifying the smart objects 322 that make up digital twin 1506 to include AI-ready contextualization metadata can allow other analytic systems - e.g., other AI systems or other types of analytic systems 2302, predictive analysis component 512, other digital models 2304, etc. - to easily interface with digital twin 1506 and can assist these other analytic systems to more quickly and efficiently converge on desired analytic results. The additional contextualization encoded in the smart tags themselves can be leveraged by these other analytic systems to reduce the search space to be examined in connection with predicting future outcomes or generating insights into past and current asset performance.

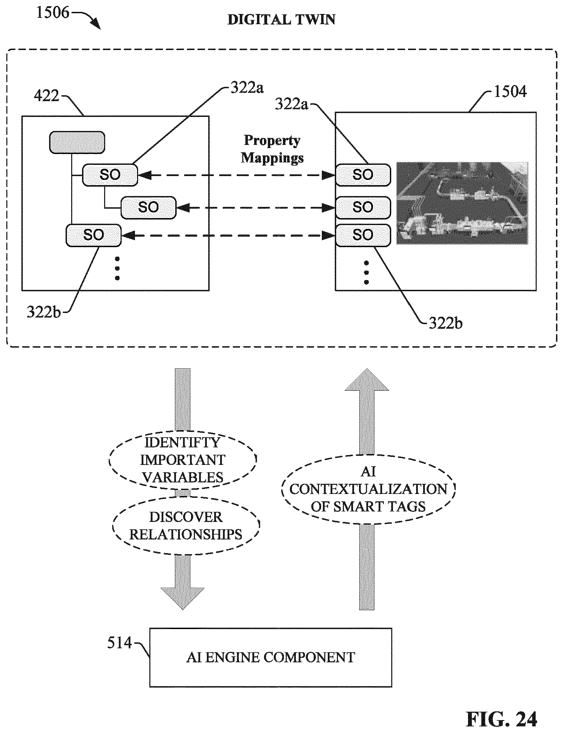

FIG. 24 is a diagram illustrating contextualization of a digital twin's smart objects 322 by AI engine component 514. In this example, the digital twin 1506 has a format similar to that described in examples discussed above, comprising an asset model 422 representing an industrial asset or collection of industrial assets in terms of hierarchical elements of an industrial facility or collection of facilities. Asset model 422 also associates selected smart objects 322 with respective elements of the hierarchical model. Digital twin 1506 also comprises a mechanical model 1504 (or another type of non-automation model) that is linked to the asset model 422 by virtue of common smart object references.

According to the invention, to facilitate validation of the digital twin 1506, and to simplify subsequent AI analysis using the digital twin 1506, AI engine component 514 modifies some or all of the smart objects 322 that make up the digital twin 1506 to add AI contextualization metadata in the form of additional fields or properties. These additional fields or properties encode learned relationships between modeled variables (e.g., process measurements, device outputs or statuses, etc.) that are not already defined in the digital twin 1506, as well as parameters defining the type of analytic problem to be solved by analytic engines that leverage the digital twin 1506.

To this end, AI engine component 514 can apply correlation and/or causation analysis on the digital twin 1506 to identify one or more smart objects 322 representing important or key variables of the industrial asset or process being modeled by the digital twin 1506. The key variables may represent key performance indicators (KPIs) of the modeled asset or process, or other aspects of the modeled system of key importance. In general, key variables represent an overall performance quality of the industrial asset.

In some scenarios, AI engine component 514 can identify a key variable based in part on industry knowledge of the type of industrial asset or process being modeled by the digital twin 1506. For example, it may be known that product throughput is a primary concern of a certain type of industrial production line. Accordingly, if the AI engine component 514 ascertains or infers that the digital twin 1506 models an industrial system that corresponds to this category of production line, the smart object 322 representing product throughput can be selected as the key variable. In some embodiments that use this approach for identifying key variables, AI engine component 514 can reference an industry knowledgebase that defines key variables for respective different types of industrial systems (e.g., machines, production lines, processes, verticals, etc.), and identify key variables by correlating the type of industrial system being modeled with the industry knowledgebase. In other scenarios, one or more of the key variables may be explicitly identified or defined by a user. In general, there may be more than one key variable or KPI for a given digital twin 1506. Other types of key variables can include, but are not limited to, energy consumption, energy efficiency, cycle time, asset availability, capacity utilization, or other such variables modeled by smart objects 322 that make up the digital twin 1506.

If industry domain knowledge for the modeled industrial system is not available, AI engine component 514 can apply data science approaches to the digital twin 1506 in order to identify which variables are most indicative of the overall performance quality of the industrial asset or process being modeled. For example, the AI engine component 514 can define and solve an optimization problem for identifying key or important variables modeled by the digital twin 1506 (that is, those variables most indicative of the modeled asset's overall performance or quality of operation). In this regard, the pre-defined smart object data structures together with the hierarchical relationships defined by the digital twin 1506 (e.g., the structures and relationships defined by the asset model 422 and the mechanical model 1504) can simplify this key variable identification analysis by reducing the search space for the optimization problem. For example, if the asset model 422 of the digital twin 1506 defines a set of production lines having both shared resources (e.g., a common master power supply, a common source of incoming material or parts, etc.) and segregated characteristics (e.g., distinct sets of equipment, isolated power supplies, independent operating characteristics, etc.), the AI engine component 514 can use these asset model definitions as useful constraints on the search for relationships between variables modeled by the digital twin 1506. That is, the AI engine component 514 can limit the correlation (and/or causality) search space to those sets of variables that could have potential relationships therebetween per the asset model definitions, and omit searches for correlations between variables on different production lines that are known to be independent or unrelated based on the asset model definitions. In one or more embodiments, the BIDT data structure can be used to assign the value of an integer variable that augments the BIDT data structure and indicates whether causal relationship between two variables is possible. Since causality determination is computationally expensive, the definition of integer variables that limit the search space is a key enabling step in almost all real world problems of reasonable size.

Once one or more key variables modeled by the digital twin 1506 have been identified, AI engine component 514 can perform further analysis on the model to identify relationships between the key variables and other variables present in the digital twin 1506. That is, AI engine component 514 can determine, for each key variable, which other variables modeled by the digital twin 1506 can be used to predict the value of the key variable. In cases in which the digital twin is a complete and accurate representation of a physical process, the model built by the AI engine for a key variable may not offer new insight that did not exist already. In a real-world scenario, however, such complete and fully accurate models do not exist and therefore the models built by the AI engine provide significant value in monitoring and validation of the digital twin. This can include, for example, performing correlation or causation analysis on the digital twin 1506 to identify variables that have a most significant impact on other variables. In an example scenario, digital twin 1506 may model a water pumping system comprising a set of electric water pumps that generate water flow for other processes. Based on correlation or causation analysis performed on the digital twin 1506, AI engine component 514 may identify and quantify correlations between water flow generated by each pump and power consumption by the pump. In one such scenario, a variable representing flow may be identified as a key variable for each pump, and variables identified as contributing to the value of the flow may include the amount of power consumed by the pump (in kilowatts) and the amount of water pressure. Encoding these relationships in the smart objects 322 of digital twin 1506 can improve plant analytics or simulations subsequently performed on the digital twin 1506 by other analytic systems (e.g., optimizers that analyze the digital twin 1506 to identify a subset of pumps capable of satisfying a total flow demand while consuming minimum power).

As with the analysis performed to identify the key variables, this correlation or causation analysis can be directed in part by the relationship topology defined by the digital twin 1506 (e.g., by the asset model 422 and the mechanical model 1504) and by the data structure of the smart objects 322 themselves. That is, the relationships between devices, measurements, equipment, and equipment properties already defined by the digital twin 1506 can place constraints on the AI engine component's search for relationships between the key variable and other variables, reducing the overhead and time required to identify these key relationships.

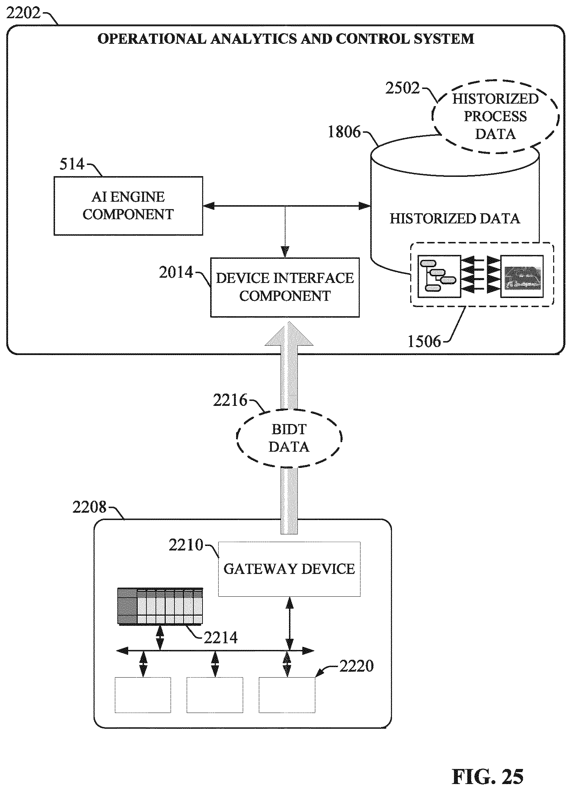

In some cases, AI engine component 514 may discover relationships between identified key variables and other modeled variables based on both the data topology of the digital twin 1506 itself as well as actual process data collected from the modeled industrial assets; e.g., using an architecture similar to that illustrated in FIG. 22. FIG. 25 is a diagram illustrating an example architecture in which AI engine component 514 contextualizes the smart tags of digital twin 1506 based on analysis of both the data topology of the digital twin 1506 and real-time or historical process data - in the form of BIDT data 2216 - collected from devices of the automation system 2208 being modeled (e.g., process data retrieved from smart objects 322 defined on devices of the automation system 2208). As described above in connection with FIG. 22, BIDT data 2216 (live process data) can be obtained from devices of automation system 2208 by device interface component 2014 and stored in historical data storage 1806 as time-series historized process data 2502. This historized process data 2502 represents time-series values of respective smart objects 322 defined by the digital twin 1506 (e.g., flow measurements, speed measurements, power statistics, etc.). As such, new relationships between key variables and other variables of the digital twin 1506 can be discovered by the AI engine component 514 based on analysis of this historized process data 2502 and the relationships between these data values already defined by digital twin 1506.

AI engine component 514 can also identify relationships between key variables and calculated values that are not available from the plant devices themselves, such as calculated asset behavior data 1602 discussed above in connection with FIGs. 16 and 19.

In general, the search topology extracted from the structure of smart objects 322 and the asset and mechanical model definitions of the digital twin 1506 can significantly constrain the parameters of optimization problems solved by the AI engine component 514, significantly reducing the time and expertise required to analyze the digital twin 1506 to identify key variables and their correlations to other variables. This mitigates the need to involve data science experts in the process of analyzing and validating digital models of industrial assets.

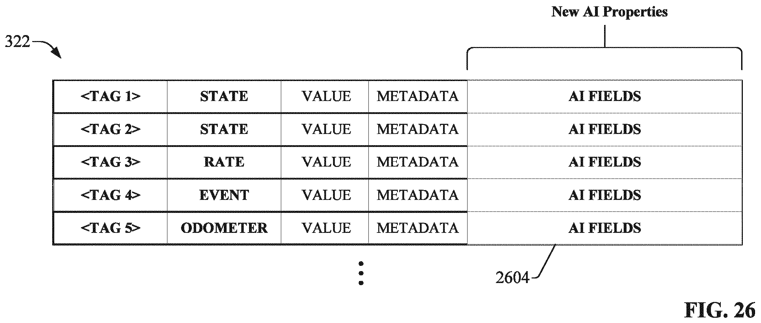

Once the key variables (represented by corresponding key smart objects 322 or their associated properties) and their relationships to other modeled variables have been identified, AI engine component 514 can augment the relevant smart objects 322 by adding AI contextualization metadata. This can involve adding new AI fields to the smart object 322 representing the key variable as well as to the related smart objects 322 determined to have an impact on the key variable. FIG. 26 is an example data schema illustrating smart objects 322 that have been augmented by the AI engine component 514 to include AI fields 2604 defining various AI properties. The smart objects 322 illustrated in FIG. 26 have a similar format to those of previous examples, but are modified by the addition of AI fields 2604. Values of the new AI fields 2604 can encode discovered relationships between the key variable and its correlated variables (those variables that directly affect the value of the key variable), as well as other information that can assist with model validation and adaptation.

For example, a new AI field 2604 can be added to the key variable smart object 322 that identifies the smart object 322 as representing a key variable. Additional AI fields 2604 can identify the other smart objects 322 that affect the value of the key variable. If AI engine component 514 is able to learn a mathematical model of the key variable as a function of the other relevant variables (e.g., based on both the data topology of the digital twin 1506 and available historized process data 2502), this model can also be included in one or more of the AI fields 2604 (e.g., as a mathematical function defining the relationship between flow output of a pump, power consumed by the pump, and water pressure). In some scenarios, such mathematical relationships or models may be discovered by the AI engine component 514 based on analysis of the digital model 2306 as well as actual process data collected from the industrial assets being modeled.

In some embodiments, AI fields 2604 can also define the type or class of analytic problem to be solved relative to the key variable (e.g., modeling, clustering, optimization, minimization, etc.). The type of analytic problem can be determined by the AI engine component 514 based on a number of factors, including but not limited to the type of industrial asset or process modeled by the digital twin 1506 and the identity of the key variable. Encapsulating these problem statements in the structure of the smart objects 322 themselves can enable programmatic access to the nature of data analysis to be carried out by analytic engines (e.g., AI engines) on the digital twin 1506. Since this analytic problem statement is embedded within the data structure of the digital twin 1506 itself, real-time analytics systems that interface with the digital twin 1506 can identify the prescribed type of analytics defined by the AI fields 2604 and carry out the defined analysis with minimal user intervention even if the digital twin 1506 is transferred to a different platform (e.g., an edge device, a cloud platform, a server, an embedded platform, etc.). In this way, the smart objects 322 can serve as a standardized interface to the digital twin 1506 through which other analytics systems can learn a desired or beneficial type of analytic to be performed on the digital twin 1506 (e.g., minimization of energy consumption, maximization of product throughput, maximization of efficiency, selection of a subset of available industrial assets to be deployed in order to achieve a desired result given defined constraints, etc.).

This analytic problem property of the smart objects 322 can also be programmatically modified in real time if the user's analytics goals change. For example, a digital twin 1506 may initially be used to solve the problem of minimizing fuel usage by its modeled industrial asset (e.g., within the context of a supervisory control system as illustrated in FIG. 22). If it is decided to prioritize minimization of emissions rather than fuel usage, the AI field 2604 defining the problem statement can be modified programmatically to reflect this new analytic problem, thereby conveying the new operational goal to the analytic system.

Enhancing the smart objects 322 to append AI fields 2604 that record relationships between variables of the modeled industrial system makes these relationships visible properties of the smart objects 322, which can be accessed and leveraged by analytic and simulation systems that interface with the digital twin 1506 (e.g., analytic systems 2302), as well as by other digital models 2304 (see FIG. 23). In some embodiments, smart objects 322 can also be viewed on a client device via a model interface generated by presentation component 508. In an example format, smart objects 322 can be rendered as tag arrays such that selecting a particular smart object 322 representing a measured or calculated process variable (e.g., line efficiency, water pump flow, etc.) causes a list of other variables that affect the selected variable to be displayed (e.g., power consumption, pressure, etc.).

The inclusion of model details that describe the dependency of a key variable on other variables in the smart object 322 can allow various types of validation analysis to be more easily applied to the digital twin 1506. For example, the AI engine component 514 can systematically use real-time operation data to determine the sensitivity of the key variable prediction to each of the variables that affect the key variables. A reliable prediction model can be used for validation of a digital twin 1506 if the relationships between variables that are used as a measure of the digital twin's validity are not sensitive to poor data quality. Evaluating the sensitivity on the model on an ongoing basis (and triggering actions to modify the digital twin 1506 if needed) can be automated if the model information is transparent and programmatically accessible via the smart objects 322.

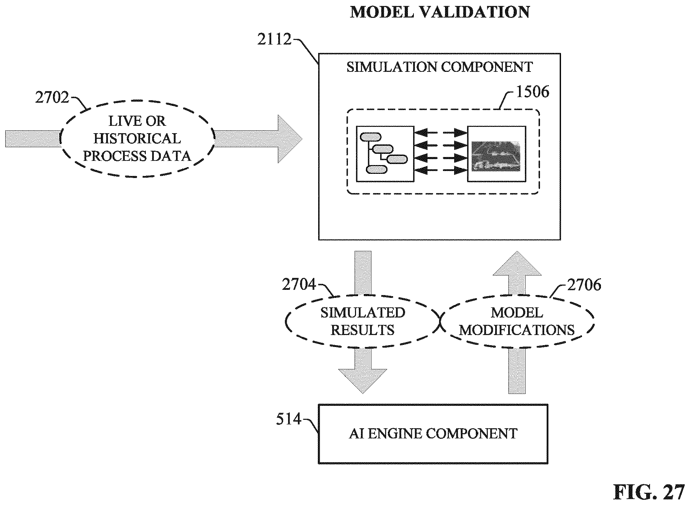

In addition to yielding a more AI-ready model of the industrial assets, enhancing the smart objects 322 of the digital twin 1506 in this manner provides a more robust foundation for validating the fidelity of the digital twin 1506 when used in different operating scenarios or when transferred to other plant locations. FIG. 27 is a diagram illustrating the use of AI-based simulation to validate the digital twin 1506 against a physical industrial asset or system being modeled. Validation of digital models, in terms of their accuracy and fidelity to their modeled assets, can pose a challenge to designers of industrial systems due to model complexity, which often necessitates involvement of data science experts to develop, validate, and deploy such models. The data contextualization and variable relationships built directly into the smart objects 322 of digital twin 1506 can greatly simplify and substantially automate the process of validating the digital twin 1506 for operation with a corresponding physical industrial asset or system. AI engine component 514, together with simulation component 2112, can apply AI intelligence to the granular smart tag data structure to verify the coherence, integrity, and validity of the digital twin 1506 relative to an industrial asset as part of the design and modeling process, rendering involvement of data scientists unnecessary.

In an example scenario, a digital twin 1506 may be developed to model an industrial asset under a particular operating condition. To validate the model, live or historical process data 2702 from the physical industrial asset (e.g., as collected and stored by device interface component 2014) can be applied to the digital twin 1506 by simulation component 2112. Process data 2702 represents actual measurement and status data generated by devices that make up the industrial asset being modeled (e.g., flows, energy consumption, temperatures, pressures, speeds etc.), and is typically time-stamped so that the simulation component 2112 can apply the data 2702 to the digital twin 1506 in a time-series manner, thereby simulating operation of the industrial asset over a time frame. Simulation component 2112 generates simulated result data 2704 representing simulated asset responses to the process data 2702, which are based on the relationships defined by the digital twin 1506 (e.g., by the asset and mechanical models) as well as the data relationships recorded in the AI fields 2604 of the smart objects 322. Simulated result data 2704 can also include other calculated indicators of asset performance (e.g., KPIs, efficiencies, cycle times, etc.) based on the data relationships modeled by the digital twin 1506 and its smart objects 322.

AI engine component 514 can apply verification algorithms to the digital twin 1506, simulated results 2704, and actual process data 2702 to verify whether specific modeled attributes and qualities of the digital twin 1506 accurately align with corresponding attributes and qualities the physical system. For example, AI engine component 514 can compare selected simulated results with their corresponding real values generated by the physical industrial asset, and determine whether the simulated results - generated based on relationships modeled in the digital twin 1506 and its smart objects 322 - are within a defined tolerance of their corresponding actual asset outputs. This comparison can be performed for individual aspects and relationships of the modeled asset so that deviations between the model and its corresponding physical asset can be identified at a highly granular level, and appropriate modifications made to the digital twin 1506.

In some embodiments, detected deviations between a modeled aspect of an industrial asset (e.g., a pump efficiency, a power consumption under a given operating mode, etc.) and corresponding actual values of the aspect can be visually rendered by presentation component 508 on a graphical representation of the modeled industrial asset; e.g., by highlighting the device, equipment, or component of the industrial asset having a characteristic or property that is not accurately modeled by the digital twin 1506. For these deviant aspects of the digital twin 1506, some embodiments of AI engine component 514 can also perform modifications 2706 on the digital twin 1506 to bring these flagged aspects of the model into alignment with the physical industrial asset. This can include, for example, updating the relationships between variables defined in the AI fields 2604 of the smart objects 322.

This approach to validating and, if necessary, updating the digital twin 1506 to ensure a high level of fidelity can be useful when the digital twin 1506 - or a replica thereof - is transferred for use with a similar, but not identical, industrial asset to that for which the digital twin 1506 was developed. For example, a digital twin 1506 may be developed to model a particular industrial system, such as a pumping system. As discussed above, development of the digital twin 1506 can involve AI contextualization of the smart objects 322 by AI engine component 514 to codify discovered relationships between modeled variables of the industrial system (e.g., measured telemetry values, KPIs, device statuses, power statistics, etc.) and to specify types of analytics to be performed or analytical problems to be solved on selected variables (e.g., optimization, minimization, clustering, etc.). It may then be decided that a copy of the resulting digital twin 1506 will be used at another plant facility to in connection with performing analytics on or performing supervisory control of a similar industrial system. During operation at the other plant facility, AI engine component 514 can monitor the simulated result data 2704 generated by the simulation component 2112 when the process data 2702 from the new industrial system is applied (e.g., efficiencies, power consumptions, etc.). In particular, AI engine component 514 can monitor for deviations between simulated properties or responses generated by the digital twin 1506 and expected values of those properties or responses learned during operation of the digital twin 1506 with the original industrial system. Such deviations are indicative of aspects of the digital twin 1506 that could be modified in order to improve the fidelity of the digital twin 1506 relative to the new industrial system.

To facilitate identifying and flagging these deviations, some of the AI fields 2604 added to the smart objects 322 by AI engine component 514 may include normal operating statistics for the variables represented by the respective smart objects 322. These normal operating statistics may be learned by AI engine component 514 based on extended monitoring of the digital twin's outputs during operation of the original industrial system. These normal or expected statistics may include expected efficiencies, expected power consumptions, expected flows or temperatures, or other such characteristics of the modeled system. Once these expected statistics are learned, the AI engine component 514 can add these expected values in new AI fields 2604 of their corresponding smart objects 322. In this way, baseline operation of important properties and characteristics of the original industrial system can be encoded within the digital twin itself. When the digital twin 1506 is deployed at the new facility, AI engine component 514 can compare these recorded expected statistics with corresponding new values of these statistics generated by applying the live or historical process data 2702 from the new plant to the digital twin 1506. If a calculated property is found to deviate from its corresponding expected value in excess of a defined tolerance, AI engine component 514 can flag the property as one that may require review or modification. AI engine component 514 may also modify the digital twin 1506 as needed to bring the model in line with the physical asset. In some cases, this may involve modifying one or more of the defined relationships encoded in the AI fields of the smart objects 322.

When performing modifications 2706 on the digital twin 1506 to address discovered inconsistencies between the digital twin 1506 and the modeled asset, AI engine component 514 can apply similar techniques to those described above for discovering updated relationships between key variables and other modeled variables of the digital twin 1506. These updated relationships can be identified based on analysis of the digital twin's outputs when time-series process data 2702 from the new industrial system is applied. Since some characteristics of the digital twin 1506 may pass validation by the AI engine component 514 - meaning that the relationships previously defined for those characteristics still hold true for the new industrial system - AI engine component 514 needs to only reassess modeled relationships for those characteristics that do not pass validation, minimizing the time required to yield a deployable digital twin 1506 for use with the new system.

In some embodiments, presentation component 508 may be configured to render a graphical representation of an industrial asset being modeled by digital twin 1506 (e.g., as a three-dimensional or VR representation of the asset) and graphically indicate portions of the digital model that have not been validated, or that have been determined to be possibly invalid based on analysis by the AI engine component 514. For example, presentation component 508 may render components, equipment, or devices of the digital model that have been validated in green, while rendering potentially invalid properties of the model in red.

A similar procedure for validating and updating the digital twin 1506 can be applied for scenarios in which the original digital twin 1506 may not accurately model an industrial asset across different operating scenarios. For example, a digital twin 1506 designed to augment available measurements from an industrial process with supplemental values (e.g., efficiency values, product or machine displacements, power consumption estimates, etc.) may accurately model the asset's responses during autumn operation, but may not be accurate for summer operating conditions. Accordingly, AI engine component 514 can assess the digital twin's calculated or simulated outputs in response to process data 2702 generated during summer operation and apply model modifications 2706 as needed to adapt the digital twin 1506 for summer operation.

By enhancing the smart objects 322 on which digital twins 1506 are built with AI properties as described herein, model validation structures become inherent properties of the digital twin's smart object infrastructure, and are transferable between digital twin installations. AI engine component 514 can interface with these enhanced smart objects 322 to validate the fidelity of the digital twin 1506 by verifying relationships between modeled properties and measurements, and adapting these relationships as needed. In this way, AI analytics become part of the model development itself in addition to being a consumer of the digital twin 1506. The enhanced smart objects 322 also render the digital twin 1506 AI-ready, simplifying the process of interfacing the digital twin 1506 with AI analytic systems or other types of analytic systems by encoding key variable dependencies and analysis goals within the smart objects themselves.

In any of the example scenarios described above, AI engine component 514 can apply artificial intelligence analysis to the digital twin 1506 and device data obtained from the modelled asset for the purposes of identifying key variables, identifying related variables that impact the key variable, learning relationships between key variables and those variables that influence the key variable, and validation of the digital twin. In some embodiments, AI engine component 514 can reason about or infer states of the digital twin or its modeled asset from a set of observations as captured via events or data. For example, inference can be employed to identify a specific context or action, or can generate a probability distribution over states. This inference can be probabilistic - that is, the computation of a probability distribution over states of interest based on a consideration of data and events. Inference can also refer to techniques employed for composing higher-level events from a set of events or data. Such inference results in the construction of new events or actions from a set of observed events or stored event data, whether or not the events are correlated in close temporal proximity, and whether the events and data come from one or several event and data sources. Various explicitly or implicitly trained classification schemes or systems (e.g., support vector machines, neural networks, expert systems, Bayesian belief networks, fuzzy logic, data fusion engine, etc.) can be employed in connection with performing automatic or inferred action in connection with the claimed subject matter.

Some embodiments of AI engine component 514 can employ classifiers in connection with learning, inferring, or validating relationships defined in the digital twin 1506. A classifier is a function that maps an input attribute vector, x = (x1, x2, x3, x4, *xn),* to a confidence that the input belongs to a class; that is, f(x) = *confidence*(*class*). This classification can employ a probabilistic or statistical-based analysis (e.g., factoring into the analysis utilities and costs) to prognose or infer an action that a user desires to be automatically performed. A support vector machine (SVM) is an example classifier that can be employed in some embodiments. The SVM operates by finding a hypersurface in the space of possible inputs. The hypersurface attempts to split triggering criteria from non-triggering events. Intuitively, this makes the classification correct for testing data that is near, but not identical to training data. Other directed and undirected model classification approaches that can be employed by embodiments of AI engine component 514 can include, but are not limited to, naive Bayes, Bayesian networks, decision trees, neural networks, fuzzy logic models, intelligent agents, and probabilistic classification models providing different patterns of independence can be employed. Classification as used herein also is inclusive of statistical regression that can be used to develop models of priority.

The design, runtime, and analytic features described above - which are made possible by the architecture of smart objects 322, asset models 422, and digital twins 1506 - can be beneficially applied to various types of industrial assets to streamline and improve the design process, perform digital simulations of the assets prior to deployment, collect metrics, and perform analytics on both the simulated assets and the physical assets. In an example implementation, an industrial design and testing platform can be configured to support the use of smart objects 322 and asset models 422 in connection with designing and simulating an industrial asset, machine, or system. The following examples describe a design and testing system for a linear synchronous motor (LSM) position and transport system that can leverage smart objects 322 and asset models 422 to facilitate design, simulation, and analysis of an LSM transport system, and to generate and utilize a digital twin of the resulting track system for both design and runtime analysis.

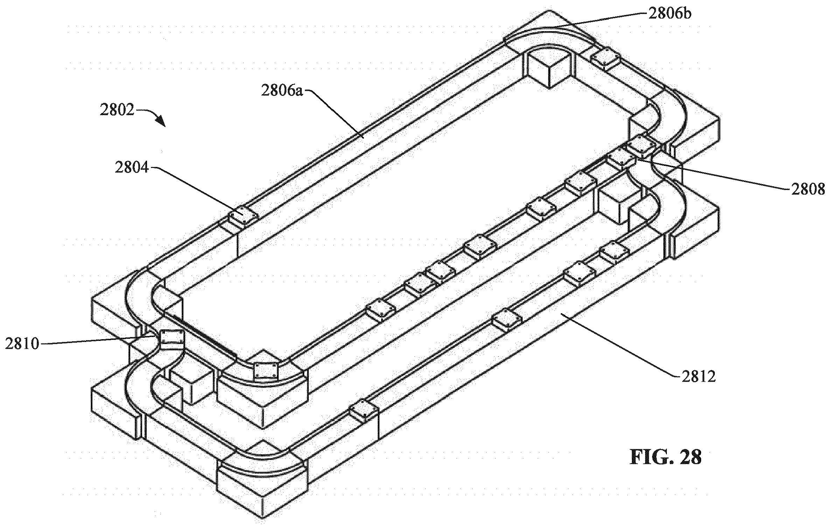

FIG. 28 is a view of an example LSM transport system 2802. The transport system 2802 comprises assembled sections of straight and curved motor modules 2806 connected together to form a closed guideway system along which one or more movers 2804 are guided and positioned with high accuracy using magnetic propulsion. Motor modules 2806 comprise not only the propulsion and routing elements used to propel the movers 2804, but also the track structures that guide the movers 2804 along a constructed path. The movers 2804 are designed to carry units of product - e.g., bottles, packages, circuit boards, etc. - to designated processing, loading, or unloading stations. To control the movements and positions of the movers 2804, magnetic flux sources, such as magnetic arrays, are installed in each mover 2804, and coreless propulsion coils are disposed at designated positions along the motor modules 2806. An industrial controller, or a dedicated track control module installed as a subsystem of an industrial controller, controls the movement and positioning of the movers 2804 along the guideway by exciting the propulsion coils in a controlled manner, causing the movers 2804 to be propelled along the guideway. Using this technique, the movers 2804 can be controlled independently of one another without collision, moved at high speed, and positioned with high accuracy.

The motor modules 2806 that form the guideway include straight track modules 2806a as well as curved motor modules 2806b. In addition to motor modules 2806, the track system 2802 may also include nodes of various types. In the example depicted in FIG. 28, a diverge node 2808 is used to selectively divert movers 2804 from the main guideway loop to a divergent guideway 2812 (assuming a clockwise direction of travel), and a merge node 2810 is used to merge movers 2804 exiting the divergent guideway 2812 back onto the main guideway loop. Other nodes can include simple nodes, terminus nodes, relays, or other such nodes. In general, any combination of straight motor modules 2806a, curved motor modules 2806b, and nodes (e.g., diverge nodes 2828 and merge nodes 2810) can be assembled as needed to create a guideway system that that fits the needs of a given industrial process.

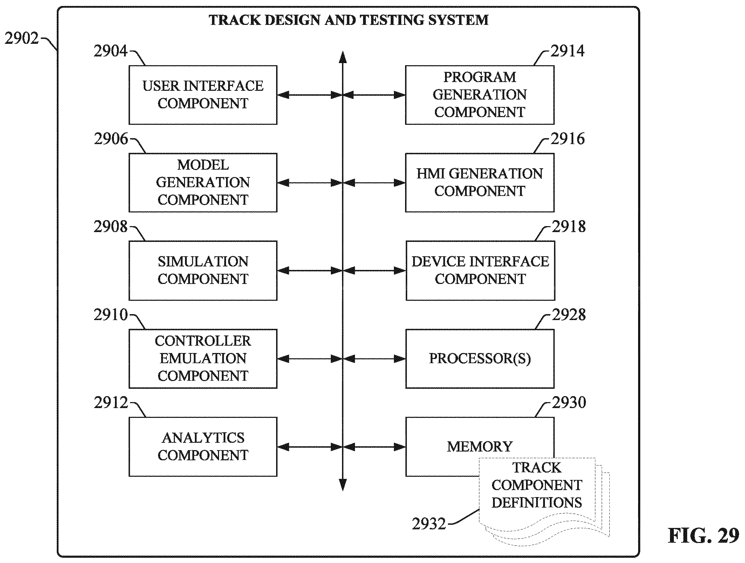

FIG. 29 is a block diagram of a track design and testing system 2902 for digitally engineering and testing an LSM transport system 2802, as well as for generating control code and visualizations that can be deployed to support the physical transport system 2802 in accordance with the design. Track design and testing system 2902 can include a user interface component 2904, a model generation component 2906, a simulation component 2908, a controller emulation component 2910, an analytics component 2912, a program generation component 2914, an HMI generation component 2916, a device interface component 2918, one or more processors 2928, and memory 2930. In various embodiments, one or more of the user interface component 2904, model generation component 2906, simulation component 2908, controller emulation component 2910, analytics component 2912, program generation component 2914, HMI generation component 2916, device interface component 2918, the one or more processors 2928, and memory 2930 can be electrically and/or communicatively coupled to one another to perform one or more of the functions of the track design and testing system 2902. In some embodiments, components 2904, 2906, 2908, 2910, 2912, 2914, and 2916 can comprise software instructions stored on memory 2930 and executed by processor(s) 2928. Track design and testing system 2902 may also interact with other hardware and/or software components not depicted in FIG. 29. For example, processor(s) 2928 may interact with one or more external user interface devices, such as a keyboard, a mouse, a display monitor, a touchscreen, or other such interface devices.

User interface component 2904 can be configured to receive user input and to render output to the user in any suitable format (e.g., visual, audio, tactile, etc.). In some embodiments, user interface component 2904 can be configured to communicatively interface with a development environment client that executes on a client device (e.g., a laptop computer, tablet computer, smart phone, etc.) that is communicatively connected to the track design and testing system 2902 (e.g., via a hardwired or wireless connection). The user interface component 2904 can then receive user input data and render output data via the development environment client. In other embodiments, user interface component 2904 can be configured to generate and serve suitable interface screens to a client device (e.g., screens for graphically assembling and configuring a digital model of a transport system), and exchange data via these interface screens. Input data that can be received via various embodiments of user interface component 2904 can include, but is not limited to, track module selections, track module assembly and orientation instructions, track station configuration parameters, mover configuration parameters, simulation control input, instructions to convert a digital track model to an executable control program (e.g., a ladder logic program) or a visualization application, or other such input. Output data rendered by various embodiments of user interface component 2904 can include renderings of animated three-dimensional track models, simulation or analytic result data, design feedback or other such output.

Model generation component 2906 can be configured to generate a digital model of the LSM transport system - similar to the asset models 422 discussed in previous examples - based on design input submitted by a user. This design input can include selection of one or more track component definitions 2932 from a component definition library stored on memory 2930. As will be described in more detail below, these track component definitions 2932 represent available motor modules (e.g., curved and straight motor modules of various sizes), stations, nodes, movers, and other components that can be assembled within a virtual to yield an LSM transport system. Design input submitted by the user can select, arrange, and assemble virtualized track components defined by these component definitions 2932 to yield a digital automation model of an LSM transport system that can be simulated and tested in the virtual design environment supported by the system 2902. Simulation component 2908 can be configured to execute a simulation of the LSM transport system in operation based on the automation model generated by the model generation component 2906. Controller emulation component 2910 can be configured to emulate execution of an industrial control program designed to monitor and control the modeled LSM transport system during simulation.

The analytics component 2912 can be configured to perform various types of analytics on the digital model, on results of one or more simulations, or on real-time contextualized data generated by the physical LSM transport system. Program generation component 2914 can be configured to translate the automation model created based on the design input to an industrial control program file that is executable on an industrial controller (e.g., a PLC or another type of controller) to facilitate monitoring and control of the physical LSM transport system. The control program file can comprise an executable control program, associated data tag and smart object definitions, and other controller configuration settings. HMI generation component 2916 can be configured to translate the design input submitted by the user to a visualization application (e.g., an HMI application) that can be executed on a visualization terminal device to render visualization displays that allow an operator to view operational and status data for the physical LSM transport system, and to interact with selected portions of the system (e.g., by setting setpoints or speeds, starting or stopping the system, etc.). Device interface component 2918 can be configured to communicatively connect to industrial devices, such as industrial controllers and HMI terminal devices, and exchange information with these field devices. This can include commissioning the project files created by the program generation component 2914 and the HMI generation component 2916 to appropriate industrial devices for execution, monitoring runtime data generated by the transport system during operation, cascading design updates between devices, and other such functions.

The one or more processors 2928 can perform one or more of the functions described herein with reference to the systems and/or methods disclosed. Memory 2930 can be a computer-readable storage medium storing computer-executable instructions and/or information for performing the functions described herein with reference to the systems and/or methods disclosed.

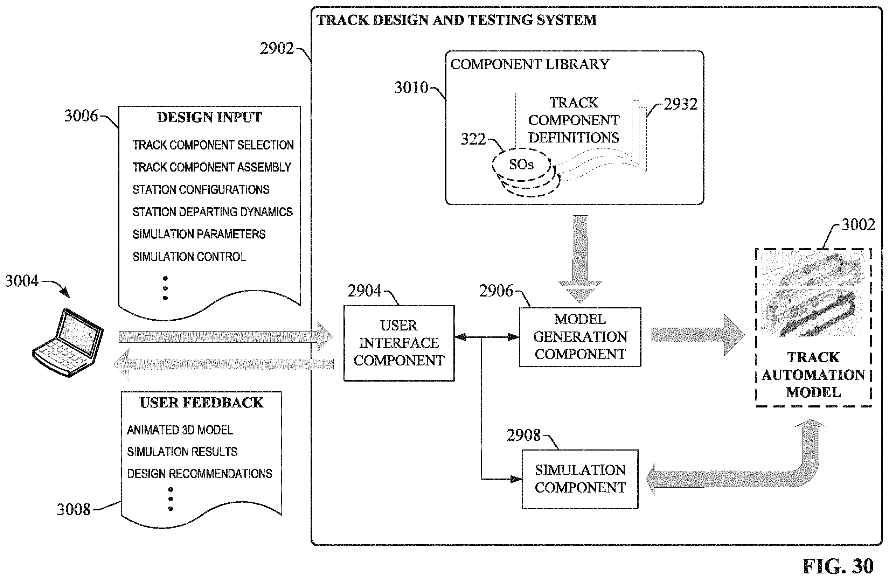

FIG. 30 is a diagram illustrating data flows associated with creation and simulation of a track automation model 3002 for an LSM transport system being designed using design and testing system 2902 according to the invention. A client device 3004 (e.g., a laptop computer, tablet computer, desktop computer, mobile device, wearable AR/VR appliance, etc.) can access the design and testing system's project development tools and leverage these tools to create a comprehensive system project - including automation model 3002 - for an LSM transport system being designed. In some embodiments, design and testing system 2902 can be installed locally on the client device 3004, or may be installed on a server accessible to the client device 3004. In still other embodiments, system 2902 can be executed on a cloud platform as a cloud service, such that authorized client devices 3004 can remotely access the design and simulation tools via a connection to the cloud.

Through interaction with the system's user interface component 2904, developers can submit design input 3006 to the system 2902 in the form of track component selections, track component assembly instructions, station configuration information, mover properties, and other such design information. Track components can be selected from among a set of track component definitions 2932 stored in a component library 3010. These track component definitions 2932 define properties of respective track modules or components, including but not limited to straight and curved motor modules (e.g., motor modules 2806), stations, merge and diverge nodes (e.g., nodes 2808 and 2810), movers (e.g., movers 2804), relays, terminus nodes, and other such components. Properties defined by track component definitions 2932 can include, but are not limited to, three-dimensional visual representations of the track components, dimensions of the components, physical properties, or other such attributes.

Some track component definitions 2932 can also define smart objects 322 associated with their corresponding track components. These defined smart objects 322 can correspond to properties or attributes of the corresponding track component, and can be configured to maintain values and associated contextualization metadata for these properties and attributes. For example, a track component definition 2932 corresponding to a station can define one or more smart objects 322 that store values of the station's dwell time, path identifier, station type, departure acceleration or velocity, or other such properties. In various embodiments, track component definition 2932 may define a single smart object 322 corresponding to the represented track component and having metadata fields corresponding to these different properties, or may define multiple smart objects 322 respectively corresponding to each of the component properties. Any of the BIDT metadata described above (e.g., in connection with FIGs. 6-8) can be associated with smart objects 322 defined by the track component definitions 2932, depending on the data type associated with the smart object (e.g., maximum, minimum, and instantaneous rate values for a Rate smart object, state names for a State smart object, etc.).

Track component definitions 2932 can also define visualization objects and controller code segments for their respective track components, which can be leveraged by HMI generation component 2916 and program generation component 2914 to generate an HMI application and industrial controller program file for the LSM transport system upon completion of the system design.

Based on this design input 3006, user interface component 2904 renders user feedback 3008 designed to assist the developer in connection with developing a three-dimensional track automation module 3002 and associated design project for configuration, control, and visualization of the LSM transport system. This feedback can include, for example, track component recommendations based on the assembly of components that have already been added to the model 3002, notifications that two track components that the user is attempting to assemble are not compatible or may introduce an inefficiency to the track system, recommendations to rearrange the current assembly of track modules in order to improve the flow of movers or to mitigate a potential inefficiency, or other such feedback.

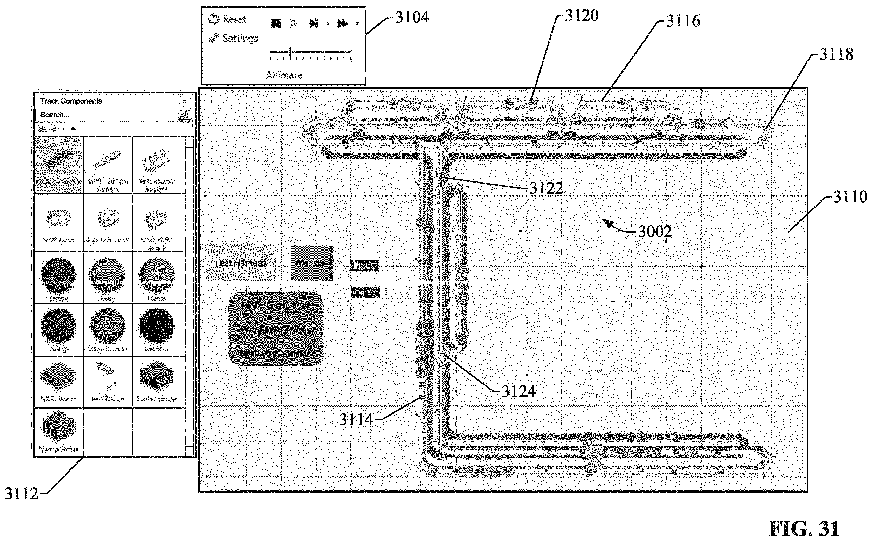

FIG. 31 is an example design interface 3102 that can be generated and rendered on client device 3004 by user interface component 2904. Design interface 3102 can include a main design area 3110 on which a three-dimensional graphical representation of the track automation model 3002 is displayed while the model 3002 is being assembled and configured by the user. The model 3002 can be modified and manipulated by the user through interaction with the design interface 3102. To facilitate design of an LSM transport system, the user can select track components to be added to the model 3002 from a Track Components menu 3112. The selectable components made available via the Track Components menu 3112 are based on the track component definitions 2932, such that each selectable component corresponds to a track component definition 2932 stored in the component library 3010. Example track components that can be selected and added to the model 3002 can include, but are not limited to, track controllers, straight motor modules 3116 of various lengths and sizes, curved motor modules 3118, left and right switches, merge nodes 3122, diverge nodes 3124, movers 3114, stations 3120 (e.g., load or unload stations, processing stations, packaging stations, etc.), station loaders, station shifters, terminals, or other such track elements. In various embodiments, virtualized track components can be added to the design area 3110 by selecting an icon representing the desired component from the menu 3112, or by dragging a selecting component from the menu 3112 to the design area 3110. The user can then manipulate the modules via interaction with the design area 3110 to arrange and assemble the selected virtual track models to achieve a desired track design and associated track automation model 3002. The model generation component 2906 can enforce track assembly rules such that only components that are physically compatible with one another are permitted to be assembled within the design environment.

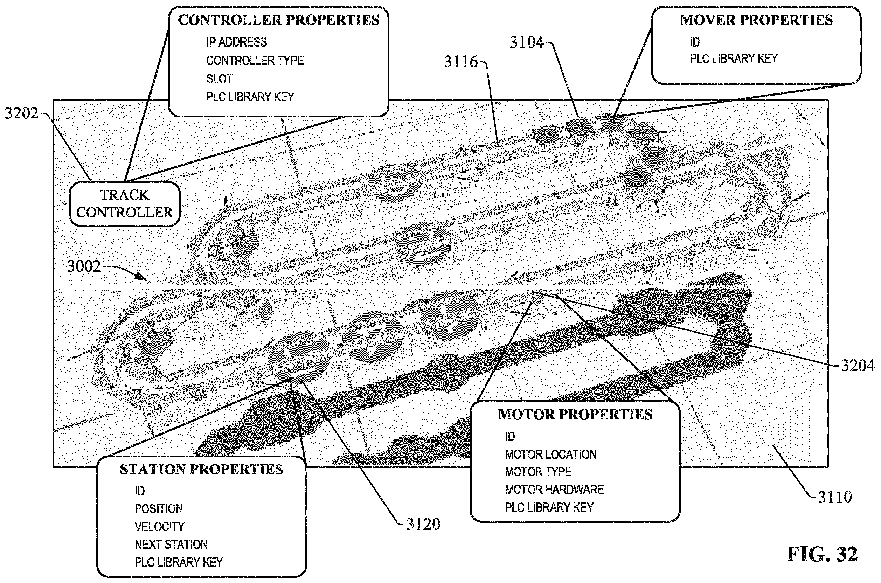

In some embodiments the track automation model 3002 can be manipulated in three dimensions via user interaction with the design area 3110 to allow the user to set the viewing angle and viewing distance of the model display. FIG. 32 is a view of an example track automation model 3002 within the design area 3110 from another perspective. In contrast to the direct overhead view of the model 3002 depicted in FIG. 31, model 3002 has been rotated in FIG. 32 to afford an angled viewing perspective.

The virtual track components defined by track component definitions 2932 can be predeveloped from mechanical models of those components. Some of the track component definitions 2932 can also comprise control logic for their respective virtual track components as well as configurable parameters or properties that allow the user to configure virtual operating behaviors of the selected track components that make up the model 3002, so that the model 3002 will accurately simulate physical and programmatic operation of the actual LSM transport system. In general, at least some of the parameters defined by the track component definitions 2932 are the same as those that will be used in the track controller program that will be generated by the program generation component 2914 for execution on the real track controller.

FIG. 32 illustrates a number of example properties that can be associated with respective virtual track components that make up the track automation model 3002. A motor module 3204 - representing a propulsion unit, such as a coreless motor with propulsion coils that react with magnets in the movers 3014 - can have an associated motor identifier, a motor location property, a motor type property, and a motor hardware property. A station 3120 can have an associated station identifier, a position property, a velocity property, a property identifying the next station in the route, or other such configurable properties. A controller 3202 can have an associated network address, controller type property, a slot identifier (if the track controller is installed in a slot of a primary industrial controller), or other such properties. Movers 3104 can each have an associated mover identifier. Values of these properties can be set by the user during the design phase to set the behaviors or functionalities of the respective track components. At least some of these properties will be ported to the industrial control program that is subsequently generated once design is complete (e.g., as add-on instruction parameter settings). Virtual track modules or components also have associated PLC library keys which link their associated modules to a library management tool used to generate the industrial control program.

Different types of stations 3120 can be selectively added and configured to the track automation model 3002 as desired. For example, a basic station will hold a mover 3104 in place until a specified process is completed, and will then send the mover 3104 to the next programmed destination. The next programmed destination can be set as one of the properties of the basic station virtual component (as defined by the basic station's tack component definition 2932). A grouping station can forward movers 3104 to downstream substations until all the substations are filled, then hold subsequently received movers 3104 until the substations are available. Substations managed by a grouping station will hold movers 3104 for a specified dwell time, or will command movers 3105 to leave in response to another specified departure criterion. A distribution station can forward movers 3104 to independent targets sequentially in order to space the movers 3104 during traversal. For example, the distribution station can be configured to hold incoming movers 3104 for a specified dwell time, and to release the movers 3104 upon expiration of the dwell time. The dwell time and the target station are configurable properties of the virtual distribution station component. In addition to defining the virtual operating behaviors of these components during simulation, the parameters defined for the respective virtual station components correspond to controller instruction parameters that will be used in the industrial controller code that will subsequently be generated and deployed based on the model 3002.

As the virtual track components are assembled and configured in accordance with the user's design input 3006, model generation component 2906 generates and configures a virtual track controller 3202 based on the selection of track components and behavioral configurations defined by the user. Track controller 3202 emulates control of the model LSM transport system by an industrial controller in accordance with the physical arrangement of track components and the operating parameters (e.g., station dwell times, maximum mover velocities and accelerations, station departing dynamics, numbers of movers, etc.) set by the user.

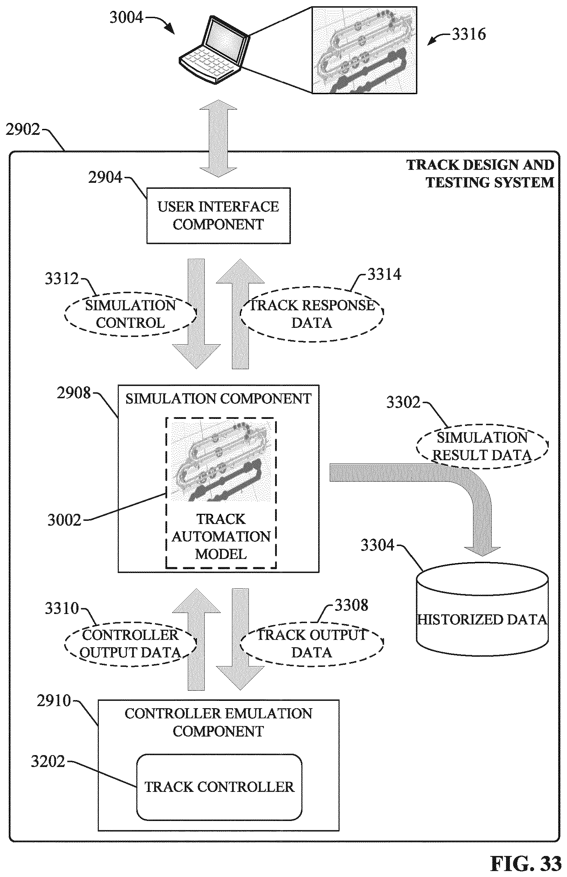

Once the virtual track automation model 3002 has been assembled and configured to conform to a desired track design, the design can be tested via simulation within the virtual development environment. FIG. 33 is a diagram illustrating example data flows associated with simulation of the track automation model 3002. Simulation component 2908 can virtually interface the track controller 3202 with the track automation model 3002 to facilitate exchange of simulated I/O data between the track controller 3202 and the model 3002, thereby simulating real-world control. Simulation component 2908 generates digital and analog I/O values representing, for example, sensor outputs, metering outputs, or other data analogous to the data expected to be generated by the physical transport system based on the design and operating characteristics encoded in the model 3002. This simulated track output data 3308 is provided to the controller emulation component 2910, which emulates operation of the track controller 3202. The controller emulation component 2910 receives this data 3308 as one or more virtual physical inputs. The track controller 3202 processes these inputs according to the arrangement of virtual track components and their corresponding control parameters as set by the user and defined in the model 3002. Based on this processing, the track controller 3202 generates digital and/or analog controller output data 3310 representing the physical outputs that would be generated by a controller and transmitted to the hardwired control devices of the transport system (e.g., motor control outputs, station control outputs, actuator control outputs, robot control outputs, etc.). The controller output data 3310 is provided to the simulation component 2908, which simulates the transport system's response to the controller outputs based on the model 3002, and updates the simulated track output data 3308 accordingly.

In addition to generating simulated track output data 3308 for consumption and processing by the track controller 3202, simulation component 2908 can also generate simulated track response data 3314 based on analysis of the simulated data exchange and expected behaviors of the modeled transport system in response to the simulated controller output data 3310. For example, based on the mechanical and control characteristics of the transport system represented by the automation model 3002, simulation component 2908 can predict expected behaviors and performance metrics of the track system and its associated movers in response to the controller output data 3310, and convey this predicted behavior as track response data 3314. Example behaviors and performance metrics generated by simulation component 2908 and represented by response data 3314 can include, but are not limited to, the movement and interactions between movers during operation, mover throughput at each of the defined stations, mover congestion or starvation statistics for each of the stations, energy consumption by the transport system as a whole, or other such behaviors and metrics.

During track simulation, user interface 2904 can generate a visualization 3316 that renders results of the simulation on a client device. Visualization 3316 can render track response data 3314 and other statistics relating to the simulation session in any suitable format. For example, visualization 3316 can render an animated version of the track automation model 3002 that visualizes movement of the movers 3104 through the modeled transport system under control of the emulated track controller 3202. This animated model 3002 can be rendered in the same design area 3110 of the user interface on which the user builds the model 3002. Returning to FIG. 31, a simulation control panel 3104 can be rendered adjacent to the design area 3110. Simulation control panel 3104 can include controls that allow the user to start and stop the simulation, adjust the speed of the simulation, or modify other simulation settings. When the simulation has been initiated, the static model 3002 user interface component 2904 animates the model 3002 to depict traversal of the movers 3104 based on the system design and configuration encoded in the model 3002. During simulation, the user can alter the viewing perspective of the animated model 3002 via interaction with the visualization 3316. This can include, for example, rotating the model 3002 in three dimensions or adjusting the zoom. This allows the user to view the simulation in either the overhead view depicted in FIG. 31 or a perspective view such as that depicted in FIG. 32. During simulation, the user interface component 2904 may also render simulation statistics as graphical animations or alphanumeric overlays on the visualization 3316.

This simulation technique can allow the user to view potential mover throughput problems, such as instances of station starvation or congestion at certain segments of the transport system at certain times. The user may also recognize possible causes of throughput problems based on visual examination of the animated simulation. In this way, the user can test and evaluate the proposed LSM transport system design prior to building the transport system. During this stage of the design and testing phase, the model 3002 can run as a complete virtualization and emulate the controls behavior.

During the simulation, simulation component 2908 can also generate and log simulation result data 3302 in historized data storage 3304 (e.g., on memory 2930 or another data storage area). This simulation result data 3302 can comprise predicted operating statistics such as mover process times at each station, mover arrival times at each station, mover throughput at various locations of the transport system, mover queuing and distribution statistics, or other such metrics. At least some of these statistics can be logged as time-series data so that performance metrics for the transport system design can be viewed as a function of time across a simulated operating time span. Simulation result data 3302 can also comprise indications of potential alarm scenarios, such as mover collisions or excessive cycle times. These statistics and potential alarm scenarios are estimated by the simulation component 2908 based on the physical arrangement of virtual track components and configured operational settings encoded in the model 3002. In this regard, simulation component 2908 leverages the physical properties defined by the track component definitions 2932 included in the model 3002, as well as physical relationships between these components as defined by the component connections, to predict how the movers and stations will operate as a function of time under control of the virtual track controller 3202.

The model-based simulation can be run in normal time or can be run at increased or decreased speed. Regardless of the simulation speed, the predicted performance metrics are saved with valid time stamps representing the real-time execution behavior of the modeled transport system.

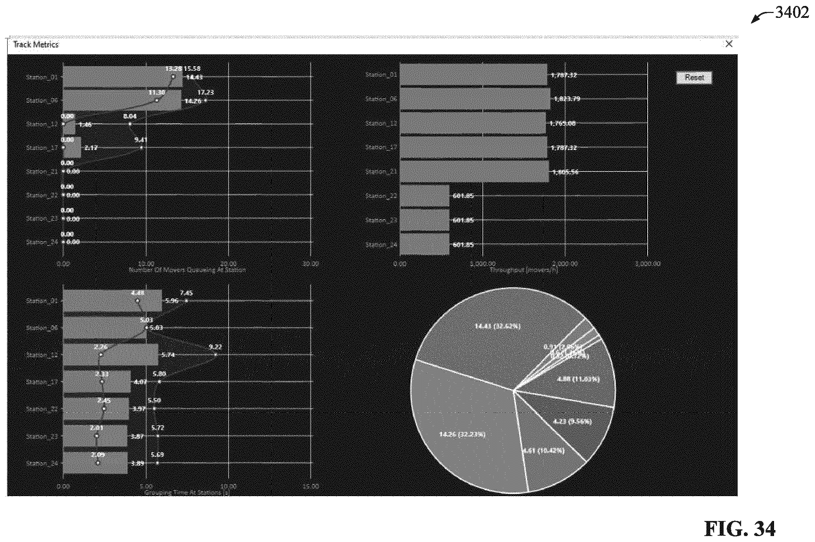

Upon completion of a simulation session, user interface component 2904 can generate summaries of the predicted operating performance of the transport system design. These summaries can be rendered in any suitable format, including alphanumeric or graphical summaries. FIG. 34 is an example track metrics display 3402 that can be generated by user interface component 2904. Track metrics display 3402 renders key performance indicators for the proposed track design as line graphs, bar graphs, and pie charts. For example, a first chart renders the number of movers queuing at each defined station as well as the variance, a second chart renders the mover grouping times at each defined station, and a third chart renders the mover throughput for each defined station (in movers per hour). These charts can depict both the mean numbers as well as variance. A pie chart can be used to convey comparative performance metrics for the stations. In general, user interface component 2904 can summarize the predicted performance of a track design using a set of statistical metrics based off running means and variances, yielding a set of quantifiable metrics that can be compared across different designs for evaluation.

This simulation technique can be used to test and debug control programs without putting field equipment and machinery at risk, to simulate modifications to plant or machine operations and estimate how such modifications affect certain key performance indicators or financial metrics, or to perform other types of analytics. Based on results of the simulation - e.g., based on evaluation of the predicted performance metrics- the user may modify the transport system design to yield an updated model 3002 and re-run the simulation. As will be discussed in more detail below, the design and testing system 2902 can simulate and evaluate multiple different track designs, and select optimal designs based on data mining performed on the resulting simulation result data.

In some embodiments, simulation component 2908 can also consider, and compensate for, variability of the track's performance prior to reaching steady-state operation. In this regard, from the moment track operation is initiated from a stopped state, the track will require a certain amount of time to reach steady-state operation. Prior to reaching this steady-state operation, the transport system experiences a transient operation during which certain performance aspects, such as the distribution of movers 3114 around the track, will vary until settling into a more predictable, less varied steady state. Accordingly, the steady state can be defined as the point in time when the change of the variance of these performance aspects falls within a defined threshold. After reaching this steady state operation, the metrics accumulated prior to reaching the steady state (that is, the performance during the transient operation) can be cleared to eliminate the influence of this transient operation and the test can be restarted. In some embodiments, the simulation component 2908 can conclude the simulation session when all metrics variances are within a defined threshold (which may be a user-defined threshold).

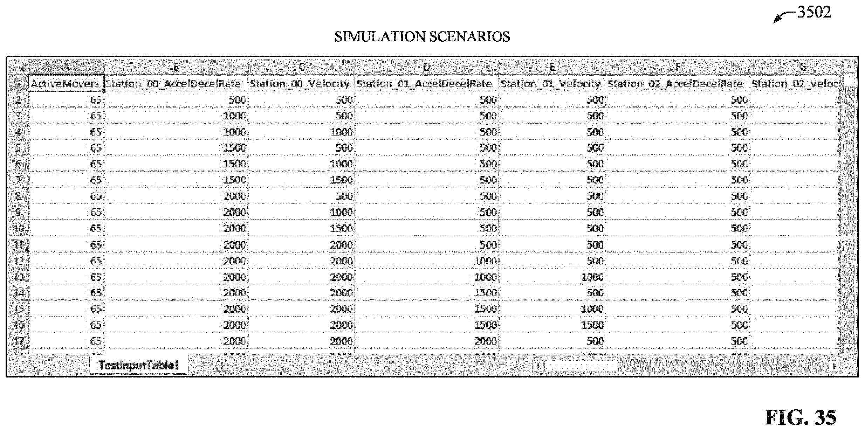

In some embodiments, the design and testing system 2902 can execute simulations for multiple different design variations for the transport system being developed, and store predicted performance metrics for the various design variations for comparative evaluation and design optimization. FIG. 35 is a partial listing of track design parameters that can be varied across different simulation sessions for the purpose of comparative analysis. Operating parameters that can be varied across different simulation sessions can include, but are not limited to, the number of active movers 3104 on the track, the acceleration and deceleration rates of each defined station 3120, the velocities of each defined station 3120, or other such characteristics. In the list depicted in FIG. 35, each row represents a different system configuration, or test case, for which a simulation can be executed.

Typically, given a certain number of stations included in the transport system, with a range of possible accelerations and velocities for each station, the number of possible system design permutations can be large. Moreover, given the necessity to allow each simulated operation to settle into steady-state operation before useful performance metrics can be generated, followed by sufficient steady-state operating time to collect enough performance data to yield an accurate performance summary, executing these simulations in normal time can be unrealistically time consuming. To address this issue, the simulation component 2908 can execute these multiple simulations in accelerated time, allowing design and testing system 2902 to quickly generate predicted performance metrics for a multitude of track design variations.

In some embodiments, prior to initiating the multi-design simulations, the user can set ranges of the design settings - e.g., number of movers, station accelerations and velocities - that are to be tested (e.g., 30-40 movers, velocities between 500 mm/s - 2000 mm/s, accelerations between 500 mm/s² - 2000 mm/s²), and the simulation component 2908 can execute simulations of the model 3002 for multiple permutations of these configuration settings within the user-specified ranges. The user may also specify steps within the defined ranges that are to be tested (e.g., station velocities in increments of 500 mm/s), and simulation component 2908 will execute simulations for permutations of the design parameters in sequential increments according to the specified ranges and steps. Alternatively, the simulation component 2908 may select suitable ranges or steps of the design parameters to be tested based on known operating ranges for the track components as defined in the track component definitions 2932. In addition to sequential simulated testing, the simulation component 2908 can also perform randomized tests using randomly selected values of the configuration settings (e.g., numbers of movers, station velocities and accelerations, etc.).

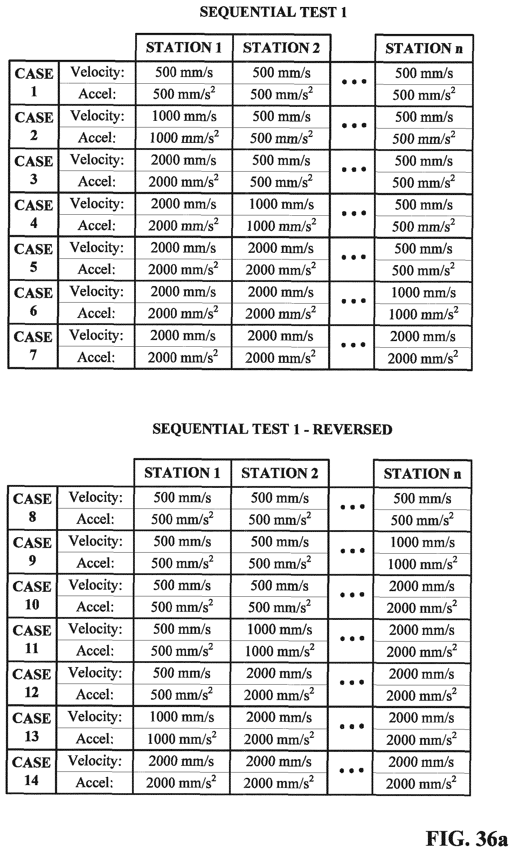

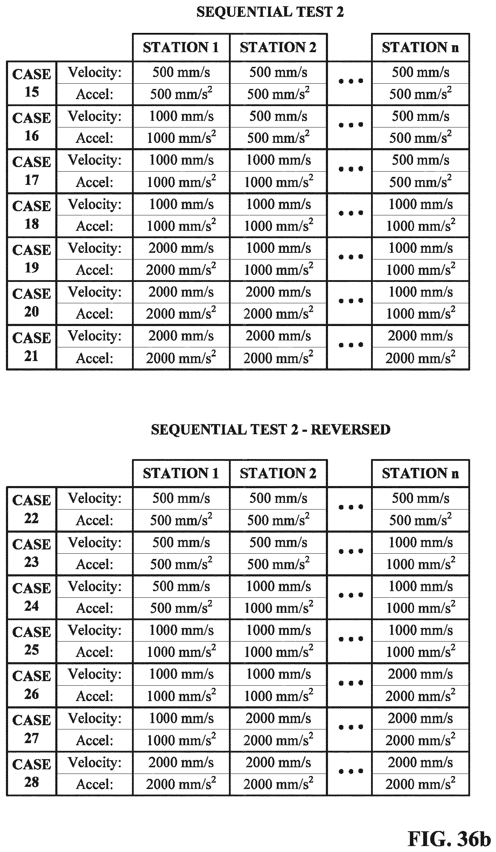

In the case of a track design comprising multiple stations, simulation component 2908 can execute simulations for multiple permutations of the velocities and accelerations, changing the values of the velocities and accelerations in a sequential manner for each consecutive simulation test case. FIGs. 36a and 36b are lists of station velocity and acceleration values that can set for respective simulation test cases in an example simulation scenario comprising two sequential simulation tests. In this example, the track automation model 3002 is assumed to comprise n stations, where n is an integer greater than two. Each station is to be tested for a range of velocities between 500 and 2000 mm/s and a range of accelerations between 500 and 2000 mm/s².

In a first sequential test, represented by cases 1-7, each station is initially set to have a velocity of 500 mm/s and an acceleration of 500 mm/s² (Case 1). Simulation component 2908 performs an acceleration simulation and stores simulated result data 3302 for this initial case. The simulation component 2908 then increases the velocity and acceleration of the Station 1 to 1000 mm/s and 1000 mm/s², respectively, for the next test case (Case 2), while leaving the configurations of the other stations unchanged. Upon completion of this simulation, the velocity and acceleration of Station 1 is increased again to 2000 mm/s and 2000 mm/s², respectively, for the next simulation (Case 3), leaving the other stations unchanged.

Next, with the settings for Station 1 left at their values from Case 3, the velocity and acceleration of Station 2 is increased for Cases 4 and 5 in a manner similar to Station 1, leaving the other stations unchanged during these test cases. Upon completion of these simulations, the settings for the next station is increased in a similar manner for the next two tests. This manner of sequential testing continues until all stations have been set to the maximum velocities and accelerations for the final test of this phase (Case 7 in the example depicted in FIG. 36a, which assumes a three-station system).

Sequential Test 1 can be re-executed for different numbers of movers (e.g., by initially performing Cases 1-7 with the maximum number of movers, then removing one mover from the simulation for each consecutive re-execution of Cases 1-7). When all of these scenarios have been run, sequential test 1 can be re-executed in a reverse manner, as represented by Cases 8-14. That is, rather than increasing the velocity and acceleration sequentially from Station 1 to Station n, these parameters are increased from Station n to Station 1.

Next, a second type of sequential test can be executed, as illustrated in FIG. 36b. In this case, the first two test cases (Cases 15 and 16) are similar to the first two test cases of Sequential Test 1. However, rather than increasing Station 1 to its maximum for the third test case (Case 17), Station 2 is increased to 1000 mm/s and 1000 mm/s². Upon completion of this simulation test case, the next station in line is also increased to 1000 mm/s and 1000 mm/s² (Case 18). When the last station in line has been increased in this manner, Station 1 is increased to its maximum of 2000 mm/s and 2000 mm/s² (Case 19), and each station in turn is similarly increased for each subsequent test. As with Sequential Test 1, Sequential Test 2 can also be re-run for different numbers of movers, and can then be run in a reverse manner (Cases 22-28).

It is to be appreciated that the example sequential tests depicted in FIGs. 36a and 36b are only intended to be exemplary, and that any manner of generating multiple permutations of station parameters for respective simulation cycles is within the scope of one or more embodiments of this disclosure. Also, in addition to the sequential tests, simulation component 2908 can also execute randomized tests in which values of the velocity and acceleration for each station are randomly selected.

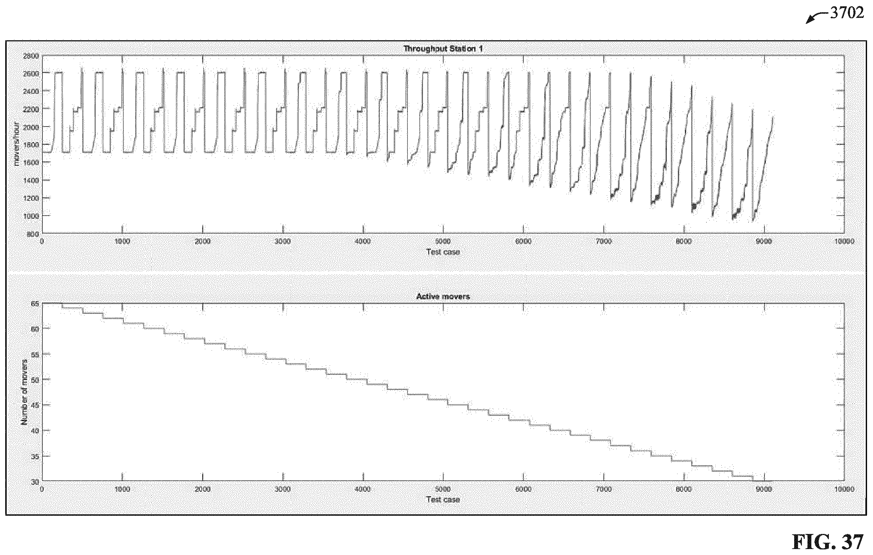

User interface component 2904 can render results of these various design test scenarios in a manner that allows the user to easily compare test results for the different designs relative to a selected performance metric of interest. FIG. 37 is an example test summary display that compares predicted mover throughput through a specified station for different simulated design scenarios. In this example, mover throughput for a selected station (Station 1) is plotted for over 9000 design variations. As a result of the sequential and/or randomized simulation test patterns described above, the tested designs vary in terms of the number of active movers on the track, as well as velocities and accelerations configured for each station.

The example test result display 3702 plots the station throughput as a function of the test case in a first chart, and the number of movers used for each test case in a second chart. Throughput values for each test case are a result of an accelerated simulation of the track automation model 3002 for a given set of design parameters (e.g., the parameters represented by individual test cases in FIGs. 36a and 36b). Although FIG. 37 depicts the throughput for Station 1 plotted together with the number of movers used in the respective simulation test cases, user interface component 2904 can allow the user to customize the view of the simulated test results to view any combination of predicted performance metrics and configuration parameters (e.g., by selecting to view the throughput graph for a different station, or by selecting a different configuration parameter - e.g., acceleration or velocity for one or more stations - for comparison). Graphs such as those depicted in FIG. 37 can allow the user to identify, for example, the minimum number of movers that can be added to the system without causing starvation of a given station.

By executing a large number of simulations in accelerated time steps without sacrificing fidelity of the feedback and measured variables, the design and testing system 2902 can allow the user to execute simulations on a wide range of design scenarios in a fraction of the time that would otherwise be required if the simulations were run in real-time.

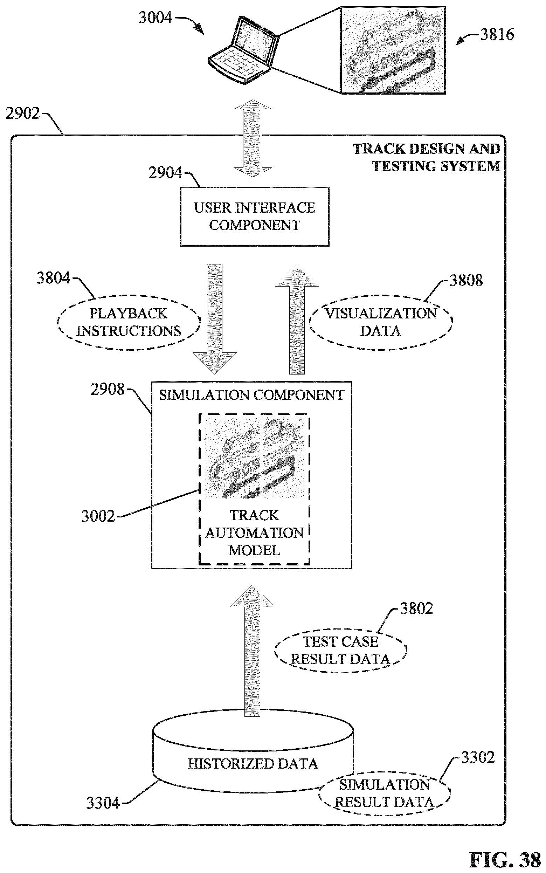

Also, in some embodiments, the user interface component 2904 can support playback of selected design simulations based on the model 3002 and selected subsets of the stored simulation result data 3302. This can allow the user to replay sequences of simulations for selected design scenarios (e.g., selected combinations of velocities, accelerations, and numbers of movers) within the design area 3110 of the development platform. FIG. 38 is a diagram that illustrates playback of selected simulations based on previously generated simulation result data 3302. Even though the simulations that generated the simulation result data 3302 were executed across a highly compressed time scale due to the accelerated simulation rates, the simulation result data 3302 for each simulation test case is time-stamped according to a real-time time scale. As such, time-series subsets of this simulation result data 3302 can be selected and rendered by the user interface component 2904 as a sequential time-series animation track automation model 3002. Similar to the playback functionality described above in connection with FIG. 18, user interface component 2904 can leverage the track automation model 3002 and the historized simulation result data 3302 to generate a virtualized "playback" of selected simulation test cases.

In an example implementation, user interface component 2904 can render simulation playback controls on the client device 3004 (e.g., a wearable computer or another type of client device) that allow the user to generate and send playback instructions 3804 to the system 2902. Playback instructions 3408 can include, for example, a selection of a specific test design case to be reviewed, instructions to scroll the simulation playback backward or forward in time, instructions to increase or decrease a speed of the simulation playback, or other such instructions. In response to selection of a design test case of interest via playback instructions 3804, user interface component 2904 can retrieve, from historized data storage 3304, test case result data 3802 comprising a subset of the time-series simulation result data 3302 that had been generated by the simulation component 2908 for the selected test case. User interface component 2904 can then render, on client device 3004, a presentation 3816 based on visualization data 3808. The presentation 3816 renders an animation of the model 3002, where the animation represents a virtual playback of the simulation of the selected design test case based on the retrieved test case result data 3802. This presentation 3816 can render the track automation model 3002 and animate the model 3002 to graphically depict the simulated operations, including movement of the movers 3104 through the transport system. Such simulation playbacks can allow the user to view predicted instances of station starvation or congestion, mover collisions, cycle times, or other such visual operating characteristics. As part of the simulation playbacks, user interface component 2904 can also overlay alphanumerical statistic information on the animated model 3002, where the statistical information is derived from the test case result data 3802 and presented on the playback at relevant times during playback.

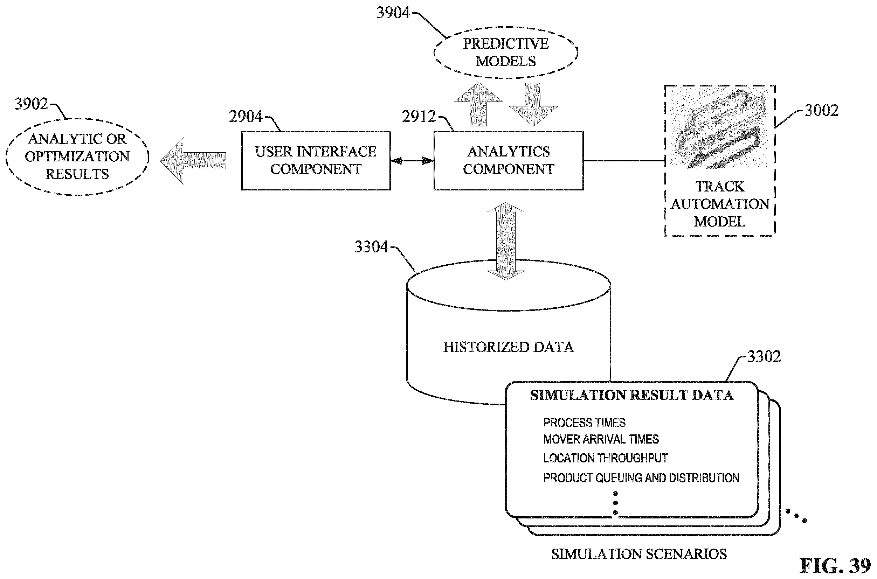

In addition to rendering results of the multiple design simulations, one or more embodiments of design and testing system 2902 can be configured to analyze, or perform data mining on, the simulation result data 3302 for the purposes of identifying a preferred or optimal design, or learning insights into the various design scenarios. FIG. 39 is a diagram illustrating analysis of the simulation result data 3302 generated by the simulation component 2908 for multiple design test case scenarios. In some embodiments, analytics component 2912 can be configured to apply machine learning algorithms to the large amount of simulation result data 3302 to identify, for example, relationships between process areas (e.g., stations 3120), control points, and hardware configurations.

As part of this analysis, a standard set of machine learning inputs can be defined, where these inputs can include the user-defined configuration parameters for the track (e.g., stations velocities and accelerations, as well as the number of movers on the track, as in the examples described above). A resulting set of statistical track performance metrics that are a function of these inputs can also be defined. These outputs can include, for example, mean grouping times at various points around the track, variance of grouping times, station queueing statistics, station arrival times, mover throughput, or other such metrics. In some embodiments, analytics component 2912 can generate predictive models 3904 for the track's operation and performance based on results of this machine learning, together with the properties defined in the automation model 3002. The inputs and outputs of the predictive models 3904 can correspond to the standardized inputs and outputs indicated above, such that the inputs of the predictive models 3904 are the user configuration parameters for the track design (e.g., accelerations, velocities, number of movers, etc.), and the outputs are the standardized track performance metrics. Using this approach, the system 2902 supports a standard workflow for defining system inputs and outputs when training predictive models 3904.

The resulting predictive models 3904 - derived from collective analysis of the simulation result data 3302 for multiple track design variations generated by simulation component 2908 - can be used to predict the behavior of the transport system represented by model 3002 for a variety of design settings and hardware configurations. In general, these predictive models 3904 can accurately predict the controls behavior of the modeled transport system under different configuration scenarios without yet factoring in the physics of the track (e.g., frictions between the movers and the track, inertias, etc.) or other user configurations such as PID loops. That is, the predictive models 3904 represent purely controls-driven models, allowing the control behavior to be assessed separately from physical considerations.

The trained predictive models 3904 generated by analytics component 2912 can subsequently be leveraged by the analytics component 2912 to evaluate a large number of configuration and operating scenarios for the modeled transport system; e.g., by providing multiple permutations of inputs (e.g., the variable configuration parameters, such as station velocities and accelerations) to the predictive models 3904 and evaluating the resulting outputs in the form of track statistical metrics. In this manner, the analytics component 2912 can assess a vast array of model input permutations in a fraction of the time required for brute force analytic approaches. Using predictive models 3904 that predict track performance metrics - such as station queuing statistics and mover throughput - as a function of the design configuration parameters, the system 2902 can allow the user to select one or more optimization criteria as desired, and the analytics component 2912 can search for sets of values for the design parameters (e.g., setpoint velocities and accelerations for each station defined in the model 3002) that yield output metrics that satisfy the specified optimization criteria. These optimization results can be rendered by the user interface component 2904 as analytic or optimization results 3902.

In some embodiments, simulation component 2908 can also estimate, during the simulation sessions for the multiple design scenarios, secondary operational characteristics of the modeled transport system that may be a function of the varying user-configurable design parameters, such as bus utilization and the rate of power consumption by the transport system under the different design scenarios. Alternatively, the analytics component 2912 can estimate these secondary operational statistics after the simulations are complete based on analysis of the simulation result data 3302 and properties of the track modules as obtained from the automation model 3002. At least some of these secondary operating statistics can be determined based in part on mechanical or electrical characteristics of the track modules included in the model 3002, as encoded in the track component definitions 2932. These secondary operating statistics can be used to assist the user to select a suitable set of design parameters in the event that multiple design test cases satisfy a primary design criterion. For example, if the user is attempting to identify a suitable set of track configuration parameters that achieve at least a specified minimum throughput through a specified station, the analytics component 2912 may determine, based on analysis of the predictive models 3904, that multiple design test cases satisfy this criterion. The user may further specify minimization of power consumption as another design criterion to be satisfied. Based on these user-defined optimization criteria, analytics component 2912 can identify, based on analysis of the predictive models 3904, one or more candidate designs that satisfy the user's throughput requirement with the least consumption of power. The configuration settings corresponding to these designs can be rendered by the user interface component 2904 as part of the analytic or optimization results 3902, thereby substantially automating the selection of control settings and design parameters (e.g., accelerations, velocities, number of movers, etc.) that will cause the track system to operate in accordance with the specified optimization criteria.

In general, the analytics component 2912 can perform global search optimization on the input selection to guide the search for a suitable input solution using a cost function inherited from the user's specified optimization criteria (in terms of station throughput, bus utilization, power consumption, or other criteria). In its simplest form, the cost function can comprise the sum of all inputs for any input selection that satisfy the defined optimization requirements (or that yield outputs that come within a defined range of the desired output values). The optimization problem then becomes a matter of identifying the input set with the lowest cost. Thus, the predictive models generated by the analytics component 2912 provides a mathematical quantity that allows the system 2902 to rank all the input sets that yield the desired performance and output.

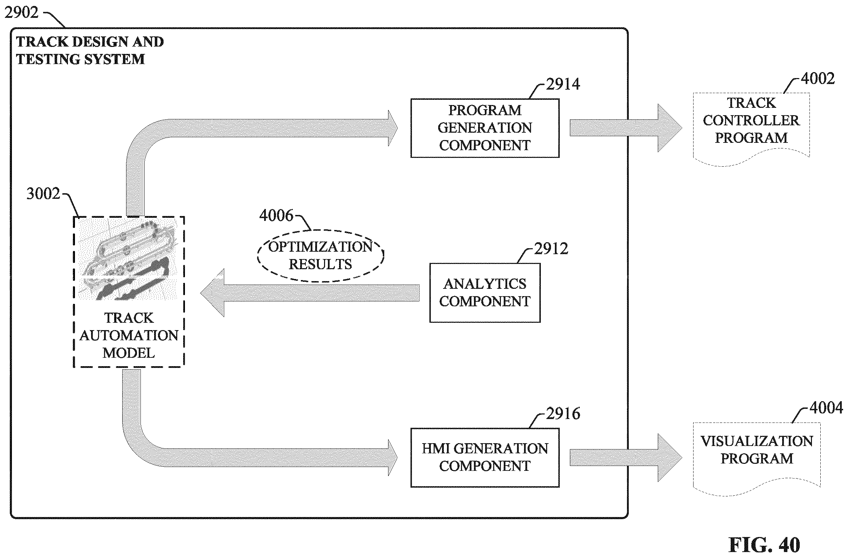

At any point after the track automation model 3002 has been completed, the track design and testing system 2902 can leverage the model 3002 to generate the control and visualization programming that will be used to implement the track control solution on the physical track system. FIG. 40 is a diagram illustrating creation of a track controller program 4002 and a visualization program 4004 by the design and testing system 2902 based on the completed automation model 3002. Program generation component 2914 is configured to compile or otherwise translate the track automation model 3002 into a track controller program 4002, which may be an executable program and configuration file that can be stored and executed on an hardware controller, such as an industrial controller (e.g., a PLC) or a track control module installed as a module of an industrial controller. The track controller program 4002 generated by the program generation component 2914 is designed to monitor and control a physical transport system analogous to the track automation model 3002, and in accordance with the design parameters encoded in that model 3002 (e.g., the station velocities, accelerations, dwell times, etc.).

If the user invoked the analytics component 2912 to discover a suitable set of design parameters for the model 3002 that satisfy one or more specified optimization criteria, as described above in connection with FIG. 39, the system can feed the resulting optimization results 4006 to the track automation model 3002 prior to creation of track controller program 4002. In this way, the model 3002 is updated to encode the selected design parameters (e.g., velocities, accelerations, number of movers, etc.). Alternatively, the user may manually set one or more of the track configuration parameters for the model 3002. In either case, once the model 3002 has been created and a suitable set of design variables have been set, the user can initiate generation of the control solution based on the updated model 3002, including creation of track controller program 4002. As part of this conversion, the program generation component 2914 can create any smart objects 322 considered necessary for storage and contextualization of data relating to operation of the transport system, making these smart objects 322 part of the controller program's tag database. At least some of these smart objects 322 may correspond to the track module properties defined in the model 3002, as set by the user or automatically by the analytics component 2912 per the optimization analysis.

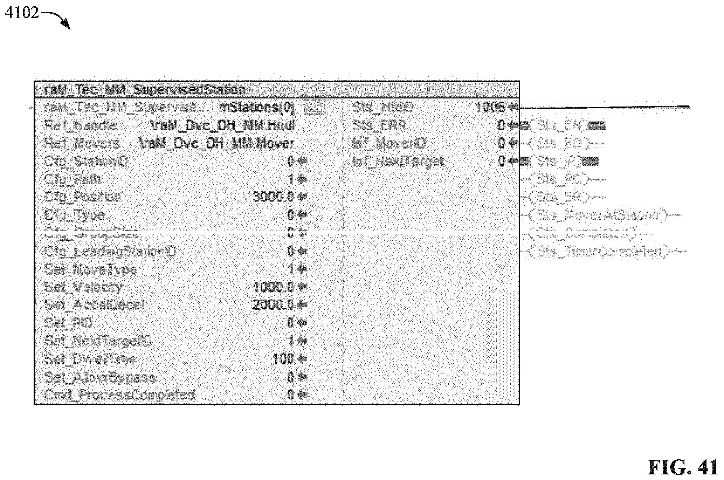

As noted above, at least some of the configurable design parameters that can be manually or automatically set for the automation model 3002 mirror those that will be used in the finalized track controller program 4002, simplifying the conversion from the model 3002 to the executable controller program 4002. For example, in some embodiments the track controller program 4002 may be a ladder logic program for execution on a PLC to facilitate monitoring and control of the physical transport system in accordance with the design parameters encoded in the model 3002. This program 4002 may support Station instructions (e.g., add-on instructions, or AOIs) having configurable parameters that match design parameters encoded in the model 3002. FIG. 41 is a depiction of an example Station instruction 4102 that can be included in a ladder logic program generated by program generation component 2914. Station instruction 4102 serves as a single type of PLC function block that can be used for all types of track stations (e.g. basic, grouping, distribution, etc.). In general, program generation component 2914 can generate track controller program 4002 to include a station instruction 4102 for each station 3120 defined in the track automation model 3002, and set the instruction parameters for each Station instruction 4102 to be equal to the values of their corresponding configuration parameters in the model 3002. In the example Station instruction 4102 depicted in FIG. 41, the configurable instruction parameters include, but are not limited to, the station identifier and type (e.g., grouping station, basic station, distribution station, etc.), velocity, acceleration and deceleration, identifier of the next target station, dwell time, a bypass permissive, and other parameters.

At least some of the parameters for the Station instruction 4102 are set based on the placement location of the respective stations 3120 within the model 3002 and the linkages between the stations 3120, as assembled graphically by the user via interaction with the design area 3110. For example, the program generation component 2914 can determine the value of NextTargetID parameter, which identifies the next target station relative to the current station, based on the physical relationships between stations 3120 as assembled by the user using the techniques described above in connection with FIGs. 30-32.

When executed on an industrial controller, station instruction 4102 causes the controller to monitor and control its corresponding station in accordance with the configurable design parameters. The Station instruction 4102 can also control the values of various station status bits, including an enabled status, an error status, an indication that a mover is at the station, an indication that processing at the station is complete, or other such station statuses. These status bits can be consumed by other portions of the controller program 4002, or can be used to drive indicators on an HMI.

The manner in which the industrial controller controls the operation of the station - including the timing of the motor control signals that propels movers into and out of the station, and the speed and acceleration at which the movers are moved - will depend on the type of station and the other instruction parameters defined for the instruction 4102. Moreover, the Station instruction 4102 can implement advanced functionalities for mover collision avoidance and synchronization between movers. These advanced functionalities can mirror similar collision avoidance and synchronization functions implemented by the model 3002 during simulation, thereby ensuring a high degree of fidelity between the simulated mover behavior and the actual behavior of the physical movers when controlled by the deployed control solution.

Returning now to FIG. 40, in addition to generating track controller program 4002 for control of the physical transport system, an HMI generation component 2916 can also generate a visualization program 4004 based on the model 3002. Visualization program 4004 can be executed on an HMI terminal or another type of visualization device to render operational and statistical information for the track system during operation on one or more graphical operator screens defined by the visualization program 4004. Each defined operator screen can contain graphical or alphanumeric objects that link to corresponding data tags or smart objects 332 within the industrial controller on which the track controller program 4002 executes, such that the values of the data tags or smart objects drive the visual presentation of the objects; e.g., by updating an alphanumeric value or a graphical animation in accordance with the value of a corresponding smart object 332 or data tag.

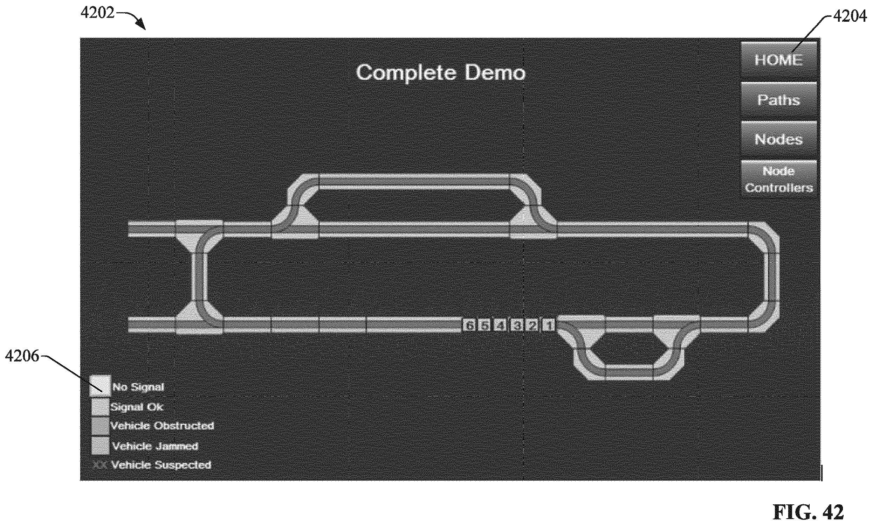

FIGs. 42-45 are example operator screens that can be defined by the visualization program 4004 generated by the HMI generation component 2916. FIG. 42 is an example track overview screen 4202 that depicts an animated overhead graphic of the physical transport system. The overview graphic comprises an overhead view of the track layout and animated mover icons that traverse the track representation in accordance with the actual positions of their corresponding movers. Status or error indicators 4206 are located at the bottom left corner of the screen. These can include, for example, indicators that a vehicle is obstructed, jammed, or suspended. The error indicators 4206 may also indicate when a signal to the controller is lost. Navigation buttons 4204 for invoking other operator screens are located in the top right corner of the screen 4202.

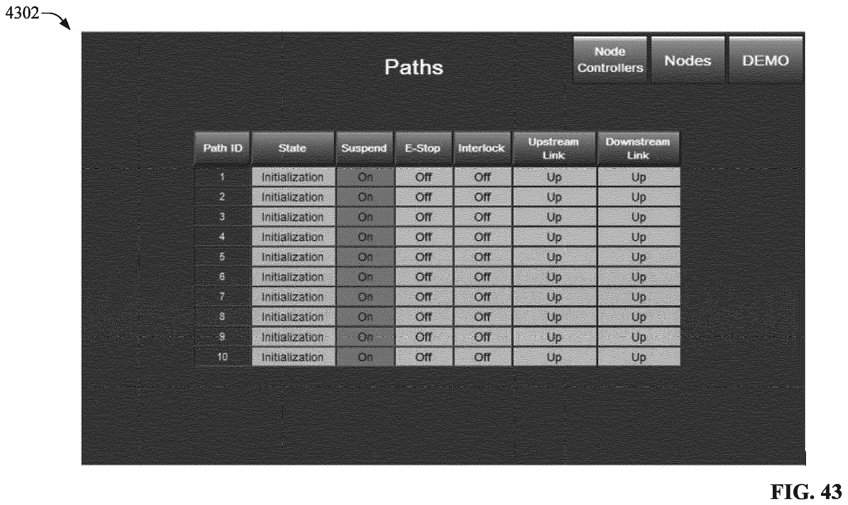

FIG. 43 is an example Paths operator screen 4302 that can be invoked via selection of an appropriate navigation button 4204. This screen 4302 lists a number of mover paths defined by the track system together with status data for each path, including a path state, a suspend status, an emergency stop status, statuses of interlocks, and statuses of upstream and downstream links.

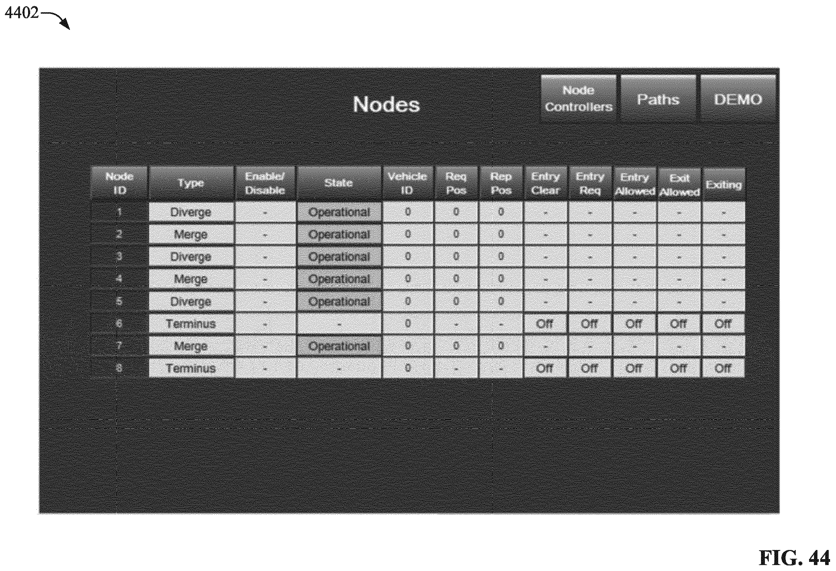

FIG. 44 is an example Nodes operator screen 4402 that can be invoked via selection of an appropriate navigation button 4204. This screen 4402 lists the various nodes that are built into the track system - e.g., diverge nodes, merge nodes, terminus nodes, etc. - together with status data for each node. For each node, the operator screen 4402 indicates the node type, an indication of whether the node is enabled, a state of the node, a identifier of a mover currently at the node, indications of whether entries into or exits from the node are allowed, or other such information. The availability of some items of node data may depend on the type of the node.

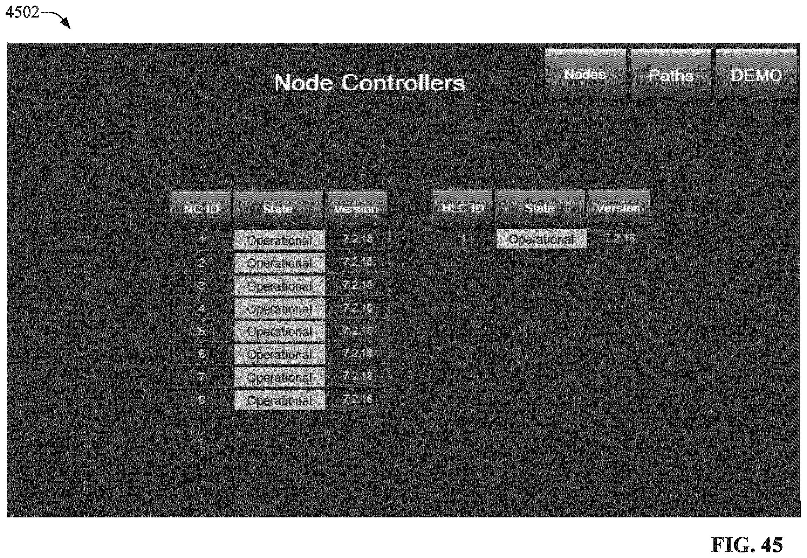

FIG. 45 is an example Node Controllers operator screen 4502 that lists the node controllers for each of the nodes together with state and version information for each node controller.

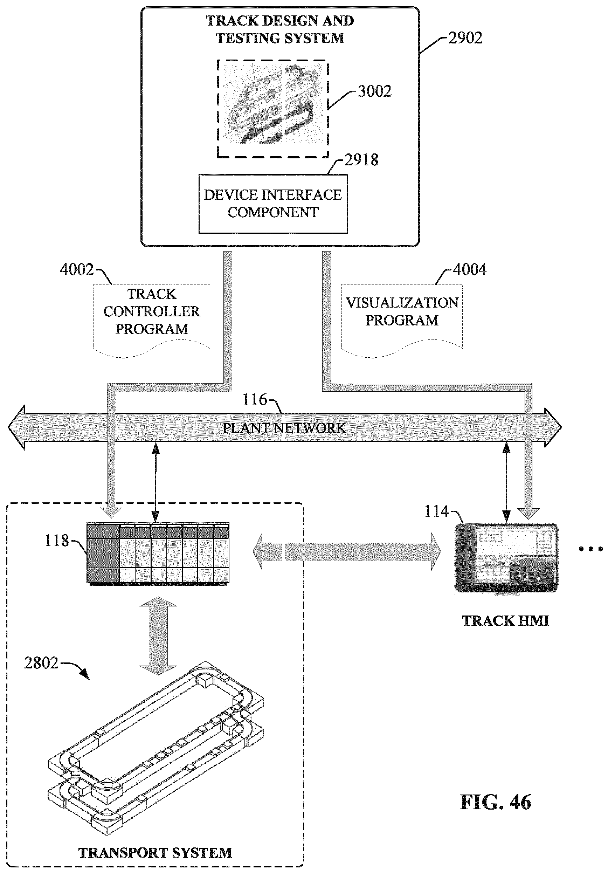

FIG. 46 is a diagram illustrating deployment of the track controller program 4002 and visualization program 4004 by the design and testing system 2902. In the example depicted in FIG. 46, the physical transport system 2802 is to be monitored and controlled by an industrial controller 118 that resides on a plant network 116. A track HMI terminal 114 for visualizing status and operational information for the transport system 2802 also resides on plant network 116. Upon completion of the transport system design and generation of a corresponding track controller program 4002 and visualization program 4004, as described above, the device interface component 2918 of the design and testing system 2902 can send the programs 4002 and 4004 to the controller 118 and HMI terminal 114 respectively over the plant network 114, thereby commissioning the control solution generated by the design and tracking system 2902. In some architectures, the design and testing system 2902 can reside on the same plant network 116 as the industrial controller 118 and HMI terminal 114, and all communication between these devices can take place over the network 116. Alternatively, if the design and tracking system 2902 executes on a cloud platform as a cloud-based service, the programs 4002 and 4004 can be deployed from the cloud platform to specified target devices on the plant floor.

As an alternative to deploying the programs 4002 and 4004 to controller 118 and HMI terminal 114 over network 116, the user may choose to download the programs 4002 and 4004 via direct connections to the controller 118 and HMI terminal 114 from the client device on which design and tracking system 2902 executes, or may choose to export programs 4002 and 4004 to another storage device used to commission the control solution to the relevant devices. Once deployed on controller 118, the track controller program 4002 controls the physical transport system 2802 in accordance with the design parameters encoded in the automation model 3002. Visualization program 4004, which was generated with appropriate links between graphical objects and their corresponding data items (e.g., smart objects 322 or data tags) in the track controller program 4002, renders status and operational information for the transport system 2802 during operation on one or more preformatted operator screens (e.g., the screens depicted in FIGs. 42-45).

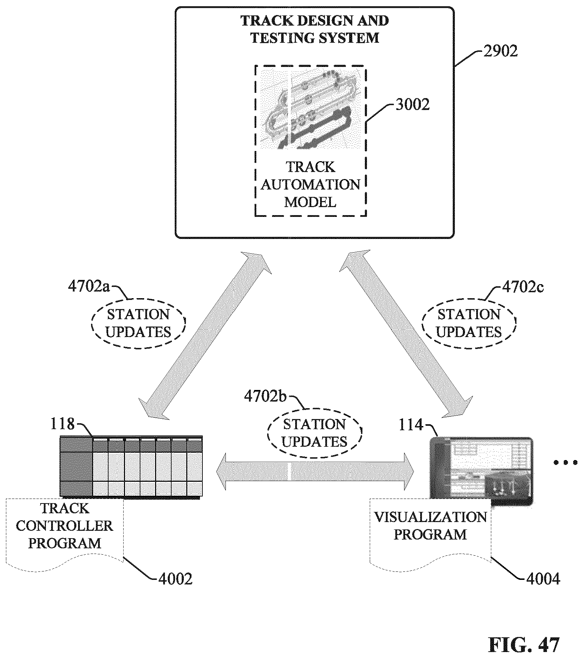

In some embodiments, after deployment of the transport control solution to the physical transport system, design and testing system 2902 can maintain consistency between the model 3002, the industrial controller 118, and the HMI terminal 114 in the event that design changes are implemented on any of these platforms. FIG. 47 is a diagram illustrating cascading of design changes between the model 3002 and the deployed control program 4002 and visualization program 4004. After the track control program 4002 and visualization program 4004 have been deployed and are executing on the plant floor, a system designer may choose to change a station design parameter, such as a velocity, acceleration, position, next target station, or other station properties. The architecture realized by the design and tracking system 2902 can allow such design modifications to be implemented by the system designer on any one of these three platforms - in the deployed control program 4002 using a program development application connected to the industrial controller 118, in the HMI program via interaction with the HMI terminal 114, or in the track automation model 3002 on the design and testing system 2902 - and the design changes will be automatically cascaded to the other platforms, thus ensuring that the designs remain synchronized between the three environments.

For example, an engineer in the plant facility may interface directly with the industrial controller 118 to modify an acceleration parameter for a selected station; e.g., by modifying the appropriate function block parameter of that stations Station instruction 4102. The device interface component 2918 of the design and testing system 2902 - which monitors the controller 118 and HMI terminal 114 over the plant network, either from within the plant facility or from a cloud platform - can detect and identify this modification, and in response, update its copy of the automation model 3002 as well as send a station update 4702 to the HMI terminal 114 to update the visualization program 4004 as needed. Depending on the nature of the station modification, the station update 4702 may alternatively be sent directly from the industrial controller 118 to the HMI terminal 114 rather than being relayed through the design and testing system 2902. Station updates 4702 can be similarly cascaded when the station updates are originated on either the design and testing system 2902 or the HMI terminal 114.

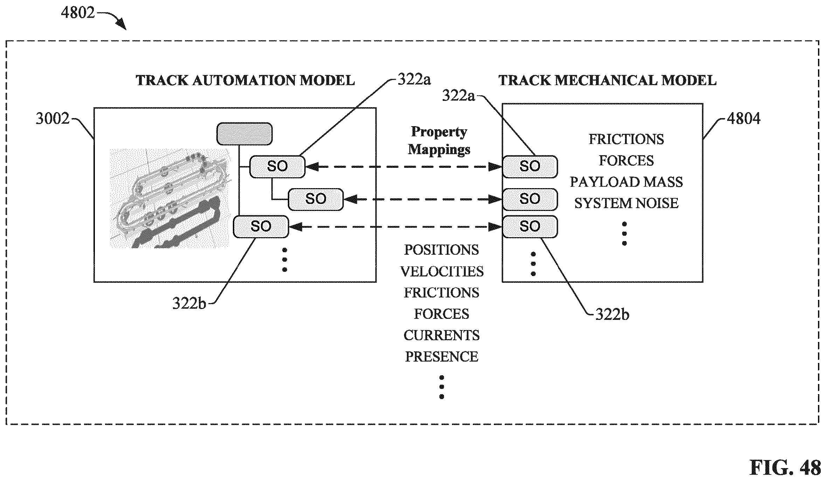

As noted above, the track automation model 3002 models the controls behavior of the physical transport system without factoring such physical properties as friction, payload mass, or system noise, or other hardware configurations such as PID loops. This allows creation of predictive models 3904 that are based purely on the process controls and behavior. To factor physical properties and hardware configurations that are not modeled by the automation model 3002, the automation model 3002 can be linked to a mechanical model or another type of streaming AI model that compensates for such factors as friction, payload mass, or system noise. FIG. 48 is a diagram illustrating integration of an automation model 3002 for the LSM transport system with a mechanical model 4804 to yield a digital twin 4802 of the transport system according to the invention. In this scenario, the track automation model 3002 can be considered a special type of asset model 422 similar to that described above in connection with FIG. 15, in that the automation model 3002 describes control properties of the transport system as contextualized and organized smart object (BIDT) data. Mechanical model 4804 may be similar to the mechanical models 1504 described above, and may define mechanical properties of the components that make up the transport system (e.g., coefficients of friction, inertias, etc.), as well as the transport system as a whole (e.g., system noise). Mechanical model 4804 may also define mechanical formulas representing mechanical transformations applied by components of the transport system (e.g., formulas representing torque, speed, or force translations). The combined automation model 3002 and mechanical model 4804 can be leveraged to yield a more holistic and comprehensive representation of the transport system, describing static control and mechanical properties of the transport system as well as dynamic control behaviors.

In some scenarios, the mechanical model 4804 may have been developed using the same object-based nomenclature as that of the object-based automation model 3002, similar to the model integration scenario described above in connection with FIG. 17. According to the invention, the use of smart objects 322 to define the automation model 3002 and the mechanical model 4804 allows the automation model 3002 to be easily integrated with the mechanical model 4804 by virtue of the common smart object nomenclature, as described above in connection with FIGs. 15-17. For example, in order to map a virtualized motor module of the automation model 3002 to a corresponding mechanical-domain property of the mechanical model 4804 (e.g., a coefficient of friction or a force translation formula), both the automation model 3002 and the mechanical model 4804 can be configured to reference the appropriate smart objects 322 corresponding to these elements and properties. In this way, properties can be easily mapped between the automation model 3002 and the mechanical model 4804 by virtue of common references to the smart objects 322 representing the properties. This allows the automation model 3002 and the mechanical model 4804 to understand each other based on common references to smart objects 322.

The combined automation model 3002 and mechanical model 4804 can serve as a digital twin 4802 of the LSM transport system capable of generating more comprehensive and high-fidelity information about the track's current and predicted operation than either of the two models could produce individually. This digital twin 4802 can be used in a variety of applications. For example, the digital twin 4802 can be used to drive a virtual simulation of the transport system in connection with testing the track design, to predict future asset behavior or play back past asset behaviors based on an analysis of historical data generated by the transport system, to perform live or historical operational analytics, or other such applications. Depending on the type of application performed by the digital twin 4802, the digital twin 4802 can be fed with live (real-time) data from the smart objects 322 during operation of the transport system or with historical time-series BIDT data generated and stored during prior operation of the transport system.

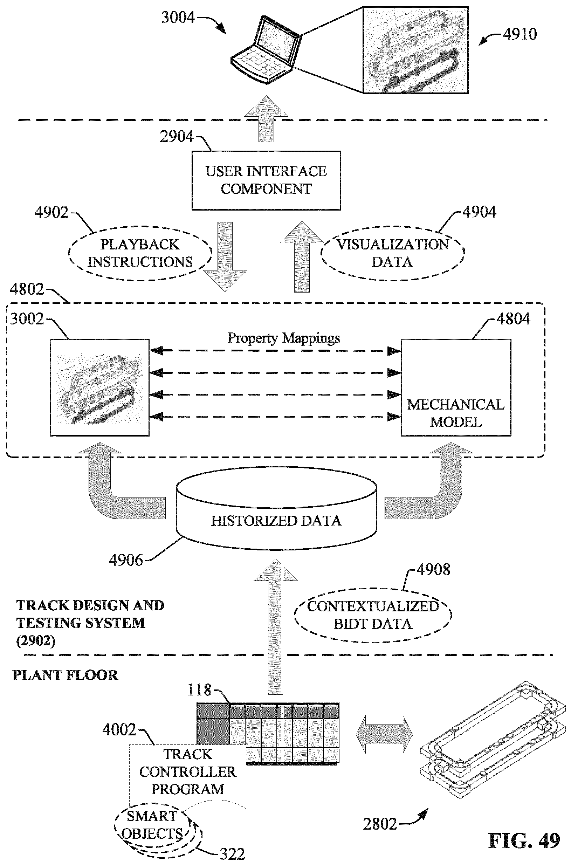

After deployment of the track controller program 4002 and visualization program 4004, the design and testing system 2902 can connect the automation model 3002 (or the digital twin 4802 comprising the automation model 3002 and a mechanical model 4804 or other type of streaming AI model) to the physical system for the purpose of visualizing and analyzing actual performance of the physical transport system. FIG. 49 is a diagram of an example architecture in which live data from the physical transport system 2802 is fed to the automation model 3002 for the purposes of live visualization and analytics. Although FIG. 49 depicts contextualized BIDT data 4908 from the running system being streamed to the digital twin 4802, which comprises both the automation model 3002 and the mechanical model 4804, in some scenarios the user may choose to leverage only the automation model 3002 for real-time visualization and analysis.

During runtime operation, the device interface component 2918 (not shown in FIG. 49) of the design and testing system 2902 can read live runtime data (e.g., contextualized BIDT data 4908) from the smart objects 322 or data tags of the industrial controller 116 as the controller 116 monitors and controls the transport system 2802 in accordance with the industrial control program 4002. The device interface component 2918 can provide this collected runtime data 4908 to the automation model 3002 (or digital twin 4802), and the system 2902 animates the automation model 3002 using the live data 4908 to yield visualization data 4904. User interface component 2904 can render this visualization data 4904 as a presentation 4910 on client device 3004. Presentation 4910 renders an animation of the model 3002 that is driven by the real-time contextualized BIDT data 4908 streamed from the controller 118 during operation of the transport system 2802, and graphically depicts substantially real-time operation of the transport system 2802, including the positions and movements of the movers 3104. In this way, viewers at remote locations can observe the current operation of the transport system 2802 as a high-fidelity virtualization.

Also, in some embodiments, the analytics component 2912 can validate the digital twin 4802 against the physical transport system 2802 based on analysis of the collected real-time data 4908, as described above in connection with FIG. 27.

Since the collected contextualized BIDT data 4908 can be stored in historized data storage 4906, the system 2902 can also allow the user to replay animations of past operation of the transport system 2802. For example, presentation 4910 may render playback controls that allow the user to submit playback instructions 4902 to the system 2902. These playback instructions 4902 can include an indication of a past start time for the playback, a speed of the playback, or other such playback instructions. Based on these playback instructions 4902, user interface 2904 can render, on presentation 4910, an animation of the model 3002 based on a subset of the historized BIDT data 4908 corresponding to the past timeframe of interest indicated by the user. In this way, the user can review past operation of the transport system 2802 within the virtual environment of the design and testing system 2902.

As part of either real-time visualization or historical playback, the presentation 4910 can also render performance metrics. These metrics can be generated based on analysis of the contextualized BIDT data 4908 by the analysis component 2912, and can include such performance metrics as station throughput statistics for each station, station starvation or congestion statistics, energy consumption, mover collision statistics, or other such metrics. These performance metrics can be similar to those calculated by the analytics component 2912 during the testing and simulation phase. Thus, the metrics generated in the virtualized environment of the design and testing system 2902 are agnostic with regard to whether the project application is connected to a transport system simulation or to the physical transport system.

During runtime, the analytics component 2912 can perform predictive analysis on transport system operation based on analysis of the BIDT data 4908 and the system properties encoded in the model 3002 or digital twin 4802. Analytics component 2912 can also analyze past and present BIDT data 4908 together with the system properties encoded in the automation model 3002 or digital twin 4802 in order to identify root causes of operational problems, such as deviations from expected transport system behavior. Thus, the models generated by the design and testing system 2902 can be used not only to optimize process control but also to isolate deviant behavior and narrow the search to specific process areas around the transport system 2802.

In some embodiments, any of the automation model 3002, the digital twin 4802, or the predictive models 3904 can be deployed in local process control solutions, cloud infrastructures, or containerized infrastructures in industrial controllers. This can allow the pre-trained models to be offered as a service for optimization of end-user's LSM transport systems. These trained models can be used to optimize control of the transport system 2802, either from a cloud platform or locally on the local control system.

Since smart objects 322 serve as the foundation for track automation model 3002 generated by the design and testing system 2902 (similar to the asset models 422 described above), the automation model 3002 can also be easily integrated into existing plant models 522, as discussed above in connection with FIG. 13.

The transport system design, in the form of automation model 3002, digital twin 4802, or predictive models 3904, can also be uploaded to a cloud platform and used to automate data mining, training, and deployment of AI models for optimization of the transport system control via an online service.

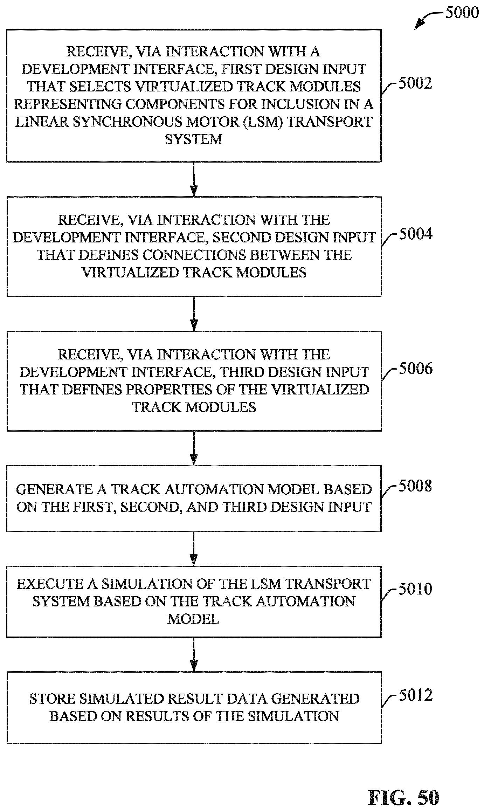

FIGs 50-52 illustrate various methodologies in accordance with one or more embodiments of the subject application. While, for purposes of simplicity of explanation, the one or more methodologies shown herein are shown and described as a series of acts, it is to be understood and appreciated that the subject innovation is not limited by the order of acts, as some acts may, in accordance therewith, occur in a different order and/or concurrently with other acts from that shown and described herein. For example, those skilled in the art will understand and appreciate that a methodology could alternatively be represented as a series of interrelated states or events, such as in a state diagram. Moreover, not all illustrated acts may be required to implement a methodology in accordance with the innovation. Furthermore, interaction diagram(s) may represent methodologies, or methods, in accordance with the subject disclosure when disparate entities enact disparate portions of the methodologies. Further yet, two or more of the disclosed example methods can be implemented in combination with each other, to accomplish one or more features or advantages described herein.

FIG. 50 illustrates an example methodology 5000 for developing and simulating a virtual model or digital twin of an LSM transport system. Initially, at 5002, first design input is received via interaction with a development interface. The first design input selects virtualized track modules representing components for inclusion in an LSM transport system. These virtualized track modules can represent, for example, straight motor modules, a curved motor modules, a track controllers, basic stations, grouping stations, distribution stations, merge nodes, diverge nodes, movers, right switches, left switches, station loaders, station shifters, terminals, or other such track components.

At 5004, second design input is received via the development interface. The second design input defines connections between the virtualized track modules selected at step 5002. At 5006, third design input is received via interaction with the development interface. The third design input defines properties of the virtualized track modules. These properties can include, but are not limited to, dwell times, path identifiers, station types, motor types, departure accelerations, departure velocities, identifiers of next target stations, or other such properties.

At 5008, a track automation model is generated based on the first, second, and third design input received at steps 5002-5006. At 5010, a simulation of the LSTM transport system is executed based on the track automation model generated at step 5008. At 5012, simulated result data generated based on results of the simulation are stored.

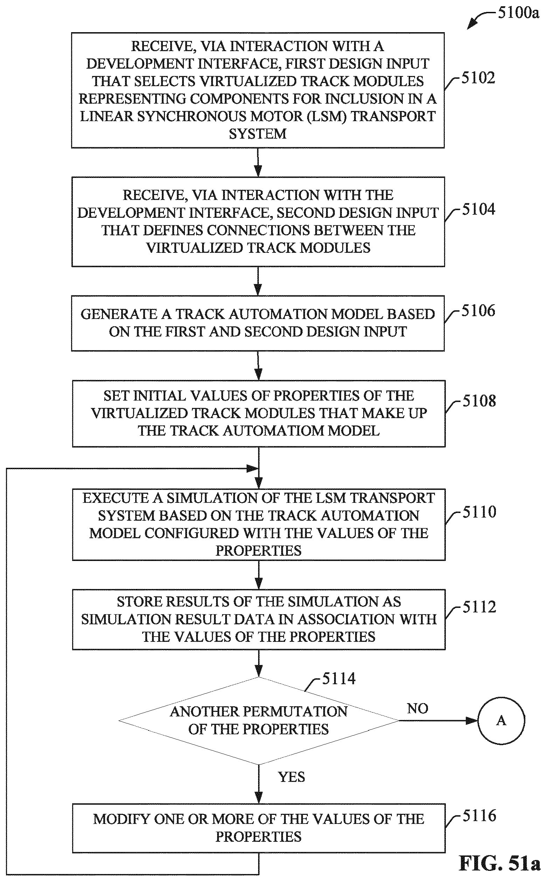

FIG. 51a illustrates a first part of an example methodology 5100a for identifying a set of configuration parameters for an LSM transport system by executing multiple simulations the transport system. Initially, at 5102, first design input is received via interaction with a development interface. The first design input selects virtualized track modules representing components for inclusion in an LSM transport system. At 5104, second design input is received via interaction with the development interface. The second design input defines connections between the virtualized track modules selected at step 5102. Steps 5102 and 5104 are similar to steps 5002 and 5004 of methodology 5000 described above.

At 5106, a track automation model is generated based on the first and second design input received at steps 5102 and 5104. At 5108, initial values of properties of the virtualized track modules that make up the track automation model are set. Properties that can be set in this step can include, but are not limited to, dwell times, path identifiers, station types, motor types, departure accelerations, departure velocities, identifiers of next target stations, or other such properties.

AT 5110, a simulation of the LSM transport system is executed based on the track automation model configured with the values of the properties set at step 5108. At 5112, results of the simulation are stored as simulation result data in association with the values of the properties used to generate the simulation results.

At 5114, a determination is made as to whether another permutation of the properties is to be simulated. If another permutation is to be simulated (YES at step 5114) the methodology proceeds to step 5116, where one or more of the values of the properties are modified. The methodology then returns to step 5110, where the LSTM transport system is simulated again based on the track automation module, this time configured with the values of the properties as modified at step 5116. The results of this simulation are stored at step 5112 in association with the modified values of the properties that gave rise to the results.

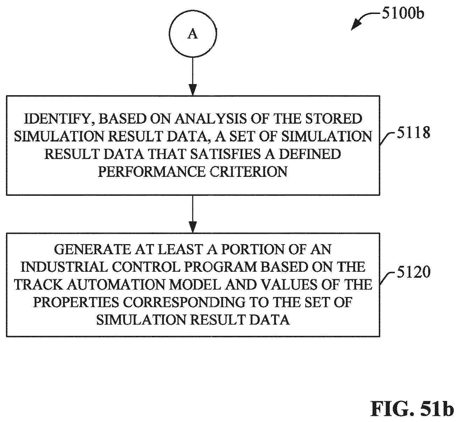

Steps 5110-5116 repeat until simulations for all permutations of the property values that are to be simulated have been performed (NO at step 5114), at which time the methodology proceeds to the second part 5100b illustrated in FIG. 51b.

At 5118, based on analysis of the stored simulation result data, a set of simulation result data that satisfies a defined performance criterion is satisfied. The performance criterion can be defined in terms of such performance metrics as station throughput, station starvation or congestion statistics, energy consumption for the track as a whole, mover collision statistics, or other such metrics. At 5120, at least a portion of an industrial control program is generated based on the track automation model and values of the properties corresponding to the set of simulation result data selected at step 5118.

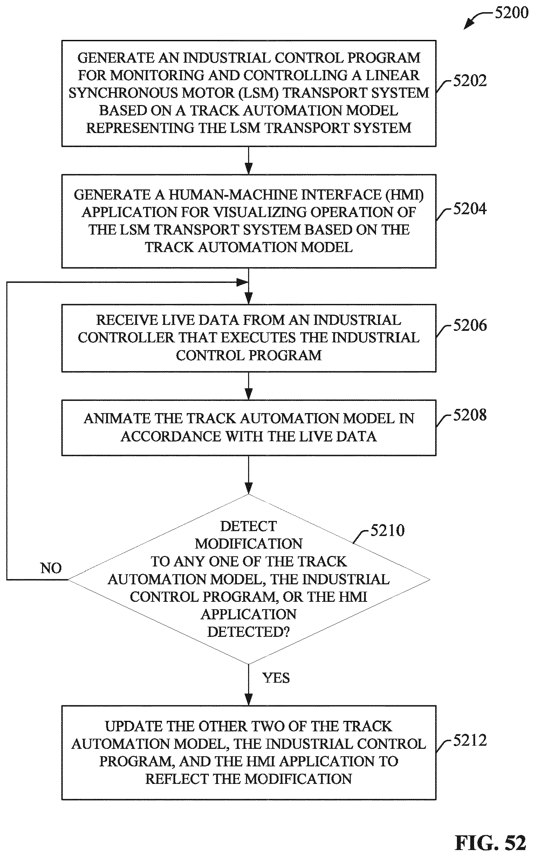

FIG. 52 illustrates example methodology 5200 for cascading design changes between a virtual model or digital twin of an LSM transport system, a control program that monitors and controls the transport system, and a human-machine interface (HMI) application that visualizes operation of the transport system. Initially, at 5202, an industrial control program for monitoring and controlling an LSM transport system is generated based on a track automation model representing the LSM transport system. In some scenarios, the control program can be generated using methodologies 5100a and 5100b described above. The control program can be executed on an industrial controller to facilitate monitoring and control of the track system.

At 5204, an HMI application for visualizing operation of the transport system is generated based on the track automation model. The HMI application can be configured to execute on an HMI terminal located near the track system and to visualize operation of the track system based on data received from the industrial controller executing the control program generated at step 5202.

At 5206, live data is received from the industrial controller that executes the control program. At 5208, the track automation model is animated in accordance with the live data received at step 5206. This allows the performance of the track system to be observed and measured from the development interface used to generate the automation model.

At 5210, a determination is made as to whether any one of the track automation model, the industrial control program, or the HMI application has been modified. If no such modifications are detected (NO at step 5210), the methodology returns to step 5206 and animation of the track automation model continues. If a modification to any of the track automation model, the control program, or the HMI application is detected (YES at step 5210), the methodology proceeds to step 5212, where the other two of the track automation model, the control program, and the HMI application are updated to reflect the modification detected at step 5210.

Embodiments, systems, and components described herein, as well as control systems and automation environments in which various aspects set forth in the subject specification can be carried out, can include computer or network components such as servers, clients, programmable logic controllers (PLCs), automation controllers, communications modules, mobile computers, on-board computers for mobile vehicles, wireless components, control components and so forth which are capable of interacting across a network. Computers and servers include one or more processors-electronic integrated circuits that perform logic operations employing electric signals-configured to execute instructions stored in media such as random access memory (RAM), read only memory (ROM), hard drives, as well as removable memory devices, which can include memory sticks, memory cards, flash drives, external hard drives, and so on.

Similarly, the term PLC or automation controller as used herein can include functionality that can be shared across multiple components, systems, and/or networks. As an example, one or more PLCs or automation controllers can communicate and cooperate with various network devices across the network. This can include substantially any type of control, communications module, computer, Input/Output (I/O) device, sensor, actuator, and human machine interface (HMI) that communicate *via* the network, which includes control, automation, and/or public networks. The PLC or automation controller can also communicate to and control various other devices such as standard or safety-rated I/O modules including analog, digital, programmed/intelligent I/O modules, other programmable controllers, communications modules, sensors, actuators, output devices, and the like.

The network can include public networks such as the internet, intranets, and automation networks such as control and information protocol (CIP) networks including DeviceNet, ControlNet, safety networks, and Ethernet/IP. Other networks include Ethernet, DH/DH+, Remote I/O, Fieldbus, Modbus, Profibus, CAN, wireless networks, serial protocols, and so forth. In addition, the network devices can include various possibilities (hardware and/or software components). These include components such as switches with virtual local area network (VLAN) capability, LANs, WANs, proxies, gateways, routers, firewalls, virtual private network (VPN) devices, servers, clients, computers, configuration tools, monitoring tools, and/or other devices.

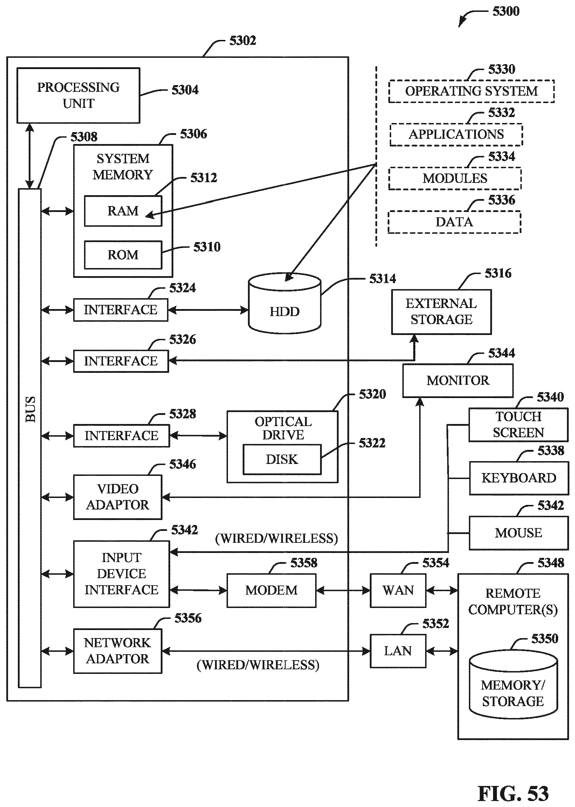

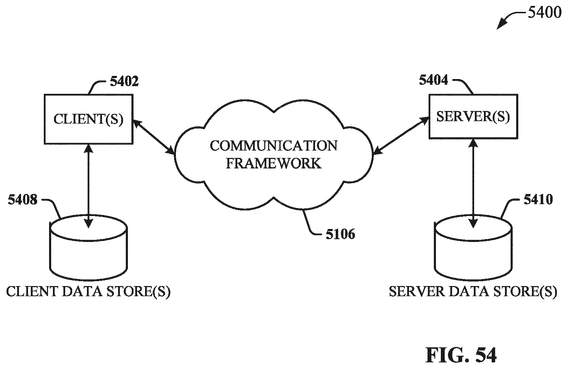

In order to provide a context for the various aspects of the disclosed subject matter, FIGs. 53 and 54 as well as the following discussion are intended to provide a brief, general description of a suitable environment in which the various aspects of the disclosed subject matter may be implemented. While the embodiments have been described above in the general context of computer-executable instructions that can run on one or more computers, those skilled in the art will recognize that the embodiments can be also implemented
as a combination of hardware and software.

Generally, program modules include routines, programs, components, data structures, etc., that perform particular tasks or implement particular abstract data types. Moreover, those skilled in the art will appreciate that the inventive methods can be practiced with other computer system configurations, including single-processor or multiprocessor computer systems, minicomputers, mainframe computers, Internet of Things (IoT) devices, distributed computing systems, as well as personal computers, hand-held computing devices, microprocessor-based or programmable consumer electronics, and the like, each of which can be operatively coupled to one or more associated devices.

The illustrated embodiments herein can be also practiced in distributed computing environments where certain tasks are performed by remote processing devices that are linked through a communications network. In a distributed computing environment, program modules can be located in both local and remote memory storage devices.

Computing devices typically include a variety of media, which can include computer-readable storage media, machine-readable storage media, and/or communications media, which two terms are used herein differently from one another as follows. Computer-readable storage media or machine-readable storage media can be any available storage media that can be accessed by the computer and includes both volatile and nonvolatile media, removable and non-removable media. By way of example, and not limitation, computer-readable storage media or machine-readable storage media can be implemented in connection with any method or technology for storage of information such as computer-readable or machine-readable instructions, program modules, structured data or unstructured data.

Computer-readable storage media can include, but are not limited to, random access memory (RAM), read only memory (ROM), electrically erasable programmable read only memory (EEPROM), flash memory or other memory technology, compact disk read only memory (CD-ROM), digital versatile disk (DVD), Blu-ray disc (BD) or other optical disk storage, magnetic cassettes, magnetic tape, magnetic disk storage or other magnetic storage devices, solid state drives or other solid state storage devices, or other tangible and/or non-transitory media which can be used to store desired information. In this regard, the terms "tangible" or "non-transitory" herein as applied to storage, memory or computer-readable media, are to be understood to exclude only propagating transitory signals per se as modifiers and do not relinquish rights to all standard storage, memory or computer-readable media that are not only propagating transitory signals per se.

Computer-readable storage media can be accessed by one or more local or remote computing devices, e.g., via access requests, queries or other data retrieval protocols, for a variety of operations with respect to the information stored by the medium.

Communications media typically embody computer-readable instructions, data structures, program modules or other structured or unstructured data in a data signal such as a modulated data signal, e.g., a carrier wave or other transport mechanism, and includes any information delivery or transport media. The term "modulated data signal" or signals refers to a signal that has one or more of its characteristics set or changed in such a manner as to encode information in one or more signals. By way of example, and not limitation, communication media include wired media, such as a wired network or direct-wired connection, and wireless media such as acoustic, RF, infrared and other wireless media.

With reference again to FIG. 53, the example environment 5300 for implementing various embodiments of the aspects described herein includes a computer 5302, the computer 5302 including a processing unit 5304, a system memory 5306 and a system bus 5308. The system bus 5308 couples system components including, but not limited to, the system memory 5306 to the processing unit 5304. The processing unit 5304 can be any of various commercially available processors. Dual microprocessors and other multi-processor architectures can also be employed as the processing unit 5304.

The system bus 5308 can be any of several types of bus structure that can further interconnect to a memory bus (with or without a memory controller), a peripheral bus, and a local bus using any of a variety of commercially available bus architectures. The system memory 5306 includes ROM 5310 and RAM 5312. A basic input/output system (BIOS) can be stored in a non-volatile memory such as ROM, erasable programmable read only memory (EPROM), EEPROM, which BIOS contains the basic routines that help to transfer information between elements within the computer 5302, such as during startup. The RAM 5312 can also include a highspeed RAM such as static RAM for caching data.

The computer 5302 further includes an internal hard disk drive (HDD) 5314 (e.g., EIDE, SATA), one or more external storage devices 5316 (e.g., a magnetic floppy disk drive (FDD) 5316, a memory stick or flash drive reader, a memory card reader, etc.) and an optical disk drive 5320 (e.g., which can read or write from a CD-ROM disc, a DVD, a BD, etc.). While the internal HDD 5314 is illustrated as located within the computer 5302, the internal HDD 5314 can also be configured for external use in a suitable chassis (not shown). Additionally, while not shown in environment 5300, a solid state drive (SSD) could be used in addition to, or in place of, an HDD 5314. The HDD 5314, external storage device(s) 5316 and optical disk drive 5320 can be connected to the system bus 5308 by an HDD interface 5324, an external storage interface 5326 and an optical drive interface 5328, respectively. The interface 5324 for external drive implementations can include at least one or both of Universal Serial Bus (USB) and Institute of Electrical and Electronics Engineers (IEEE) 1394 interface technologies. Other external drive connection technologies are within contemplation of the embodiments described herein.

The drives and their associated computer-readable storage media provide nonvolatile storage of data, data structures, computer-executable instructions, and so forth. For the computer 5302, the drives and storage media accommodate the storage of any data in a suitable digital format. Although the description of computer-readable storage media above refers to respective types of storage devices, it should be appreciated by those skilled in the art that other types of storage media which are readable by a computer, whether presently existing or developed in the future, could also be used in the example operating environment, and further, that any such storage media can contain computer-executable instructions for performing the methods described herein.

A number of program modules can be stored in the drives and RAM 5312, including an operating system 5330, one or more application programs 5332, other program modules 5334 and program data 5336. All or portions of the operating system, applications, modules, and/or data can also be cached in the RAM 5312. The systems and methods described herein can be implemented utilizing various commercially available operating systems or combinations of operating systems.

Computer 5302 can optionally comprise emulation technologies. For example, a hypervisor (not shown) or other intermediary can emulate a hardware environment for operating system 5330, and the emulated hardware can optionally be different from the hardware illustrated in FIG. 53. In such an embodiment, operating system 5330 can comprise one virtual machine (VM) of multiple VMs hosted at computer 5302. Furthermore, operating system 5330 can provide runtime environments, such as the Java runtime environment or the .NET framework, for application programs 5332. Runtime environments are consistent execution environments that allow application programs 5332 to run on any operating system that includes the runtime environment. Similarly, operating system 5330 can support containers, and application programs 5332 can be in the form of containers, which are lightweight, standalone, executable packages of software that include, e.g., code, runtime, system tools, system libraries and settings for an application.

Further, computer 5302 can be enable with a security module, such as a trusted processing module (TPM). For instance with a TPM, boot components hash next in time boot components, and wait for a match of results to secured values, before loading a next boot component. This process can take place at any layer in the code execution stack of computer 5302, e.g., applied at the application execution level or at the operating system (OS) kernel level, thereby enabling security at any level of code execution.

A user can enter commands and information into the computer 5302 through one or more wired/wireless input devices, e.g., a keyboard 5338, a touch screen 5340, and a pointing device, such as a mouse 5342. Other input devices (not shown) can include a microphone, an infrared (IR) remote control, a radio frequency (RF) remote control, or other remote control, a joystick, a virtual reality controller and/or virtual reality headset, a game pad, a stylus pen, an image input device, e.g., camera(s), a gesture sensor input device, a vision movement sensor input device, an emotion or facial detection device, a biometric input device, e.g., fingerprint or iris scanner, or the like. These and other input devices are often connected to the processing unit 5304 through an input device interface 5344 that can be coupled to the system bus 5308, but can be connected by other interfaces, such as a parallel port, an IEEE 1394 serial port, a game port, a USB port, an IR interface, a BLUETOOTH^{®} interface, etc.

A monitor 5344 or other type of display device can be also connected to the system bus 5308 via an interface, such as a video adapter 5348. In addition to the monitor 5344, a computer typically includes other peripheral output devices (not shown), such as speakers, printers, etc.

The computer 5302 can operate in a networked environment using logical connections via wired and/or wireless communications to one or more remote computers, such as a remote computer(s) 5348. The remote computer(s) 5348 can be a workstation, a server computer, a router, a personal computer, portable computer, microprocessor-based entertainment appliance, a peer device or other common network node, and typically includes many or all of the elements described relative to the computer 5302, although, for purposes of brevity, only a memory/storage device 5350 is illustrated. The logical connections depicted include wired/wireless connectivity to a local area network (LAN) 5352 and/or larger networks, e.g., a wide area network (WAN) 5354. Such LAN and WAN networking environments are commonplace in offices and companies, and facilitate enterprise-wide computer networks, such as intranets, all of which can connect to a global communications network, e.g., the Internet.

When used in a LAN networking environment, the computer 5302 can be connected to the local network 5352 through a wired and/or wireless communication network interface or adapter 5356. The adapter 5356 can facilitate wired or wireless communication to the LAN 5352, which can also include a wireless access point (AP) disposed thereon for communicating with the adapter 5356 in a wireless mode.

When used in a WAN networking environment, the computer 5302 can include a modem 5358 or can be connected to a communications server on the WAN 5354 via other means for establishing communications over the WAN 5354, such as by way of the Internet. The modem 5358, which can be internal or external and a wired or wireless device, can be connected to the system bus 5308 via the input device interface 5342. In a networked environment, program modules depicted relative to the computer 5302 or portions thereof, can be stored in the remote memory/storage device 5350. It will be appreciated that the network connections shown are example and other means of establishing a communications link between the computers can be used.

When used in either a LAN or WAN networking environment, the computer 5302 can access cloud storage systems or other network-based storage systems in addition to, or in place of, external storage devices 5316 as described above. Generally, a connection between the computer 5302 and a cloud storage system can be established over a LAN 5352 or WAN 5354 e.g., by the adapter 5356 or modem 5358, respectively. Upon connecting the computer 5302 to an associated cloud storage system, the external storage interface 5326 can, with the aid of the adapter 5356 and/or modem 5358, manage storage provided by the cloud storage system as it would other types of external storage. For instance, the external storage interface 5326 can be configured to provide access to cloud storage sources as if those sources were physically connected to the computer 5302.

The computer 5302 can be operable to communicate with any wireless devices or entities operatively disposed in wireless communication, e.g., a printer, scanner, desktop and/or portable computer, portable data assistant, communications satellite, any piece of equipment or location associated with a wirelessly detectable tag (e.g., a kiosk, news stand, store shelf, etc.), and telephone. This can include Wireless Fidelity (Wi-Fi) and BLUETOOTH^{®} wireless technologies. Thus, the communication can be a predefined structure as with a conventional network or simply an ad hoc communication between at least two devices.

FIG. 54 is a schematic block diagram of a sample computing environment 5400 with which the disclosed subject matter can interact. The sample computing environment 5400 includes one or more client(s) 5402. The client(s) 5402 can be hardware and/or software (e.g., threads, processes, computing devices). The sample computing environment 5400 also includes one or more server(s) 5404. The server(s) 5404 can also be hardware and/or software (e.g., threads, processes, computing devices). The servers 504 can house threads to perform transformations by employing one or more embodiments as described herein, for example. One possible communication between a client 5402 and servers 5404 can be in the form of a data packet adapted to be transmitted between two or more computer processes. The sample computing environment 5400 includes a communication framework 5406 that can be employed to facilitate communications between the client(s) 5402 and the server(s) 5404. The client(s) 5402 are operably connected to one or more client data store(s) 5408 that can be employed to store information local to the client(s) 5402. Similarly, the server(s) 5404 are operably connected to one or more server data store(s) 5410 that can be employed to store information local to the servers 5404.

What has been described above includes examples of the subject innovation. It is, of course, not possible to describe every conceivable combination of components or methodologies for purposes of describing the disclosed subject matter, but one of ordinary skill in the art may recognize that many further combinations and permutations of the subject innovation are possible. Accordingly, the disclosed subject matter is intended to embrace all such alterations, modifications, and variations that fall within the scope of the appended claims.

In particular and in regard to the various functions performed by the above described components, devices, circuits, systems and the like, the terms (including a reference to a "means") used to describe such components are intended to correspond, unless otherwise indicated, to any component which performs the specified function of the described component (e.g., a functional equivalent), even though not structurally equivalent to the disclosed structure, which performs the function in the herein illustrated exemplary aspects of the disclosed subject matter. In this regard, it will also be recognized that the disclosed subject matter includes a system as well as a computer-readable medium having computer-executable instructions for performing the acts and/or events of the various methods of the disclosed subject matter.

In addition, while a particular feature of the disclosed subject matter may have been disclosed with respect to only one of several implementations, such feature may be combined with one or more other features of the other implementations as may be desired and advantageous for any given or particular application. Furthermore, to the extent that the terms "includes," and "including" and variants thereof are used in either the detailed description or the claims, these terms are intended to be inclusive in a manner similar to the term "comprising."

In this application, the word "exemplary" is used to mean serving as an example, instance, or illustration. Any aspect or design described herein as "exemplary" is not necessarily to be construed as preferred or advantageous over other aspects or designs. Rather, use of the word exemplary is intended to present concepts in a concrete fashion.

Various aspects or features described herein may be implemented as a method, apparatus, or article of manufacture using standard programming and/or engineering techniques. The term "article of manufacture" as used herein is intended to encompass a computer program accessible from any computer-readable device, carrier, or media. For example, computer readable media can include but are not limited to magnetic storage devices (e.g., hard disk, floppy disk, magnetic strips...), optical disks [e.g., compact disk (CD), digital versatile disk (DVD)...], smart cards, and flash memory devices (e.g., card, stick, key drive...).

## Claims

1. A system, comprising:
a memory that stores executable components; and
a processor, operatively coupled to the memory, that executes the executable components, the executable components comprising:
a user interface component (2904) configured to render a development interface that facilitates design of a linear synchronous motor, LSM, transport system, and to receive design input via interaction with the development interface, wherein the design input selects virtualized track modules representing components for inclusion in the LSM transport system and defines connections between the virtualized track modules, wherein a virtualized track module, of the virtualized track modules, defines at least one of a three-dimensional visual representation of a corresponding track component, dimensions of the corresponding track component, and one or more physical properties of the corresponding track component, and wherein the design input further defines properties of the virtualized track modules that correspond to properties of the corresponding track components;
a model generation component (2906) configured to generate a track automation model (3002) for the LSM transport system based on the design input, the track automation model (3002) for the LSM transport system being integrated with a mechanical model (4804) to yield a digital twin (4802), wherein smart objects (322) are used to define the track automation model and the mechanical model, the smart objects being adapted to store data values, statuses, events or other properties that are measured, and wherein the track automation model is leveraged to generate a control and visualization programming to be used to implement a track control solution on the physical LSM transport system;
a simulation component (2908) configured to execute a simulation of the LSM transport system based on the track automation model, and to store simulated result data generated based on a result of the simulation; and
an artificial intelligence, AI, engine component (514) configured to modify some or all of the smart objects that make up the digital twin to add AI contextualization metadata in the form of additional fields or properties, wherein the additional fields or properties encode learned relationships between modeled variables that are not already defined in the digital twin.

2. The system of claim 1, at least one of:
wherein the virtualized track modules represent at least one of a straight motor module, a curved motor module, a track controller, a basic station, a grouping station, a distribution station, a merge node, a diverge node, a mover, a right switch, a left switch, a station loader, a station shifter, or a terminal; and
wherein the simulated result data comprises at least one of process times for respective stations defined in the track automation model, mover arrival times for the respective stations, mover throughput statistics, mover queuing statistics, or mover distribution statistics.

3. The system of claim 1 or 2, wherein the virtualized track module, of the virtualized track modules further defines a controller code segment for controlling the corresponding track component.

4. The system of claim 1, wherein
the properties comprise at least one of a dwell time, a path identifier, a station type, a motor type, a departure acceleration, a departure velocity, or an identifier of a next target station.

5. The system of claim 4, wherein
the model generation component is configured to set values of one or more of the properties in accordance with a subset of the design input received via interaction with the virtualized track modules, and
the simulation component is configured to execute the simulation in accordance with the values of the one or more properties.

6. The system of claim 4 or 5, wherein the simulation component is further configured to execute multiple simulations of the LSM transport system, based on the track automation model, for multiple permutations of values of the properties, and to store multiple sets of the simulated result data respectively corresponding to the multiple permutations of values of the properties.

7. The system of claim 6, further comprising an analytics component configured to identify a set of simulated result data, of the multiple sets of the simulated result data, that satisfies a performance criterion specified by the design input, and to set values of the properties based on a permutation of values, of the multiple permutations, that yielded the set of simulated result data.

8. The system of claim 7, further comprising a program generation component configured to generate an industrial control program based on the track automation model and the values of the properties,
wherein the industrial control program comprises at least a station instruction corresponding to a station defined in the track automation model, and the station instruction comprises parameters that correspond to the values of the properties.

9. The system of claim 7 or 8, further comprising a human-machine interface, HMI, component configured to generate a visualization program configured to visualize operation of the LSM transport system based on the track automation model and the values of the properties.

10. The system of claim 8, further comprising a device interface component configured to retrieve live data from an industrial controller that executes the industrial control program to facilitate monitoring and control of the LSM system,
wherein the user interface component is configured to render an animation of the track automation model based on the live data,
wherein the device interface component is further configured to, in response to detection of a modification to the industrial control program implemented on the industrial controller, update at least one of the track automation model or a visualization program that executes on a human-machine interface, HMI, terminal to reflect the modification.

11. A method for simulating linear synchronous motor, LSM, transport systems, comprising:
rendering, by a system comprising a processor, a development interface (2904) that facilitates design of an LSM transport system;
receiving, by the system via interaction with the development interface, design input that selects virtualized track modules representing components for inclusion in the LSM transport system and defines connections between the virtualized track modules, wherein a virtualized track module, of the virtualized track modules, defines at least one of a three-dimensional visual representation of a corresponding track component, dimensions of the corresponding track component, and one or more physical properties of the corresponding track component, and wherein the design input further defines properties of the virtualized track modules that correspond to properties of the corresponding track components;
generating, by the system, a track automation model (3002) for the LSM transport system based on the design input, the track automation model (3002) for the LSM transport system being integrated with a mechanical model (4804) to yield a digital twin (4802), wherein smart objects (322) are used to define the track automation model and the mechanical model, the smart objects being adapted to store data values, statuses, events or other properties that are measured, and wherein the track automation model is leveraged to generate a control and visualization programming to be used to implement a track control solution on the physical LSM transport system;
executing, by the system, a simulation of the LSM transport system based on the track automation model; and
storing, by the system, simulated result data generated based on a result of the simulation;
the method further comprising:
modifying some or all of the smart objects that make up the digital twin to add AI contextualization metadata in the form of additional fields or properties, wherein the additional fields or properties encode learned relationships between modeled variables that are not already defined in the digital twin.

12. The method of claim 11, wherein the storing comprises storing at least one of process times for respective stations defined in the track automation model, mover arrival times for the respective stations, mover throughput statistics, mover queuing statistics, or mover distribution statistics.

13. The method of claim 11 or 12, wherein the one or more properties comprising at least one of a dwell time, a path identifier, a station type, a motor type, a departure acceleration, a departure velocity, or an identifier of a next target station,
wherein
the executing of the simulation comprises executing multiple simulations of the LSM transport system, based on the track automation model, for multiple permutations of values of the one or more properties, and
the storing comprises storing multiple sets of the simulated result data respectively corresponding to the multiple permutations of values of the one or more properties, and
the method further comprising:
identifying, by the system, a set of simulated result data, of the multiple sets of the simulated result data, that satisfies a performance criterion specified by the design input; and
setting, by the system, values of the one or more properties based on a permutation of values, of the multiple permutations, that yielded the set of simulated result data.

14. A non-transitory computer-readable medium having stored thereon instructions that, in response to execution by a processor of a system, cause the system to perform operations, the operations comprising:
rendering a development interface (2904) that facilitates design of a linear synchronous motor, LSM, transport system;
receiving, via interaction with the development interface, design input that selects virtualized track modules representing components for inclusion in the LSM transport system and defines connections between the virtualized track modules, wherein a virtualized track module, of the virtualized track modules, defines at least one of a three-dimensional visual representation of a corresponding track component, dimensions of the corresponding track component, and one or more physical properties of the corresponding track component, and wherein the design input further defines properties of the virtualized track modules that correspond to properties of the corresponding track components;
generating a track automation model (3002) for the LSM transport system based on the design input, the track automation model (3002) for the LSM transport system being integrated with a mechanical model (4804) to yield a digital twin (4802), wherein smart objects (322) are used to define the track automation model and the mechanical model, the smart objects being adapted to store data values, statuses, events or other properties that are measured, and wherein the track automation model is leveraged to generate a control and visualization programming to be used to implement a track control solution on the physical LSM transport system;
executing a simulation of the LSM transport system based on the track automation model; and
storing simulated result data generated based on a result of the simulation;
the operations further comprising:
modifying some or all of the smart objects that make up the digital twin to add AI contextualization metadata in the form of additional fields or properties, wherein the additional fields or properties encode learned relationships between modeled variables that are not already defined in the digital twin.

15. The non-transitory computer-readable medium of claim 14, wherein the storing comprises storing at least one of process times for respective stations defined in the track automation model, mover arrival times for the respective stations, mover throughput statistics, mover queuing statistics, or mover distribution statistics.

## Patentansprüche

1. Ein System, das aufweist:
einen Speicher, der ausführbare Bauteile speichert; und
einen Prozessor, der operativ mit dem Speicher gekoppelt ist, der die ausführbaren Bauteile ausführt, wobei die ausführbaren Bauteile aufweisen:
eine Benutzer-Schnittstellenkomponente (2904), die so konfiguriert ist, dass sie eine Entwicklungsschnittstelle wiedergibt, die den Entwurf eines LSM-Transportsystems (Linearer Synchronmotor) erleichtert, und dass sie Designeingaben über eine Interaktion mit der Entwicklungsschnittstelle empfängt, wobei die Designeingabe virtualisierte Schienenmodule auswählt, die Komponenten zur Aufnahme in das LSM-Transportsystem darstellen, und Verbindungen zwischen den virtualisierten Schienenmodulen definiert, wobei ein virtualisiertes Schienemodul der virtualisierten Schienemodule mindestens eine dreidimensionale visuelle Darstellung einer entsprechenden Schienenkomponente, Abmessungen der entsprechenden Schienenkomponente und eine oder mehrere physikalische Eigenschaften der entsprechenden Schienenkomponente definiert, und wobei die Designeingabe ferner Eigenschaften der virtualisierten Schienemodule definiert, die den Eigenschaften der entsprechenden Schienenkomponenten entsprechen;
eine Modellgenerierungskomponente (2906), die so konfiguriert ist, dass sie ein Schiene-Automatisierungsmodell (3002) für das LSM-Transportsystem auf der Basis der Designeingabe erzeugt, wobei das Schiene-Automatisierungsmodell (3002) für das LSM-Transportsystem mit einem mechanischen Modell (4804) integriert wird, um einen digitalen Zwilling (4802) zu erzeugen, wobei intelligente Objekte (322) verwendet werden, um das Schiene-Automatisierungsmodell und das mechanische Modell zu definieren, wobei die intelligenten Aufgaben (322) verwendet werden, um das Schiene-Automatisierungsmodell und das mechanische Modell zu definieren, wobei die intelligenten Aufgaben angepasst sind, um Datenwerte, Zustände, Ereignisse oder andere Eigenschaften, die gemessen werden, zu speichern, und wobei das Schiene-Automatisierungsmodell genutzt wird, um eine Steuerungs- und Visualisierungsprogrammierung zu erzeugen, die verwendet werden soll, um eine Schiene-Steuerungslösung auf dem physischen LSM-Transportsystem zu implementieren;
eine Simulationskomponente (2908), die so konfiguriert ist, dass sie eine Simulation des LSM-Transportsystems auf der Basis des Schiene-Automatisierungsmodells ausführt und simulierte Ergebnisdaten speichert, die auf der Basis eines Ergebnisses der Simulation erzeugt wurden; und
ein Bauteil (514) mit künstlicher Intelligenz (AI), das so konfiguriert ist, dass es einige oder alle intelligenten Aufgaben, aus denen der digitale Zwilling besteht, modifiziert, um Al-Kontextualisierungs-Metadaten in Form von zusätzlichen Feldern oder Eigenschaften hinzuzufügen, wobei die zusätzlichen Felder oder Eigenschaften gelernte Beziehungen zwischen modellierten Variablen kodieren, die nicht bereits im digitalen Zwilling definiert sind.

2. Das System nach Anspruch 1, mit mindestens einem der folgenden Merkmale:
wobei die virtualisierten Steuerungsmodule mindestens eines von einem geraden Motormodul, einem gebogenen Motormodul, einer Steuerungseinheit, einem Basisbahnhof, einem Gruppierungsbahnhof, einem Verteilerbahnhof, einem Zusammenführungsknoten, einem Abzweigungsknoten, einem Beweger, einer rechten Weiche, einer linken Weiche, einem Bahnhofslader, einem Bahnhofsverschieber oder einem Anschluss darstellen; und
wobei die simulierten Ergebnisdaten mindestens eines der folgenden Elemente aufweist: Prozesszeiten für jeweilige Stationen, die in dem Schiene-Automatisierungsmodell definiert sind, Bewegungs-Ankunftszeiten für die jeweiligen Stationen, Bewegungs-Durchsatzstatistiken, Bewegungs-Warteschlangenstatistiken oder Bewegungs-Verteilungsstatistiken.

3. Das System nach Anspruch 1 oder 2, wobei das virtualisierte Gleismodul der virtualisierten Gleismodule ferner ein Steuereinheit-Code-Segment zur Steuerung der entsprechenden Schiene definiert.

4. Das System nach Anspruch 1, wobei
die Eigenschaften mindestens eine von einer Verweilzeit, einer Pfadkennung, einem Stationstyp, einem Motortyp, einer Abfahrtsbeschleunigung, einer Abfahrtsgeschwindigkeit oder einer Kennung einer nächsten Zielstation aufweisen.

5. Das System nach Anspruch 4, wobei
die Modellgenerierungskomponente so konfiguriert ist, dass sie Werte einer oder mehrerer der Eigenschaften in Übereinstimmung mit einer Teilmenge der Designeingabe einstellt, die über die Interaktion mit den virtualisierten Schienenmodulen empfangen wird, und
das Bauteil zur Simulation so konfiguriert ist, dass es die Simulation in Übereinstimmung mit den Werten der einen oder mehreren Eigenschaften ausführt.

6. Das System nach Anspruch 4 oder 5, wobei das Bauteil für die Simulation ferner so konfiguriert ist, dass es mehrere Simulationen des LSM-Transportsystems auf der Basis des Schiene-Automatisierungsmodells für mehrere Permutationen von Werten der Eigenschaften ausführt und mehrere Sätze der simulierten Ergebnisdaten speichert, die jeweils den mehreren Permutationen von Werten der Eigenschaften entsprechen.

7. Das System nach Anspruch 6 weist ferner eine Analytikkomponente auf, die so konfiguriert ist, dass sie einen Satz von simulierten Ergebnisdaten aus den mehreren Sätzen der simulierten Ergebnisdaten identifiziert, der ein durch die Designeingabe spezifiziertes Leistungskriterium erfüllt, und dass sie Werte der Eigenschaften auf der Grundlage einer Permutation von Werten aus den mehreren Permutationen festlegt, die den Satz von simulierten Ergebnisdaten ergeben haben.

8. Das System nach Anspruch 7 weist ferner ein Bauteil zur Programmerzeugung auf, das so konfiguriert ist, dass es ein industrielles Steuerprogramm auf der Basis des Schiene-Automatisierungsmodells und der Werte der Eigenschaften erzeugt,
wobei das industrielle Steuerprogramm mindestens eine Stationsanweisung aufweist, die einer in dem Schiene-Automatisierungsmodell definierten Station entspricht, und die Stationsanweisung Parameter aufweist, die den Werten der Eigenschaften entsprechen.

9. Das System nach Anspruch 7 oder 8 weist ferner ein Bauteil für eine Mensch-Maschine-Schnittstelle (HMI) auf, das so konfiguriert ist, dass es ein Visualisierungsprogramm erzeugt, das so konfiguriert ist, dass es den Betrieb des LSM-Transportsystems auf der Basis des Schiene-Automatisierungsmodells und der Werte der Eigenschaften visualisiert.

10. Das System nach Anspruch 8 weist ferner eine Geräteschnittstellen-Komponente auf, die so konfiguriert ist, dass sie Live-Daten von einer industriellen Steuereinheit abruft, die das industrielle Steuerprogramm ausführt, um die Überwachung und Steuerung des LSM-Systems zu erleichtern,
wobei das Bauteil der Benutzer-Schnittstellenkomponente so konfiguriert ist, dass es eine Animation des Schiene-Automatisierungsmodells auf der Basis der Live-Daten rendert,
wobei die Geräteschnittstellen-Komponente ferner so konfiguriert ist, dass sie als Reaktion auf die Erkennung einer Modifikation des in der industriellen Steuerung implementierten industriellen Steuerungsprogramms das Gleisautomatisierungsmodell oder ein Visualisierungsprogramm, das auf einem HMI-Anschluss (Human-Machine-Interface) ausgeführt wird, aktualisiert, um die Modifikation wiederzugeben.

11. Ein Verfahren zur Simulation von linearen Synchronmotoren, LSM, Transportsystemen, aufweisend:
Rendering einer Entwicklungsschnittstelle (2904), die den Entwurf eines LSM-Transportsystems erleichtert, durch ein System, das einen Prozessor aufweist;
Empfangen einer Designeingabe durch das System über eine Interaktion mit der Entwicklungsschnittstelle, die virtualisierte Schienemodule auswählt, die Komponenten zur Einbeziehung in das LSM-Transportsystem darstellen, und Verbindungen zwischen den virtualisierten Schienemodulen definiert, wobei ein virtualisiertes Schienemodul der virtualisierten Schienemodule mindestens eine dreidimensionale visuelle Darstellung einer entsprechenden Schienenkomponente, Abmessungen der entsprechenden Schienenkomponente und eine oder mehrere physikalische Eigenschaften der entsprechenden Schienenkomponente definiert, und wobei die Designeingabe ferner Eigenschaften der virtualisierten Schienemodule definiert, die den Eigenschaften der entsprechenden Schienenkomponenten entsprechen;
Erzeugen, durch das System, eines Schiene-Automatisierungsmodells (3002) für das LSM-Transportsystem auf der Basis der Designeingabe, wobei das Schiene-Automatisierungsmodell (3002) für das LSM-Transportsystem mit einem mechanischen Modell (4804) integriert wird, um einen digitalen Zwilling (4802) zu ergeben, wobei intelligente Objekte (322) verwendet werden, um das Schiene-Automatisierungsmodell und das mechanische Modell zu definieren, wobei die intelligenten Aufgaben (322) verwendet werden, um das Schiene-Automatisierungsmodell und das mechanische Modell zu definieren, wobei die intelligenten Aufgaben angepasst sind, um Datenwerte, Zustände, Ereignisse oder andere Eigenschaften, die gemessen werden, zu speichern, und wobei das Schiene-Automatisierungsmodell genutzt wird, um eine Steuerungs- und Visualisierungsprogrammierung zu erzeugen, die verwendet werden soll, um eine Schiene-Steuerungslösung auf dem physischen LSM-Transportsystem zu implementieren;
Ausführen einer Simulation des LSM-Transportsystems durch das System, basierend auf dem Schiene-Automatisierungsmodell; und
Speichern von simulierten Ergebnisdaten, die auf der Grundlage eines Ergebnisses der Simulation erzeugt wurden, durch das System;
das Verfahren weist ferner auf:
Modifizieren einiger oder aller intelligenten Aufgaben, aus denen der digitale Zwilling besteht, um Al-Kontextualisierungs-Metadaten in Form von zusätzlichen Feldern oder Eigenschaften hinzuzufügen, wobei die zusätzlichen Felder oder Eigenschaften gelernte Beziehungen zwischen modellierten Variablen kodieren, die nicht bereits im digitalen Zwilling definiert sind.

12. Das Verfahren nach Anspruch 11, wobei das Speichern das Speichern von mindestens einem der folgenden Elemente aufweist: Prozesszeiten für jeweilige Stationen, die im Schiene-Automatisierungsmodell definiert sind, Ankunftszeiten von Bewegern für die jeweiligen Stationen, Beweger-Durchsatzstatistiken, Beweger-Wartestatistiken oder Beweger-Verteilungsstatistiken.

13. Das Verfahren nach Anspruch 11 oder 12, wobei die eine oder die mehreren Eigenschaften mindestens eine Verweilzeit, einen Pfadidentifikator, einen Stationstyp, einen Motortyp, eine Abfahrtsbeschleunigung, eine Abfahrtsgeschwindigkeit oder einen Identifikator einer nächsten Zielstation aufweist,
wobei
das Ausführen der Simulation das Ausführen mehrerer Simulationen des LSM-Transportsystems, basierend auf dem Schiene-Automatisierungsmodell, für mehrere Permutationen von Werten der einen oder mehreren Eigenschaften aufweist, und
das Speichern das Speichern mehrerer Sätze der simulierten Ergebnisdaten aufweist, die jeweils den mehreren Permutationen von Werten der einen oder mehreren Eigenschaften entsprechen, und
das Verfahren weiterhin aufweist:
Identifizieren, durch das System, eines Satzes von simulierten Ergebnisdaten aus den mehreren Sätzen der simulierten Ergebnisdaten, der ein durch die Designeingabe spezifiziertes Leistungskriterium erfüllt; und
Einstellen von Werten der einen oder mehreren Eigenschaften durch das System auf der Basis einer Permutation von Werten der mehreren Permutationen, die den Satz von simulierten Ergebnisdaten ergeben haben.

14. Ein nichtflüchtiges computerlesbares Medium, auf dem Befehle gespeichert sind, die als Reaktion auf die Ausführung durch einen Prozessor eines Systems das System veranlassen, Operationen durchzuführen, wobei die Operationen aufweisen:
Bereitstellen einer Entwicklungsschnittstelle (2904), die den Entwurf eines linearen synchronen Motor-, LSM-, Transportsystems erleichtert;
Empfangen von Designeingaben über eine Interaktion mit der Entwicklungsschnittstelle, die virtualisierte Schienemodule auswählen, die Komponenten zur Einbeziehung in das LSM-Transportsystem darstellen, und Verbindungen zwischen den virtualisierten Schienemodulen definieren, wobei ein virtualisiertes Schienemodul der virtualisierten Schienemodule mindestens eine dreidimensionale visuelle Darstellung einer entsprechenden Schienenkomponente, Abmessungen der entsprechenden Schienenkomponente und eine oder mehrere physikalische Eigenschaften der entsprechenden Schienenkomponente definiert, und wobei die Designeingabe ferner Eigenschaften der virtualisierten Schienemodule definiert, die den Eigenschaften der entsprechenden Schienenkomponenten entsprechen;
Erzeugen eines Schiene-Automatisierungsmodells (3002) für das LSM-Transportsystem auf der Grundlage der Designeingabe, wobei das Schiene-Automatisierungsmodell (3002) für das LSM-Transportsystem mit einem mechanischen Modell (4804) integriert wird, um einen digitalen Zwilling (4802) zu ergeben, wobei intelligente Objekte (322) verwendet werden, um das Schiene-Automatisierungsmodell und das mechanische Modell zu definieren, wobei die intelligenten Objekte angepasst sind, um Datenwerte, Zustände, Ereignisse oder andere Eigenschaften, die gemessen werden, zu speichern, und wobei das Schiene-Automatisierungsmodell genutzt wird, um eine Steuerungs- und Visualisierungsprogrammierung zu erzeugen, die verwendet werden soll, um eine Schiene-Steuerungslösung auf dem physischen LSM-Transportsystem zu implementieren;
Ausführen einer Simulation des LSM-Transportsystems auf der Basis des Schiene-Automatisierungsmodells; und
Speichern von simulierten Ergebnisdaten, die auf der Grundlage eines Ergebnisses der Simulation erzeugt wurden;
die Vorgänge weiterhin aufweisend sind:
Modifizieren einiger oder aller intelligenten Aufgaben, aus denen der digitale Zwilling besteht, um Al-Kontextualisierungs-Metadaten in Form von zusätzlichen Feldern oder Eigenschaften hinzuzufügen, wobei die zusätzlichen Felder oder Eigenschaften gelernte Beziehungen zwischen modellierten Variablen kodieren, die nicht bereits im digitalen Zwilling definiert sind.

15. Das nichtflüchtige computerlesbare Medium nach Anspruch 14, wobei das Speichern das Speichern von mindestens einem der folgenden Elemente aufweist: Prozesszeiten für jeweilige Stationen, die in dem Schiene-Automatisierungsmodell definiert sind, Ankunftszeiten von Bewegern für die jeweiligen Stationen, Beweger-Durchsatzstatistiken, Beweger-Wartestatistiken oder Beweger-Verteilungsstatistiken.

## Revendications

1. Système, comprenant :
une mémoire qui stocke des composants exécutables ; et
un processeur, couplé en fonctionnement à la mémoire, qui exécute les composants exécutables, les composants exécutables comprenant :
un composant d'interface d'utilisateur (2904) configuré pour générer un rendu d'une interface de développement qui facilite une conception d'un système de convoyage à moteur synchrone linéaire, LSM (Linear Synchronous Motor), et pour recevoir une entrée de conception via une interaction avec l'interface de développement, dans lequel l'entrée de conception sélectionne des modules de piste virtualisés représentant des composants destinés à une inclusion dans le système de convoyage LSM, et définit des connexions entre les modules de piste virtualisés, dans lequel un module de piste virtualisé, des modules de piste virtualisés, définit au moins une d'une représentation visuelle tridimensionnelle d'un composant de piste correspondant, de dimensions du composant de piste correspondant, et d'une ou plusieurs propriétés physiques du composant de piste correspondant, et dans lequel l'entrée de conception définit en outre des propriétés des modules de piste virtualisés qui correspondent à des propriétés des composants de piste correspondants ;
un composant de génération de modèle (2906) configuré pour générer un modèle d'automatisation de piste (3002) pour le système de convoyage LSM selon l'entrée de conception, le modèle d'automatisation de piste (3002) pour le système de convoyage LSM étant intégré à un modèle mécanique (4804) pour générer un jumeau numérique (4802), dans lequel des objets intelligents (322) sont utilisés pour définir le modèle d'automatisation de piste et le modèle mécanique, les objets intelligents étant adaptés pour stocker des valeurs de données, des états, des événements ou d'autres propriétés qui sont mesurées, et dans lequel le modèle d'automatisation de piste est rentabilisé pour générer une programmation de commande et de visualisation à utiliser pour mettre en œuvre une solution de contrôle de piste sur le système de convoyage LSM physique ;
un composant de simulation (2908) configuré pour exécuter une simulation du système de convoyage LSM selon le modèle d'automatisation de piste, et pour stocker des données de résultat simulé générées selon un résultat de la simulation ; et
un composant de moteur d'IA (Intelligence artificielle) (514) configuré pour modifier certains ou la totalité des objets intelligents qui constituent le jumeau numérique pour ajouter des métadonnées de contextualisation IA sous la forme de champs ou de propriétés supplémentaires, dans lequel les champs ou propriétés supplémentaires codent des relations apprises entre des variables modélisées qui ne sont pas encore définies dans le jumeau numérique.

2. Le système de la revendication 1, au moins un de :
dans lequel les modules de piste virtualisés représentent au moins un d'un module de moteur droit, un module de moteur incurvé, un contrôleur de piste, un poste de base, un poste de regroupement, un poste de distribution, un nœud de convergence, un nœud de divergence, un chariot, un commutateur droit, un commutateur gauche, un chargeur de poste, un commutateur de poste, ou un terminal ; et
dans lequel les données de résultat simulé comprennent au moins un de durées de traitement pour des postes respectifs définis dans le modèle d'automatisation de piste, d'heures d'arrivée de chariot pour les postes respectifs, de statistiques de débit de chariot, de statistiques de file d'attente de chariot ou de statistiques de distribution de chariot.

3. Le système de la revendication 1 ou 2, dans lequel le module de piste virtualisé, des modules de piste virtualisés, définit en outre un segment de code de contrôleur pour commander le composant de piste correspondant.

4. Le système de la revendication 1, dans lequel
les propriétés comprennent au moins un d'une durée de temporisation, d'un identificateur de trajet, d'un type de poste, d'un type de moteur, d'une accélération de départ, d'une vélocité de départ ou d'un identificateur d'un prochain poste cible.

5. Le système de la revendication 4, dans lequel
le composant de génération de modèle est configuré pour définir des valeurs d'une ou plusieurs des propriétés conformément à un sous-ensemble de l'entrée de conception reçue via une interaction avec les modules de piste virtualisés, et
le composant de simulation est configuré pour exécuter la simulation conformément aux valeurs de l'une ou plusieurs propriétés.

6. Le système de la revendication 4 ou 5, dans lequel le composant de simulation est configuré en outre pour exécuter plusieurs simulations du système de convoyage LSM, selon le modèle d'automatisation de piste, pour plusieurs permutations de valeurs des propriétés, et pour stocker plusieurs ensembles des données de résultat simulé respectivement correspondant aux plusieurs permutations de valeurs des propriétés.

7. Le système de la revendication 6, comprenant en outre un composant d'analyse configuré pour identifier un ensemble de données de résultat simulé, des plusieurs ensembles des données de résultat simulé, qui satisfait un critère de performance spécifié par l'entrée de conception, et pour définir des valeurs des propriétés selon une permutation de valeurs, des plusieurs permutations, qui ont généré l'ensemble de données de résultat simulé.

8. Le système de la revendication 7, comprenant en outre un composant de génération de programme configuré pour générer un programme de commande industrielle selon le modèle d'automatisation de piste et les valeurs des propriétés,
dans lequel le programme de commande industrielle comprend au moins une instruction de poste correspondant à un poste défini dans le modèle d'automatisation de piste, et l'instruction de poste comprend des paramètres qui correspondent aux valeurs des propriétés.

9. Le système de la revendication 7 ou 8, comprenant en outre un composant d'interface homme-machine, IHM, configuré pour générer un programme de visualisation configuré pour visualiser un fonctionnement du système de convoyage LSM selon le modèle d'automatisation de piste et les valeurs des propriétés.

10. Le système de la revendication 8, comprenant en outre un composant d'interface de dispositif configuré pour récupérer des données en direct issues d'un contrôleur industriel qui exécute le programme de commande industrielle pour faciliter la surveillance et le contrôle du système LSM,
dans lequel le composant d'interface d'utilisateur est configuré pour générer un rendu d'une animation du modèle d'automatisation de piste selon les données en direct,
dans lequel le composant d'interface de dispositif est configuré en outre pour, en réaction à une détection d'une modification apportée au programme de commande industrielle mis en œuvre sur le contrôleur industriel, actualiser au moins un du modèle d'automatisation de piste ou d'un programme de visualisation qui s'exécute sur un terminal d'interface homme-machine, IHM, pour refléter la modification.

11. Procédé pour simuler des systèmes de convoyage à moteur synchrone linéaire, LSM (Linear Synchronous Motor), comprenant :
un rendu, par un système comprenant un processeur, une interface de développement (2904) qui facilite une conception d'un système de convoyage LSM ;
une réception, par le système via une interaction avec l'interface de développement, d'une entrée de conception qui sélectionne des modules de piste virtualisés représentant des composants destinés à une inclusion dans le système de convoyage LSM, et définit des connexions entre les modules de piste virtualisés, dans lequel un module de piste virtualisé, des modules de piste virtualisés, définit au moins une d'une représentation visuelle tridimensionnelle d'un composant de piste correspondant, de dimensions du composant de piste correspondant, et d'une ou plusieurs propriétés physiques du composant de piste correspondant, et dans lequel l'entrée de conception définit en outre des propriétés des modules de piste virtualisés qui correspondent à des propriétés des composants de piste correspondants ;
une génération, par le système, d'un modèle d'automatisation de piste (3002) pour le système de convoyage LSM selon l'entrée de conception, le modèle d'automatisation de piste (3002) pour le système de convoyage LSM étant intégré à un modèle mécanique (4804) pour générer un jumeau numérique (4802), dans lequel des objets intelligents (322) sont utilisés pour définir le modèle d'automatisation de piste et le modèle mécanique, les objets intelligents étant adaptés pour stocker des valeurs de données, des états, des événements ou d'autres propriétés qui sont mesurées, et dans lequel le modèle d'automatisation de piste est rentabilisé pour générer une programmation de commande et de visualisation à utiliser pour mettre en œuvre une solution de contrôle de piste sur le système de convoyage LSM physique ;
une exécution, par le système, d'une simulation du système de convoyage LSM selon le modèle d'automatisation de piste ; et
un stockage, par le système, de données de résultat simulé générées selon un résultat de la simulation ;
le procédé comprenant en outre :
une modification de certains ou de la totalité des objets intelligents qui constituent le jumeau numérique pour ajouter des métadonnées de contextualisation IA sous la forme de champs ou de propriétés supplémentaires, dans lequel les champs ou propriétés supplémentaires codent des relations apprises entre des variables modélisées qui ne sont pas encore définies dans le jumeau numérique.

12. Le procédé de la revendication 11, dans lequel le stockage comprend un stockage d'au moins un de durées de traitement pour des postes respectifs définis dans le modèle d'automatisation de piste, d'heures d'arrivée de chariot pour les postes respectifs, de statistiques de débit de chariot, de statistiques de file d'attente de chariot ou de statistiques de distribution de chariot.

13. Le procédé de la revendication 11 ou 12, dans lequel l'une ou plusieurs propriétés comprenant au moins un d'une durée de temporisation, d'un identificateur de trajet, d'un type de poste, d'un type de moteur, d'une accélération de départ, d'une vélocité de départ ou d'un identificateur d'un prochain poste cible,
dans lequel
l'exécution de la simulation comprend une exécution de plusieurs simulations du système de convoyage LSM, selon le modèle d'automatisation de piste, pour plusieurs permutations de valeurs de l'une ou plusieurs propriétés, et
le stockage comprend un stockage de plusieurs ensembles des données de résultat simulé respectivement correspondant aux plusieurs permutations de valeurs de l'une ou plusieurs propriétés, et
le procédé comprenant en outre :
une identification, par le système, d'un ensemble de données de résultat simulé, des plusieurs ensembles des données de résultat simulé, qui satisfait un critère de performance spécifié par l'entrée de conception ; et
une définition, par le système, de valeurs de l'une ou plusieurs propriétés selon une permutation de valeurs, des plusieurs permutations, qui ont généré l'ensemble de données de résultat simulé.

14. Support non transitoire lisible par un ordinateur ayant stockées en son sein des instructions qui, en réaction à une exécution par un processeur d'un système, entraînent une exécution d'opérations par le système, les opérations comprenant :
un rendu d'une interface de développement (2904) qui facilite une conception d'un système de convoyage à moteur synchrone linéaire, LSM (Linear Synchronous Motor) ;
une réception via une interaction avec l'interface de développement, d'une entrée de conception qui sélectionne des modules de piste virtualisés représentant des composants destinés à une inclusion dans le système de convoyage LSM, et définit des connexions entre les modules de piste virtualisés, dans lequel un module de piste virtualisé, des modules de piste virtualisés, définit au moins une d'une représentation visuelle tridimensionnelle d'un composant de piste correspondant, de dimensions du composant de piste correspondant, et d'une ou plusieurs propriétés physiques du composant de piste correspondant, et dans lequel l'entrée de conception définit en outre des propriétés des modules de piste virtualisés qui correspondent à des propriétés des composants de piste correspondants ;
une génération d'un modèle d'automatisation de piste (3002) pour le système de convoyage LSM selon l'entrée de conception, le modèle d'automatisation de piste (3002) pour le système de convoyage LSM étant intégré à un modèle mécanique (4804) pour générer un jumeau numérique (4802), dans lequel des objets intelligents (322) sont utilisés pour définir le modèle d'automatisation de piste et le modèle mécanique, les objets intelligents étant adaptés pour stocker des valeurs de données, des états, des événements ou d'autres propriétés qui sont mesurées, et dans lequel le modèle d'automatisation de piste est rentabilisé pour générer une programmation de commande et de visualisation à utiliser pour mettre en œuvre une solution de contrôle de piste sur le système de convoyage LSM physique ;
une exécution d'une simulation du système de convoyage LSM selon le modèle d'automatisation de piste ; et
un stockage de données de résultat simulé générées selon un résultat de la simulation ;
les opérations comprenant en outre :
une modification de certains ou de la totalité des objets intelligents qui constituent le jumeau numérique pour ajouter des métadonnées de contextualisation IA sous la forme de champs ou de propriétés supplémentaires, dans lequel les champs ou propriétés supplémentaires codent des relations apprises entre des variables modélisées qui ne sont pas encore définies dans le jumeau numérique.

15. Le support non transitoire lisible par un ordinateur de la revendication 14, dans lequel le stockage comprend un stockage d'au moins un de durées de traitement pour des postes respectifs définis dans le modèle d'automatisation de piste, d'heures d'arrivée de chariot pour les postes respectifs, de statistiques de débit de chariot, de statistiques de file d'attente de chariot ou de statistiques de distribution de chariot.
